# EUROPÄISCHE PATENTSCHRIFT

(11) **EP 3 538 286 B1**
(45) Veröffentlichungstag und Bekanntmachung des Hinweises auf die Patenterteilung: **19.05.2021**
(21) Anmeldenummer: 17804104.2
(22) Anmeldetag: 09.11.2017
(51) Int. Cl.: B05B 13/02, B65G 54/02, H02K 41/03

(54) **VORRICHTUNG ZUR BEARBEITUNG EINES BAUTEILS, VERFAHRWAGEN FÜR EINE SOLCHE VORRICHTUNG UND VERFAHREN ZUM BETREIBEN DERSELBEN**
APPARATUS FOR MACHINING A COMPONENT, TRAVELLING CARRIAGE FOR SUCH AN APPARATUS, AND METHOD FOR OPERATING SAME
DISPOSITIF D'USINAGE D'UN COMPOSANT, CHARIOT DE DÉPLACEMENT POUR UN TEL DISPOSITIF ET PROCÉDÉ DE FONCTIONNEMENT

(30) Priorität: 11.11.2016 DE 102016121674
(43) Veröffentlichungstag der Anmeldung: 18.09.2019
(73) Patentinhaber: Scia Systems GmbH, 09125 Chemnitz (DE)
(72) Erfinder: HAUSTEIN, Daniel, 08393 Meerane (DE); MARTIN, Sybille, 09125 Chemnitz (DE); NESTLER, Matthias, 01683 Nossen (DE); ZEUNER, Michael, 09125 Chemnitz (DE)
(74) Vertreter: Viering, Jentschura & Partner mbB Patent- und Rechtsanwälte
(86) Internationale Anmeldenummer: PCT/EP2017/078737
(87) Internationale Veröffentlichungsnummer: WO 2018/087216

(56) Entgegenhaltungen:
- EP-A1- 2 543 749
- WO-A1-00/68125
- US-A1- 2004 061 383
- US-A1- 2014 054 136

## Beschreibung

### Gebiet der Erfindung

Die vorliegende Erfindung betrifft eine Vorrichtung zur Bearbeitung (z.B. zur Beschichtung und/oder Entschichtung) eines Bauteils und einen Verfahrwagen für eine solche Vorrichtung sowie ein Verfahren zum Betreiben einer solchen Vorrichtung.

### Hintergrund der Erfindung

Im Allgemeinen werden konventionelle Vorrichtungen zur Beschichtung und/oder Entschichtung, im Allgemeinen zur Bearbeitung eines Bauteils verwendet, um eine oder mehrere Materialschichten gewünschter Dicken auf ein Bauteil aufzubringen und/oder davon abzutragen. Üblicherweise weisen solche konventionelle Vorrichtungen mehrere Kammern / Stationen auf, in welche hinein und/oder durch welche hindurch das Bauteil transportiert wird, um dabei bestimmten Bearbeitungsvorgängen unterzogen zu werden. Beispielsweise wird das Bauteil von einer Atmosphärenseite aus in eine Prozesskammer transportiert, in der ein Vakuum vorherrscht und in der dann die erforderlichen Bearbeitungsvorgänge, beispielsweise zum Beschichten des Bauteils oder zum Abtragen von Material vom Bauteil, durchgeführt werden. Nach Abschluss der Bearbeitungsvorgänge wird das Bauteil aus der Prozesskammer heraus transportiert.

Im Hinblick auf den erforderlichen Transport des Bauteils in die und/oder innerhalb der Kammern und der Stationen gibt es verschiedene konventionelle Ansätze. In einer konventionellen Technik wird beispielsweise eine Verfahreinrichtung verwendet, an der das Bauteil angebracht ist und an der zur Versorgung der Verfahreinrichtung mit Energie zum Antreiben der Verfahreinrichtung Leitungen (z.B. in Schleppketten geführt) an die Verfahreinrichtung angeschlossen sind, die innerhalb der Kammern / Stationen (insbesondere auch innerhalb der ein Vakuum aufweisenden Prozesskammern) verlaufen.

Bei innerhalb der Prozesskammern verlaufenden Leitungen können jedoch unter Vakuum Ausgasungen auftreten und kann es dadurch zu einer Fremdmaterialkontamination und/oder Partikelkontamination des Vakuums und somit einer Verschlechterung der Vakuumqualität (beispielsweise des mittels einer bestimmten Konfiguration der Vorrichtung erreichbaren minimalen Drucks) und des Bearbeitungsergebnisses des Bauteils kommen.

Außerdem sind die an die konventionelle Verfahreinrichtung angeschlossenen Leitungen besonders beim Übergang von Bereichen unterschiedlichen Druckniveaus (z.B. beim Übergang von Atmosphärenseite zur Vakuumseite) hinderlich und müssen üblicherweise zusätzliche, lösbare Anschlüsse und Leitungen vorgesehen werden, um dem Antriebssystem auf der Vakuumseite Energie von der Atmosphärenseite aus zuzuführen, was einen komplexeren Aufbau der Vorrichtung und somit hohe Kosten und hohen Arbeitsaufwand bei Fertigung und Montage der konventionellen Vorrichtung verursacht.

Ferner werden üblicherweise auch unterschiedliche Antriebssysteme in verschiedenen Abschnitten (z.B. auf Atmosphärenseite, Vakuumseite, etc.) der Vorrichtung verwendet, was eine modularisierte Bauweise der konventionellen Vorrichtungen schwierig macht und ebenfalls zu hohen Kosten und hohem Arbeitsaufwand bei Fertigung und Montage der konventionellen Vorrichtungen führt.

Ferner offenbart die WO 00/68125 A1 ein Transportsystem, das zumindest einen entlang einer Laufbahn mittels einer Primärteil und Sekundärteil aufweisenden Linearmotorantriebseinrichtung bewegbaren Produktträger aufweist, wobei dazu, dass eine beliebige Anzahl von Produktträgern unabhängig voneinander entlang der Laufbahn bewegt werden können und vielseitig zum Transport unterschiedlichster Produkte oder Werkstücke eingesetzt werden können, der Produktträger eine im wesentlichen ebene Grundplatte zum Transport von Gegenständen aufweist und der Grundplatte der Primärteil und der Laufbahn der Sekundärteil jeweils zugeordnet ist.

### Erläuterung der Erfindung

Mit der vorliegenden Erfindung werden eine Vorrichtung zur Bearbeitung eines Bauteils gemäß dem Anspruch 1 und ein Verfahren zum Betreiben einer solchen Vorrichtung gemäß dem Anspruch 12 geschaffen, welche zumindest einige der oben genannten Nachteile mildert oder sogar
gänzlich vermeidet. Vorteilhafte Weiterbildungen der beanspruchten Vorrichtung und des beanspruchten Verfahrens sind in den abhängigen Ansprüchen definiert.

Durch die vorliegende Erfindung wird eine Vorrichtung zur Bearbeitung (z.B. zur Beschichtung und/oder Entschichtung) eines Bauteils bereitgestellt, welche aufweist: einen Verfahrwagen mit einem Rahmen, welcher entlang einer Längsrichtung eine Translationsachse, entlang welcher der Verfahrwagen translatorisch vorwärts und rückwärts bewegbar ist, definiert, einem Drehgestell, das relativ zum Rahmen um eine Rotationsachse drehbar mit dem Rahmen verbunden ist und an welchem das Bauteil anbringbar ist, einer ersten Translation-Permanentmagneteinrichtung, die an dem Rahmen angebracht ist und die entlang der Längsrichtung angeordnete Permanentmagnete aufweist, einer Rotation-Permanentmagneteinrichtung, die an dem Drehgestell angebracht ist, eine sich um die Rotationsachse herum erstreckende Umfangsrichtung definiert und entlang dieser Umfangsrichtung angeordnete Permanentmagnete aufweist, und einem wagenseitigen Längsführungsmittel, welches an dem Rahmen angebracht ist, eine stationäre Verfahrwagenführungseinrichtung, die ein zu dem wagenseitigen Längsführungsmittel komplementäres führungseinrichtungsseitiges Längsführungsmittel aufweist, mittels dessen der Verfahrwagen translatorisch geführt ist, eine erste Translation-Elektromagneteinrichtung, die an der Verfahrwagenführungseinrichtung angebracht ist und die entlang der Längsrichtung angeordnete Elektromagnete, welche mit den Permanentmagneten der ersten Translation-Permanentmagneteinrichtung magnetisch zusammenwirken, aufweist, eine erste Rotation-Elektromagneteinrichtung, die an der Verfahrwagenführungseinrichtung angebracht ist und die entlang der Längsrichtung angeordnete Elektromagnete, welche mit den Permanentmagneten der Rotation-Permanentmagneteinrichtung magnetisch zusammenwirken, aufweist, und eine Steuereinrichtung, welche mit der ersten Translation-Elektromagneteinrichtung und mit der ersten Rotation-Elektromagneteinrichtung zur Ansteuerung der Elektromagnete (z.B. zur elektrischen Energieversorgung der Elektromagnete) verbunden ist, um die translatorische Bewegung des Verfahrwagens entlang der Translationsachse mittels des magnetischen Zusammenwirkens der Elektromagnete der ersten Translation-Elektromagneteinrichtung mit den Permanentmagneten der ersten Translation-Permanentmagneteinrichtung zu steuern und um die Rotationsbewegung des Drehgestells um die Rotationsachse mittels des magnetischen Zusammenwirkens der Elektromagnete der ersten Rotation-Elektromagneteinrichtung mit den Permanentmagneten der Rotation-Permanentmagneteinrichtung zu steuern.

Unter dem Begriff "Translationsbewegung" bzw. "translatorische Bewegung" ist nicht nur eine (rein) geradlinige Vorwärts-Rückwärts-Bewegung entlang der Translationsachse in der Längsrichtung zu verstehen, sondern ist auch eine nichtgeradlinige oder eine oszillierende (z.B. eine Oszillationen quer zur Translationsachse aufweisende) Vorwärts-Rückwärts-Bewegung zu verstehen.

Durch das erfindungsgemäß von der Steuereinrichtung geeignet gesteuerte Zusammenwirken der Elektromagneteinrichtungen mit den Permanentmagneteinrichtungen für sowohl die translatorische Bewegung des Verfahrwagens als auch die Rotation des Drehgestells, wird durch die vorliegende Erfindung ein nach dem Funktionsprinzip eines Linearmotors funktionierendes Verfahrwagenantriebssystem einer Vorrichtung zur Bearbeitung eines Bauteils bereitgestellt, wobei auf an dem Verfahrwagen angeschlossene Leitungen (z.B. Schleppketten für elektrische Leitungen), die für eine leitungsgebundene Energiezufuhr an den Verfahrwagen erforderlich sind, auf der Vakuumseite der Vorrichtung (z.B. im Inneren von Prozesskammern der Vorrichtung, in denen ein Vakuum vorherrscht) vollständig verzichtet werden kann, wodurch Ausgasungen aus den Leitungen und somit eine Partikelkontamination des Vakuums verringert bzw. im Wesentlichen verhindert werden können. Hierdurch können die Vakuumqualität in den Prozesskammern und das Bearbeitungsergebnis des Bauteils verbessert werden.

Zudem ist es mit der vorliegenden Erfindung möglich, ein einheitliches Antriebssystem in der erfindungsgemäßen Vorrichtung, z.B. für verschiedene vakuumseitige und atmosphärenseitige Kammern und Stationen (beispielsweise Prozesskammern, Schleusenkammern, Auswuchtstationen, Bauteilmontagestationen etc.), zu verwenden, wodurch auf das Vorsehen unterschiedlicher Antriebssysteme, die auf Betriebsbedingungen in den entsprechenden Kammern und Stationen abgestimmt sein können, verzichtet werden kann und eine modulare Bauweise der Vorrichtung ermöglicht wird. Außerdem kann ein Übergang zwischen Bereichen unterschiedlichen Druckniveaus (z.B. ein Übergang von Atmosphärenseite zu Vakuumseite durch eine Schleusenkammer) einfacher realisiert werden. Hierdurch können die Skalierbarkeit und die Nachrüstbarkeit der Vorrichtung sowie die Fertigung und Montage der Vorrichtung (z.B. hinsichtlich Kosten und Arbeitsaufwand) verbessert werden.

In einer Ausgestaltung kann der Verfahrwagen ferner eine zweite Translation-Permanentmagneteinrichtung aufweisen, die an dem Rahmen bezüglich der Längsrichtung gegenüberliegend der (und z.B. im Abstand zur) ersten Translation-Permanentmagneteinrichtung angebracht ist und die entlang der Längsrichtung angeordnete Permanentmagnete aufweist, und kann die Vorrichtung ferner eine zweite Translation-Elektromagneteinrichtung aufweisen, die bezüglich der Längsrichtung gegenüberliegend der (und z.B. im Abstand zur) ersten Translation-Elektromagneteinrichtung an der Verfahrwagenführungseinrichtung angebracht ist und die entlang der Längsrichtung angeordnete Elektromagnete, welche mit den Permanentmagneten der zweiten Translation-Permanentmagneteinrichtung magnetisch zusammenwirken, aufweist, wobei die Steuereinrichtung ferner mit der zweiten Translation-Elektromagneteinrichtung zur Ansteuerung der Elektromagnete der zweiten Translation-Elektromagneteinrichtung (z.B. zur elektrischen Energieversorgung der Elektromagnete der zweiten Translation-Elektromagneteinrichtung) verbunden sein kann, um die translatorische Bewegung des Verfahrwagens entlang der Translationsachse zusätzlich mittels des magnetischen Zusammenwirkens der Elektromagnete der zweiten Translation-Elektromagneteinrichtung mit den Permanentmagneten der zweiten Translation-Permanentmagneteinrichtung zu steuern.

In einer weiteren Ausgestaltung kann die Vorrichtung ferner eine zweite Rotation-Elektromagneteinrichtung, die bezüglich der Längsrichtung gegenüberliegend der (und z.B. im Abstand zur) ersten Rotation-Elektromagneteinrichtung an der Verfahrwagenführungseinrichtung angebracht ist und die entlang der Längsrichtung angeordnete Elektromagnete, welche mit den Permanentmagneten der Rotation-Permanentmagneteinrichtung magnetisch zusammenwirken, aufweist, wobei die Steuereinrichtung ferner mit der zweiten Rotation-Elektromagneteinrichtung zur Ansteuerung der Elektromagnete der zweiten Rotation-Elektromagneteinrichtung (z.B. zur elektrischen Energieversorgung der Elektromagnete der Rotation-Elektromagneteinrichtung) verbunden sein kann, um die Rotationsbewegung des Drehgestells um die Rotationsachse zusätzlich mittels des magnetischen Zusammenwirkens der Elektromagnete der zweiten Rotation-Elektromagneteinrichtung mit den Permanentmagneten der Rotation-Permanentmagneteinrichtung zu steuern.

Durch das Vorsehen zusätzlicher Elektromagneteinrichtungen und/oder Permanentmagneteinrichtungen für Translation und/oder Rotation kann die Leistungsfähigkeit (z.B. maximale Beschleunigung, maximale Geschwindigkeit, maximal antreibbare Masse von Verfahrwagen sowie Bauteil, etc.) des Antriebssystems der erfindungsgemäßen Vorrichtung erhöht werden.

Es ist zu verstehen, dass die erfindungsgemäße Vorrichtung auch weitere (z.B. eine dritte, eine vierte, eine fünfte, etc.) Translation-Permanentmagneteinrichtungen und Translation-Elektromagneteinrichtungen, welche in Struktur und Funktionsweise im Wesentlichen den zuvor beschriebenen Translation-Permanentmagneteinrichtungen bzw. Translation-Elektromagneteinrichtungen entsprechen können, sowie weitere Rotation-Permanentmagneteinrichtungen und Rotation-Elektromagneteinrichtungen, welche in Struktur und Funktionsweise im Wesentlichen den zuvor beschriebenen Rotation-Permanentmagneteinrichtungen bzw. Rotation-Elektromagneteinrichtungen entsprechen können, aufweisen kann und nicht auf die Zahl der zuvor genannten Permanentmagneteinrichtungen bzw. Elektromagneteinrichtungen für Translation und/oder Rotation beschränkt ist.

Die Translation-Permanentmagneteinrichtung(en) und/oder die Rotation-Permanentmagneteinrichtung(en) können eine Mehrzahl von unterschiedlich gepolten Permanentmagneten aufweisen, die abwechselnd angeordnet sind. Beispielsweise weist eine jede Translation-Permanentmagneteinrichtung eine Mehrzahl von Nordpol-Permanentmagneten (d.h. mit dem Nordpol im Wesentlichen zur jeweiligen Translation-Elektromagneteinrichtung ausgerichtete Permanentmagneten) und eine Mehrzahl von Südpol-Permanentmagneten (d.h. mit dem Südpol im Wesentlichen zur jeweiligen Translation-Elektromagneteinrichtung ausgerichtete Permanentmagneten) auf, welche entlang der Längsrichtung abwechselnd (z.B. in der Reihenfolge Nordpol-Permanentmagnet, Südpol-Permanentmagnet, Nordpol-Permanentmagnet, Südpol-Permanentmagnet, usw.) angeordnet sind. Außerdem kann die Rotation-Permanentmagneteinrichtung eine Mehrzahl von Nordpol-Permanentmagneten (d.h. mit dem Nordpol im Wesentlichen zur jeweiligen Rotation-Elektromagneteinrichtung ausgerichtete Permanentmagneten) und eine Mehrzahl von Südpol-Permanentmagneten (d.h. mit dem Südpol im Wesentlichen zur jeweiligen Rotation-Elektromagneteinrichtung ausgerichtete Permanentmagneten) aufweisen, welche entlang der Umfangsrichtung abwechselnd angeordnet sind.

In noch einer weiteren Ausgestaltung kann das Drehgestell aufweisen: ein erstes Rad, das die Permanentmagnete der Rotation-Permanentmagneteinrichtung trägt, ein zweites Rad, welches dem ersten Rad gegenüberliegend angeordnet ist und an welchem das Bauteil anbringbar ist, und eine Welle, welche das erste Rad und das zweite Rad miteinander verbindet, wobei der Verfahrwagen ein Drehlager, z.B. ein Axiallager (beispielsweise ein Axial-Schrägkugellager, ein Axial-Pendelrollenlager, etc.), aufweisen kann, welches die Welle drehbar mit dem Rahmen des Verfahrwagens verbindet. Ferner kann die Vorrichtung eine Befestigungsvorrichtung (z.B. eine Käfigstruktur) aufweisen, mittels welcher das Bauteil an dem Drehgestell (z.B. an dem zweiten Rad des Drehgestells) anbringbar ist.

Beispielsweise kann das erste Rad ein oberes Rad sein und kann das zweite Rad ein unteres Rad sein, wobei das erste und das zweite Rad übereinander angeordnet sind und die beiden Räder um eine im Wesentlichen vertikale Rotationsachse drehbar sind. Hierbei können Beschichtungseinrichtungen und/oder Abtrageinrichtungen unterhalb des zweiten Rads angebracht sein. Alternativ kann das erste Rad ein unteres Rad sein und kann das zweite Rad ein oberes Rad sein, wobei das erste und das zweite Rad übereinander angeordnet sind und die beiden Räder um eine im Wesentlichen vertikale Rotationsachse drehbar sind. Hierbei können Beschichtungseinrichtungen und/oder Abtrageinrichtungen oberhalb des zweiten Rads angebracht sein. Es kann aber auch vorgesehen sein, dass das erste Rad und das zweite Rad seitlich nebeneinander und mit ihrer Radialrichtung sich im Wesentlichen vertikal erstreckend angeordnet sind, wobei die beiden Räder um eine im Wesentlichen horizontale Rotationsachse drehbar sind. Hierbei können Beschichtungseinrichtungen und/oder Abtrageinrichtungen seitlich benachbart zum zweiten Rad angebracht sein. Je nach der zuvor beschriebenen Anordnung der beiden Räder und entsprechender Anordnung der Beschichtungseinrichtungen und/oder Abtrageinrichtungen kann eine für den jeweiligen Anwendungsfall unerwünschte, schwerkraftbedingte Partikelkontamination des zu bearbeitenden Bauteils, der Beschichtungseinrichtung(en) und/oder der Abtrageinrichtung(en) verringert bzw. vermieden werden. Es versteht sich, dass entsprechend der gewünschten Anordnung der beiden Räder die übrigen Komponenten des Verfahrwagens und die dazu zugehörigen Komponenten der Vorrichtung geeignet angeordnet und ausgerichtet sein können.

In noch einer weiteren Ausgestaltung kann die Verfahrwagenführungseinrichtung aus einer Gestellstruktur gebildet sein, welche entlang der Längsrichtung im Abstand voneinander angeordnete Querbügel aufweist, welche jeweils seitliche Pfosten, die bezüglich der Längsrichtung gegenüberliegend voneinander (und zueinander im Abstand) angeordnet sind, und einen Querträger aufweisen, welcher sich quer zur Längsrichtung (z.B. in einer quer zur Längsrichtung verlaufenden Querrichtung) erstreckt und die Pfosten miteinander verbindet, wobei das führungseinrichtungsseitige Längsführungsmittel von Längsschienen, welche unterhalb der Querträger angeordnet sind, sich entlang der Längsrichtung (z.B. mit ihrer Längserstreckung in Längsrichtung) erstrecken und die Querbügel miteinander verbinden, oder von Rollen, welche unterhalb der Querträger entlang der Längsrichtung im Abstand zueinander angeordnet sind, gebildet sein kann. Beispielsweise können die Längsschienen bzw. die Rollen jeweilig mit den Pfosten der Gestellstruktur verbunden sein. Die Längsschienen können unmittelbar aufeinanderfolgend (z.B. im Wesentlichen spaltfrei aufeinanderfolgend) angeordnet sein und/oder entlang der Längsrichtung mit Räumen bzw. Spalten zwischen jeweiligen Längsschienen vorgesehen sein. Die Rollen können in Form von jeweiligen Rollenpaaren ausgebildet sein, wobei die Rollenpaare entlang der Längsrichtung im Abstand zueinander angeordnet sind.

Die Gestellstruktur kann beispielsweise einzelne Module aufweisen, wobei jedes Modul beispielsweise zwei Querbügel, die mittels sich entlang der Längsrichtung erstreckenden Querbügellängsträgern miteinander verbunden sind, aufweist. Die einzelnen Module können ferner miteinander mittels sich entlang der Längsrichtung erstreckenden Verbindungslängsträgern verbunden sein. Die Gestellstruktur kann eine Mehrzahl ((z.B. genau) ein, zwei, drei, vier, fünf oder mehr) solcher miteinander verbundenen Module aufweisen.

In noch einer weiteren Ausgestaltung kann das wagenseitige Längsführungsmittel eine erste wagenseitige Längsführungsmittelkomponente und eine zweite wagenseitige Längsführungsmittelkomponente aufweisen und kann das führungseinrichtungsseitige Längsführungsmittel eine erste führungseinrichtungsseitige Längsführungsmittelkomponente und eine zweite führungseinrichtungsseitige Längsführungsmittelkomponente aufweisen, wobei die erste wagenseitige Längsführungsmittelkomponente und die erste führungseinrichtungsseitige Längsführungsmittelkomponente unter Ausbildung eines Quer-Festlagers (ein ein Querspiel (nämlich quer zur Längsrichtung) unterbindendes Festlager) miteinander im Eingriff stehen können und wobei die zweite wagenseitige Längsführungsmittelkomponente und die zweite führungseinrichtungsseitige Längsführungsmittelkomponente unter Ausbildung eines Quer-Loslagers (ein ein Querspiel (nämlich quer zur Längsrichtung) erlaubendes Festlager) miteinander im Eingriff stehen können.

Optional kann die erste führungseinrichtungsseitige Längsführungsmittelkomponente durch eine erste führungseinrichtungsseitige Längsschiene, welche sich entlang der Längsrichtung erstreckt, gebildet sein und kann die zweite führungseinrichtungsseitige Längsführungsmittelkomponente durch eine zweite führungseinrichtungsseitige Längsschiene, welche bezüglich der Längsrichtung gegenüberliegend der (und z.B. im Abstand zur) ersten führungseinrichtungsseitigen Längsschiene angeordnet ist und sich entlang der Längsrichtung erstreckt, gebildet sein, wobei die erste wagenseitige Längsführungsmittelkomponente durch wenigstens eine Rolle (z.B. wenigstens eine Profilrolle, beispielsweise wenigstens eine Rolle mit profilierter Lauffläche), die mit der ersten führungseinrichtungsseitigen Längsschiene unter Ausbildung des Quer-Festlagers in einem ein Querspiel unterbindenden Konkav-Konvex-Eingriff ist, optional durch bezüglich der ersten führungseinrichtungsseitigen Längsschiene gegenüberliegende erste wagenseitige Rollen (z.B. Profilrollen, beispielsweise Rollen mit profilierter Lauffläche), die mit der ersten führungseinrichtungsseitigen Längsschiene unter Ausbildung des Quer-Festlagers in einem ein Querspiel unterbindenden Konkav-Konvex-Eingriff sind, gebildet sein kann und die zweite wagenseitige Längsführungsmittelkomponente durch wenigstens eine Rolle (z.B. wenigstens eine Zylinderrolle bzw. Planrolle, beispielsweise wenigstens eine Rolle mit balliger Lauffläche), die mit der zweiten führungseinrichtungsseitigen Längsschiene unter Ausbildung des Quer-Loslagers in einem ein Querspiel erlaubenden Eingriff ist, optional durch bezüglich der zweiten führungseinrichtungsseitigen Längsschiene gegenüberliegende zweite wagenseitige Rollen (z.B. Zylinderrollen bzw. Planrollen, beispielsweise Rollen mit balliger Lauffläche), die mit der zweiten führungseinrichtungsseitigen Längsschiene unter Ausbildung des Quer-Loslagers in einem ein Querspiel erlaubenden Eingriff sind, gebildet sein kann. Die Verfahrwagenführungseinrichtung kann beispielsweise mehrere erste und mehrere zweite führungseinrichtungsseitige Längsschienen aufweisen, wobei zumindest ein Teil oder alle der mehreren ersten führungseinrichtungsseitigen Längsschienen jeweilig unmittelbar aufeinanderfolgend (z.B. im Wesentlichen spaltfrei aufeinanderfolgend) angeordnet sein können und/oder entlang der Längsrichtung mit Räumen bzw. Spalten zwischen jeweiligen Längsschienen vorgesehen sein können und wobei zumindest ein Teil oder alle der mehreren zweiten führungseinrichtungsseitigen Längsschienen jeweilig unmittelbar aufeinanderfolgend (z.B. im Wesentlichen spaltfrei aufeinanderfolgend) angeordnet sein können und/oder entlang der Längsrichtung mit Räumen bzw. Spalten zwischen jeweiligen Längsschienen vorgesehen sein können.

Optional kann die erste wagenseitige Längsführungsmittelkomponente durch eine erste wagenseitige Längsschiene, welche sich entlang der Längsrichtung erstreckt, gebildet sein und kann die zweite wagenseitige Längsführungsmittelkomponente durch eine zweite wagenseitige Längsschiene, welche bezüglich der Längsrichtung gegenüberliegend der (und z.B. im Abstand zur) ersten wagenseitigen Längsschiene angeordnet ist und sich entlang der Längsrichtung erstreckt, gebildet ist, wobei die erste führungseinrichtungsseitige Längsführungsmittelkomponente durch wenigstens eine Rolle (z.B. wenigstens eine Profilrolle, beispielsweise wenigstens eine Rolle mit profilierter Lauffläche), die mit der ersten wagenseitigen Längsschiene unter Ausbildung des Quer-Festlagers in einem ein Querspiel unterbindenden Konkav-Konvex-Eingriff ist, optional durch bezüglich der ersten wagenseitigen Längsschiene gegenüberliegende erste führungseinrichtungsseitige Rollen (z.B. Profilrolle, beispielsweise Rollen mit profilierter Lauffläche), die mit der ersten wagenseitigen Längsschiene unter Ausbildung des Quer-Festlagers in einem ein Querspiel unterbindenden Konkav-Konvex-Eingriff sind, gebildet sein kann und die zweite führungseinrichtungsseitige Längsführungsmittelkomponente durch wenigstens eine Rolle, die mit der zweiten wagenseitigen Längsschiene unter Ausbildung des Quer-Loslagers in einem ein Querspiel erlaubenden Eingriff ist, optional durch bezüglich der zweiten wagenseitigen Längsschiene gegenüberliegende zweite führungseinrichtungsseitige Rollen, die mit der zweiten wagenseitigen Längsschiene unter Ausbildung des Quer-Loslagers in einem ein Querspiel erlaubenden Eingriff sind, gebildet sein kann. Die führungseinrichtungsseitigen Rollen können entlang der Längsrichtung im Abstand zueinander angeordnet sein und können optional in Form von jeweiligen Rollenpaaren (z.B. mit jeweils zwei bezüglich der zweiten wagenseitigen Längsschiene gegenüberliegenden Rollen) ausgebildet sein, wobei die Rollenpaare entlang der Längsrichtung im Abstand zueinander angeordnet sind.

Das Quer-Loslager kann Querbewegungen bzw. Querverschiebungen des Verfahrwagens (z.B. durch thermische Materialausdehnung bzw. thermische Materialkontraktion hervorgerufene Querbewegungen bzw. Querverschiebungen) ausgleichen, wobei das Quer-Festlager eine sichere und präzise Führung des Verfahrwagens bei der translatorischen Bewegung des Verfahrwagens gewährleistet. Wenn beispielsweise zur Reinigung und Vakuumvorbereitung des Verfahrwagens und des Bauteils diese zuvor gemeinsam in der Vorrichtung (z.B. in einer entsprechenden Kammer der Vorrichtung) auf eine vorbestimmte Ausheiztemperatur (z.B. auf mehr als 100°C) aufgeheizt werden, kann das Quer-Loslager bei der erfindungsgemäßen Vorrichtung in vorteilhafter Weise die dabei auftretenden relativ großen Materialausdehnungen und Materialkontraktionen ausgleichen.

Ferner können die Rollen den Verfahrwagen gegen die Gewichtskraft des Verfahrwagens und des Bauteils an den Längsschienen abstützen. Bei einer Anordnung von bezüglich der jeweiligen Längsschiene gegenüberliegenden Rollen kann zudem der Verfahrwagen an den Längsschienen gegen die Anziehungskräfte, welche zwischen den Translation-Permanentmagneteinrichtungen und den Translation-Elektromagneteinrichtungen wirken und zwischen der Rotation-Permanentmagneteinrichtung und den Rotation-Elektromagneteinrichtungen wirken, abgestützt werden. Hierdurch kann beispielsweise ein Spalt zwischen den Elektromagneteinrichtungen und den Permanentmagneteinrichtung im Wesentlichen konstant gehalten werden, um einen zuverlässigen Betrieb des Antriebssystems (z.B. ein zuverlässiges magnetisches Zusammenwirken der Elektromagneteinrichtungen und der Permanentmagneteinrichtung) sicherzustellen.

In noch einer weiteren Ausgestaltung können die Elektromagnete der ersten und/oder der zweiten Translation-Elektromagneteinrichtung und/oder die Elektromagnete der ersten und/oder der zweiten Rotation-Elektromagneteinrichtung jeweilig ein Gehäuse aufweisen, in welchem Elektromagnet-Spulen der Elektromagnete untergebracht sind, wobei in dem Gehäuse Kühlmittelkanäle ausgebildet sind, an welche eine Kühlmittelversorgung anschließbar ist bzw. angeschlossen ist, um dem Gehäuse Kühlmittel zur Kühlung der Elektromagnet-Spulen zuzuführen. Das Gehäuse kann derart eingerichtet sein, dass ein Gehäuseinnenraum gegenüber der Umgebung luftdicht ist. Die Elektromagnet-Spulen der Elektromagnete können beispielsweise in dem Gehäuse mittels eines Gießmaterials, z.B. mittels eines Gießharzes, eingebettet bzw. eingegossen sein. Ferner kann ein jeweiliger (z.B. ein jeder) Elektromagnet mehrere Elektromagnet-Spulen aufweisen, die voneinander getrennt sind und die individuell von der Steuereinrichtung ansteuerbar (z.B. mit elektrischer Energie versorgbar) sind.

In noch einer weiteren Ausgestaltung kann die Vorrichtung ferner aufweisen: eine oder mehrere Prozesskammern, eine Vakuumvorrichtung (die z.B. eine oder mehrere Vakuumpumpen aufweist), mittels deren die eine oder die mehreren Prozesskammern evakuierbar sind, wobei eine oder mehrere Beschichtungseinrichtungen (z.B. eine oder mehrere Sputter-Beschichtungseinrichtungen, die z.B. jeweilig eine oder mehrere Magnetroneinrichtungen (z.B. Sputterplasmaeinrichtungen) aufweisen), mittels derer das Bauteil beschichtet werden kann, innerhalb der einen oder mehreren Prozesskammern angeordnet sind und/oder eine oder mehrere Abtrageinrichtungen (z.B. eine oder mehrere Sputter-Abtrageinrichtungen, die z.B. jeweilig eine oder mehrere Sputterplasmaeinrichtungen aufweisen), mittels derer Material von dem Bauteil abgetragen werden kann, innerhalb der einen oder mehreren Prozesskammern angeordnet sind, wobei die Verfahrwagenführungseinrichtung mit der daran angebrachten jeweiligen Translation-Elektromagneteinrichtung und der daran angebrachten jeweiligen Rotation-Elektromagneteinrichtung sich zumindest teilweise (z.B. vollständig) innerhalb der einen oder mehreren Prozesskammern erstreckt, so dass der durch die Verfahrwagenführungseinrichtung geführte Verfahrwagen innerhalb der einen oder mehreren Prozesskammern entlang der Translationsachse mittels der jeweiligen Translation-Elektromagneteinrichtung translatorisch bewegbar ist und das Drehgestell des Verfahrwagens mittels der jeweiligen Rotation-Elektromagneteinrichtung innerhalb der einen oder mehreren Prozesskammern um die Rotationsachse drehbar ist.

Beispielsweise können die Bestandteile der Gestellstruktur der Verfahrwagenführungseinrichtung vakuumseitig innerhalb der einen oder den mehreren Prozesskammern derart angeordnet sein, dass sie lediglich auf dem Prozesskammerboden stehen und zumindest teilweise oder im Wesentlichen vollständig von den die Prozesskammer(n) ausbildenden Prozesskammerwänden (z.B. Prozesskammerseitenwänden) entkoppelt bzw. getrennt sind. Auf diese Weise kann vermieden werden, dass Bewegungen (z.B. aufgrund von bei Vakuumerzeugung entstehenden Verformungen der Prozesskammerwände) von der einen oder den mehreren Prozesskammern auf die Gestellstruktur und somit auch auf den Verfahrwagen übertragen werden und die Genauigkeit der translatorischen Bewegung des Verfahrwagens und der Rotationsbewegung des Drehgestells negativ beeinflusst wird.

Darüber hinaus kann die Vorrichtung noch weitere Kammern / Stationen, z.B. eine oder mehrere Schleusenkammern zum Übergang von der Atmosphärenseite auf die Vakuumseite (z.B. durch Abpumpen der Schleusenkammer auf einen Druck, der nahe dem Druck des Vakuums in der einen oder mehreren Prozesskammern liegt), eine oder mehrere Vakuumvorbereitungskammern (z.B. zum Vorbereiten (z.B. durch Ausheizen) des Verfahrwagens und/oder des Bauteils für das Vakuum), eine oder mehrere Auswuchtstationen, eine oder mehrere Bauteilmontagestationen, sowie eine oder mehrere Ventileinrichtung, welche dazu eingerichtet sind, zwei Kammern selektiv miteinander verbinden, um ein Bewegen des Verfahrwagens zwischen den zwei Kammern zu ermöglichen, und selektiv die zwei Kammern voneinander luftdicht abzuschotten, aufweisen. Die weiteren Kammern können auch mehrere Funktionen in sich vereinen. Beispielsweise kann die Schleusenkammer zum Vorbereiten des Verfahrwagens und des Bauteils für das Vakuum als auch zum Übergang von der Atmosphärenseite auf die Vakuumseite eingerichtet sein.

In noch einer weiteren Ausgestaltung kann an dem Rahmen des Verfahrwagens ferner mindestens eine Bremslängsschiene angebracht sein, die sich entlang der Längsrichtung erstreckt, wobei die Verfahrwagenführungseinrichtung ferner wenigstens eine Bremsbackeneinrichtung (z.B. mehrere Bremsbackeneinrichtung) aufweisen kann, welche beidseitig der Bremslängsschiene angeordnete Bremsbacken aufweist, mittels deren die Bremslängsschiene unter Erzeugung einer Bremskraft einklemmbar ist. Die wenigstens eine Bremsbackeneinrichtung kann beispielsweise dazu eingerichtet sein, eine Abbremsung des Verfahrwagens in einer vorbestimmten Fehlersituation (z.B. bei Betätigung eines Not-Aus-Schalters und/oder bei Ausfall der Energieversorgung, etc.) durchzuführen. Indem die wenigstens eine Bremsbackeneinrichtung an der stationären Verfahrwagenführungseinrichtung und nicht an dem Verfahrwagen (bzw. wagenseitig) angebracht ist, ist es nicht erforderlich, dem Verfahrwagen zusätzliche Energie zum Betreiben einer wagenseitigen Bremsbackeneinrichtung über Leitungen (z.B. über die zuvor genannten Schleppketten) zuzuführen.

Die Vorrichtung kann in noch einer weiteren Ausgestaltung ferner wenigstens eine Translation-Messeinrichtung zum berührungslosen Messen der translatorischen Bewegung des Verfahrwagens und wenigstens eine Rotation-Messeinrichtung zum berührungslosen Messen der Rotation des Drehgestells aufweisen, welche jeweilig mit der Steuereinrichtung verbunden sind, wobei die Steuereinrichtung ferner dazu eingerichtet sein kann, Signale, welche Informationen hinsichtlich eines Translationswegs (bzw. einer Translationsposition) und einer Translationsrichtung des Verfahrwagens aufweisen, von der wenigstens einen Translation-Messeinrichtung zu erhalten und Signale, welche Informationen hinsichtlich eines Winkels (bzw. eines Rotationswegs) und/oder einer Rotationsgeschwindigkeit und/oder einer Rotationsrichtung (beispielsweise, aber nicht darauf beschränkt, den Winkel und die Rotationsrichtung oder die Rotationsgeschwindigkeit und die Rotationsrichtung) des Drehgestells des Verfahrwagens aufweisen, von der wenigstens einen Rotation-Messeinrichtung zu erhalten.

Die wenigstens eine Translation-Messeinrichtung kann dazu eingerichtet sein, den Translationsweg (bzw. die Translationsposition) und die Translationsrichtung des Verfahrwagens in magnetischer Weise und/oder in optischer Weise zu erfassen. Beispielsweise kann die wenigstens eine Translation-Messeinrichtung eine magnetische (z.B. einen auf Magnetostriktion basierende) Translationsdetektionseinrichtung aufweisen (oder als solche ausgebildet sein), die einen seitlich an dem Verfahrwagen (z.B. fest) angebrachten (permanent- )magnetischen Positionsgeber und einen an der Verfahrwagenführungseinrichtung (z.B. fest) angebrachten magnetischen Sensor, der mit dem magnetischen Positionsgeber magnetisch zusammenwirkt, um den Translationsweg (bzw. die Translationsposition) und die Translationsrichtung des Verfahrwagens zu ermitteln, aufweist. Ferner kann die wenigstens eine Translation-Messeinrichtung eine optische Translationsdetektionseinrichtung aufweisen (oder als solche ausgebildet sein), die einen seitlich an dem Verfahrwagen (z.B. fest) angebrachten (z.B. länglichen) Maßstab (z.B. einen Glasmaßstab, einen Edelstahlmaßstab), der Striche und Lücken zwischen den Strichen (z.B. in Form einer absoluten Codierung) aufweist, und einen an der Verfahrwagenführungseinrichtung (z.B. fest) angebrachten optischen Abtastkopf, der dazu eingerichtet ist, den Maßstab (z.B. die Striche und Lücken des Maßstabs) abzutasten, um den Translationsweg (bzw. die Translationsposition) und die Translationsrichtung des Verfahrwagens zu ermitteln, aufweist.

Die wenigstens eine Rotation-Messeinrichtung kann dazu eingerichtet sein, den Winkel (bzw. den Rotationsweg) und/oder die Rotationsgeschwindigkeit und/oder die Rotationsrichtung (beispielsweise, aber nicht darauf beschränkt, den Winkel und die Rotationsrichtung oder die Rotationsgeschwindigkeit und die Rotationsrichtung) des Drehgestells in optischer Weise mittels einer (z.B. bezüglich des Verfahrwagens) stationären Sensoreinrichtung zu erfassen. Beispielsweise kann die wenigstens eine Rotation-Messeinrichtung eine optische Inkrementalmesseinrichtung (bzw. Inkrementalgeber) oder eine optische Absolutwertmesseinrichtung aufweisen oder als solche ausgebildet sein.

Die wenigstens eine Rotation-Messeinrichtung kann in einem Beispiel eine (z.B. bezüglich des Verfahrwagens) stationäre Sensoreinrichtung (die z.B. wenigstens eine Reflexlichtschranke, beispielsweise wenigstens oder genau zwei Reflexlichtschranken, aufweist) und eine Reflexionseinrichtung aufweisen, wobei die stationäre Sensoreinrichtung dazu eingerichtet ist, wenigstens einen (z.B. wenigstens oder genau zwei) Lichtstrahl(en) (z.B. wenigstens einen Laserstrahl, beispielsweise wenigstens oder genau zwei Laserstrahlen) in Richtung des Verfahrwagens auszusenden, wenigstens einen von der Reflexionseinrichtung impulsweise reflektierten Lichtstrahl (z.B. wenigstens oder genau zwei impulsweise reflektierten Lichtstrahlen) zu empfangen und anhand des wenigstens einen impulsweise reflektierten Lichtstrahls einen Winkel (bzw. einen Rotationsweg) und/oder die Rotationsgeschwindigkeit und/oder die Rotationsrichtung des Drehgestells zu ermitteln, und wobei die Reflexionseinrichtung an dem Drehgestell (z.B. an dem ersten Rad des Drehgestells) angebracht ist und dazu eingerichtet ist, wenigstens einen auftreffenden Lichtstrahl bei Rotation des Drehgestells impulsweise (bzw. in Form von Impulsen) zu reflektieren. Beispielsweise weist die Reflexionseinrichtung hierzu einen an dem Rahmen des Verfahrwagens (z.B. fest) angebrachten Spiegel, auf welchen der wenigstens eine Lichtstrahl der stationären Sensoreinrichtung gerichtet ist, und eine sich entlang der Umfangrichtung erstreckende und mit dem Drehgestell drehfest verbundene Codiereinrichtung (z.B. eine Codierscheibe) auf, welche in einem Weg des Lichtstrahls (z.B. des nicht reflektierten und des reflektierten Lichtstrahls) zwischen dem Spiegel und der stationären Sensoreinrichtung angeordnet ist und eine Mehrzahl von Schlitzen aufweist, wodurch die Reflexionseinrichtung dazu eingerichtet ist, bei Rotation des Drehgestells wenigstens einen auf die Reflexionseinrichtung treffenden Lichtstrahl impulsweise entsprechend der Rotationsrichtung und/oder dem Winkel (bzw. Rotationsweg) und/oder der Rotationsgeschwindigkeit durch die Mehrzahl von Schlitzen hindurch zu reflektieren.

Die wenigstens eine Rotation-Messeinrichtung kann in einem weiteren Beispiel eine (z.B. bezüglich des Verfahrwagens) stationäre Sensoreinrichtung, eine der Sensoreinrichtung gegenüberliegende (z.B. bezüglich des Verfahrwagens) stationäre Lichtstrahlsendeeinrichtung (die z.B. wenigstens eine Lichtstrahlquelle, beispielsweise wenigstens oder genau zwei Lichtstrahlquellen, aufweist) und eine mit dem Drehgestell drehfest verbundene Codiereinrichtung (z.B. eine Codierscheibe) aufweisen, wobei die stationäre Lichtstrahlsendeeinrichtung dazu eingerichtet ist, wenigstens einen Lichtstrahl (z.B. wenigstens oder genau zwei Lichtstrahlen) in Richtung zur stationären Sensoreinrichtung auszusenden, wobei der Verfahrwagen sich zwischen der stationären Sensoreinrichtung und der stationären Lichtstrahlsendeeinrichtung bewegt, so dass die Codiereinrichtung in einem Weg des wenigstens einen Lichtstrahls zwischen der stationären Lichtstrahlsendeeinrichtung und der stationären Sensoreinrichtung angeordnet ist, die Codiereinrichtung eine Mehrzahl von Schlitzen aufweist und dazu eingerichtet ist, den von der stationären Lichtstrahlsendeeinrichtung ausgesendeten wenigstens einen Lichtstrahl bei einer Rotation des Drehgestells unter Erzeugung von Lichtimpulsen entsprechend der Rotationsrichtung und/oder dem Winkel (bzw. Rotationsweg) und/oder der Rotationsgeschwindigkeit des Drehgestells mittels der Mehrzahl von Schlitzen in Richtung zur stationären Sensoreinrichtung durch die Mehrzahl von Schlitzen durchzulassen, und die stationäre Sensoreinrichtung dazu eingerichtet ist, die erzeugten Lichtimpulse zu empfangen und anhand der empfangenen Lichtimpulse einen Winkel (bzw. einen Rotationsweg) und/oder die Rotationsgeschwindigkeit und/oder die Rotationsrichtung des Drehgestells zu ermitteln.

In noch einem weiteren Beispiel kann die wenigstens eine Rotation-Messeinrichtung eine (z.B. bezüglich des Verfahrwagens) stationäre Sensoreinrichtung, eine an dem Verfahrwagen angebrachte Verfahrwagen-Lichtstrahlsendeeinrichtung (die z.B. wenigstens eine Lichtstrahlquelle, beispielsweise wenigstens oder genau zwei Lichtstrahlquellen, aufweist) und eine mit dem Drehgestell drehfest verbundene Codiereinrichtung (z.B. eine Codierscheibe) aufweisen, wobei die Verfahrwagen-Lichtstrahlsendeeinrichtung dazu eingerichtet ist, wenigstens einen Lichtstrahl (z.B. wenigstens oder genau zwei Lichtstrahlen) in Richtung zur stationären Sensoreinrichtung auszusenden, die Codiereinrichtung in einem Weg des wenigstens einen Lichtstrahls zwischen der Verfahrwagen-Lichtstrahlsendeeinrichtung und der stationären Sensoreinrichtung angeordnet ist und eine Mehrzahl von Schlitzen aufweist und dazu eingerichtet ist, den von der Verfahrwagen-Lichtstrahlsendeeinrichtung ausgesendeten wenigstens einen Lichtstrahl bei einer Rotation des Drehgestells unter Erzeugung von Lichtimpulsen entsprechend der Rotationsrichtung und/oder dem Winkel (bzw. Rotationsweg) und/oder der Rotationsgeschwindigkeit des Drehgestells mittels der Mehrzahl von Schlitzen in Richtung zur stationären Sensoreinrichtung durchzulassen, und die stationäre Sensoreinrichtung dazu eingerichtet ist, die erzeugten Lichtimpulse zu empfangen und anhand der empfangenen Lichtimpulse einen Winkel (bzw. einen Rotationsweg) und/oder die Rotationsrichtung und/oder die Rotationsgeschwindigkeit des Drehgestells zu ermitteln. Die Verfahrwagen-Lichtstrahlsendeeinrichtung kann beispielsweise eine Batterie (z.B. einem austauschbaren Akkumulator) zur Versorgung mit elektrischer Energie aufweisen und/oder kann dazu eingerichtet sein, ihre zum Betrieb erforderliche elektrische Energie dem Magnetfeld der Translation-Elektromagneteinrichtungen und/oder der Rotation-Elektromagneteinrichtungen zu entziehen.

Zusätzlich oder alternativ kann die wenigstens eine Rotation-Messeinrichtung eine an dem Verfahrwagen angebrachte Verfahrwagen-Rotationserfassungseinrichtung und eine mit der Steuereinrichtung verbundene Empfangseinheit aufweisen, wobei die an dem Verfahrwagen angebrachte Verfahrwagen-Rotationserfassungseinrichtung dazu eingerichtet ist, den Winkel und/oder die Rotationsgeschwindigkeit und/oder die Rotationsrichtung des Drehgestells zu erfassen und den erfassten Winkel und/oder die erfasste Rotationsgeschwindigkeit und/oder die erfasste Rotationsrichtung des Drehgestells drahtlos an die Empfangseinheit zu übermitteln, und wobei die Empfangseinheit dazu eingerichtet ist, die empfangenen Informationen über den Winkel und/oder die Rotationsgeschwindigkeit und/oder die Rotationsrichtung des Drehgestells an die Steuereinheit zu übermitteln. Die Verfahrwagen-Rotationserfassungseinrichtung kann beispielsweise dazu eingerichtet sein, den Winkel (bzw. den Rotationsweg) und/oder die Rotationsgeschwindigkeit und/oder die Rotationsrichtung des Drehgestells in beliebiger Weise, z.B. bevorzugt in optischer Weise und/oder magnetischer Weise, zu erfassen und den erfassten Winkel und/oder die erfasste Rotationsgeschwindigkeit und/oder die erfasste Rotationsrichtung des Drehgestells als Daten über eine Funkverbindung an die Empfangseinheit zu übermitteln. Die Verfahrwagen-Rotationserfassungseinrichtung kann beispielsweise eine an dem Verfahrwagen angebrachte Batterie (z.B. einen austauschbaren Akkumulator) zur Versorgung mit elektrischer Energie aufweisen und/oder kann dazu eingerichtet sein, die für ihren Betrieb erforderliche elektrische Energie dem Magnetfeld der Translation-Elektromagneteinrichtungen und/oder der Rotation-Elektromagneteinrichtungen zu entziehen.

Es ist auch möglich, dass verschiedene Beispiele der wenigstens einen Rotation-Messeinrichtung, die oben beschrieben wurden, in Kombination verwendet werden. Beispielsweise kann die Rotation des Drehgestells in optischer Weise (z.B. mittels eines der oben beschriebenen Beispiele zur optischen Messung) gemessen werden und kann gleichzeitig die Rotation des Drehgestells mittels einer Verfahrwagen-Rotationserfassungseinrichtung gemessen werden und der von der Verfahrwagen-Rotationserfassungseinrichtung erfasste Winkel und/oder die erfasste Rotationsgeschwindigkeit und/oder die von der Verfahrwagen-Rotationserfassungseinrichtung erfasste Rotationsrichtung des Drehgestells drahtlos an eine mit der Steuereinrichtung verbundene Empfangseinheit übermittelt werden und wobei die Empfangseinheit die empfangenen Informationen über den Winkel und/oder die Rotationsgeschwindigkeit und/oder die Rotationsrichtung des Drehgestells an die Steuereinheit übermittelt.

Die Steuereinrichtung kann eine Translationssteuereinrichtung, die mit der (den) Translation-Elektromagneteinrichtung(en) verbunden ist und dazu eingerichtet ist, die translatorische Bewegung des Verfahrwagens zu steuern, und eine Rotationsteuereinrichtung aufweisen, mit der (den) Rotation-Elektromagneteinrichtung(en) verbunden ist und die dazu eingerichtet ist, die Rotation des Drehgestells zu steuern. Ferner kann die Steuereinrichtung eine Überlagerungssteuereinrichtung (z.B. eine Steuereinheit mit einem Prozessor) aufweisen, die mit der Translationssteuereinrichtung und der Rotationsteuereinrichtung verbunden ist und die dazu eingerichtet ist, entsprechende Steuersignale zu erzeugen und an die Translationssteuereinrichtung und die Rotationsteuereinrichtung zu übermitteln, um die translatorische Bewegung des Verfahrwagens und die Rotation des Drehgestells in überlagerter Weise zu steuern (und somit eine überlagerte Bewegung aus der translatorischen Bewegung und der Rotation des Bauteils zu erzeugen). Die Translationssteuereinrichtung weist beispielsweise erste Translation-Umrichtereinrichtungen auf, die jeweilig mit zugehörigen Elektromagneten der ersten Translation-Elektromagneteinrichtung verbunden sind und dazu eingerichtet sind, die zugehörigen Elektromagneten der ersten Translation-Elektromagneteinrichtung mit elektrischer Energie zu versorgen, so dass eine translatorische Bewegung des Verfahrwagens entlang der Translationsachse erzeugt wird, und die Translationssteuereinrichtung kann ferner zweite Translation-Umrichtereinrichtungen aufweisen, die jeweilig mit zugehörigen Elektromagneten der zweiten Translation-Elektromagneteinrichtung verbunden sind und dazu eingerichtet sind, die zugehörigen Elektromagneten der zweiten Translation-Elektromagneteinrichtung von der Translationssteuereinrichtung mit elektrischer Energie zu versorgen, so dass eine translatorische Bewegung des Verfahrwagens entlang der Translationsachse erzeugt wird. Die Rotationssteuereinrichtung weist beispielsweise erste Rotation-Umrichtereinrichtungen auf, die jeweilig mit zugehörigen Elektromagneten der ersten Rotation-Elektromagneteinrichtung verbunden sind und dazu eingerichtet sind, die zugehörigen Elektromagneten der ersten Rotation-Elektromagneteinrichtung mit elektrischer Energie zu versorgen, so dass eine Rotation des Drehgestells um die Rotationsachse erzeugt wird, und die Rotationssteuereinrichtung kann ferner zweite Rotation-Umrichtereinrichtungen aufweisen, die jeweilig mit zugehörigen Elektromagneten der zweiten Rotation-Elektromagneteinrichtung verbunden sind und dazu eingerichtet sind, die zugehörigen Elektromagneten der zweiten Rotation-Elektromagneteinrichtung mit elektrischer Energie zu versorgen, so dass eine Rotation des Drehgestells um die Rotationsachse erzeugt wird. Die ersten Translation-Umrichtereinrichtungen und die zweiten Translation-Umrichtereinrichtungen können derart eingerichtet sein, dass sie jeweils paarweise in einem Master-Slave-Betrieb arbeiten (z.B. arbeitet bei einem jeweiligen Paar aus einer ersten Translation-Umrichtereinrichtung und einer zweiten Translation-Umrichtereinrichtung die erste Translation-Umrichtereinrichtung als Master und die zweite Translation-Umrichtereinrichtung als Slave oder umgekehrt). Dasselbe gilt gleichermaßen für die ersten Rotation-Umrichtereinrichtungen und die zweiten Rotation-Umrichtereinrichtungen. Eine jede der vorgenannten Umrichtereinrichtungen kann einen Umrichter (z.B. einen Frequenzumrichter), der mit den Elektromagnet-Spulen der Elektromagnete der zugehörigen Elektromagneteinrichtung verbunden ist und dazu eingerichtet ist, die Elektromagnet-Spulen der Elektromagnete der zugehörigen Elektromagneteinrichtung mit elektrischer Energie zu versorgen, und eine Frequenzumrichtersteuereinheit (z.B. mit einem Steuerprozessor) aufweisen, die mit dem zugehörigen Umrichter verbunden ist, und dazu eingerichtet ist, dem zugehörigen Umrichter Steuersignale zuzuführen, um die Energieversorgung der Elektromagnet-Spulen in Abhängigkeit von den Steuersignalen mittels des Umrichters zu steuern.

Ein Verfahrwagen für eine wie z.B. hierin beschriebene Vorrichtung zur Bearbeitung eines Bauteils bereitgestellt, weist beispielsweise auf: einen Rahmen, welcher entlang einer Längsrichtung eine Translationsachse, entlang welcher der Verfahrwagen translatorisch vorwärts und rückwärts bewegbar ist, definiert, ein Drehgestell, das relativ zum Rahmen um eine Rotationsachse drehbar mit dem Rahmen verbunden ist und an welchem das Bauteil anbringbar ist, eine ersten Translation-Permanentmagneteinrichtung, die an dem Rahmen angebracht ist und die entlang der Längsrichtung angeordnete Permanentmagnete, welche mit Elektromagneten einer ersten Translation-Elektromagneteinrichtung der Vorrichtung zusammenwirken können, aufweist, eine Rotation-Permanentmagneteinrichtung, die mit dem Drehgestell verbunden ist, eine sich um die Rotationsachse herum erstreckende Umfangsrichtung definiert und entlang dieser Umfangsrichtung angeordnete Permanentmagnete, welche mit Elektromagneten einer ersten Rotation-Elektromagneteinrichtung und/oder einer zweiten Rotation-Elektromagneteinrichtung der Vorrichtung zusammenwirken können, aufweist, und ein wagenseitiges Längsführungsmittel, das mit einem dazu komplementären führungseinrichtungsseitigen Längsführungsmittel einer stationären Verfahrwagenführungseinrichtung der Vorrichtung zusammenwirken kann, so dass der Verfahrwagen an der Verfahrwagenführungseinrichtung der Vorrichtung translatorisch führbar ist.

Der Verfahrwagen kann in einer Ausgestaltung ferner eine zweite Translation-Permanentmagneteinrichtung aufweisen, die an dem Rahmen bezüglich der Längsrichtung gegenüberliegend der (und z.B. im Abstand zur) ersten Translation-Permanentmagneteinrichtung angebracht ist und die entlang der Längsrichtung angeordnete Permanentmagnete, welche mit einer zweiten Translation-Elektromagneteinrichtung der Vorrichtung zusammenwirken können, aufweist.

Durch die vorliegende Erfindung wird darüber hinaus ein Verfahren zum Betreiben einer Vorrichtung gemäß der vorliegenden Erfindung bereitgestellt, wobei die Steuereinrichtung wenigstens eine der Translation-Elektromagneteinrichtungen und/oder wenigstens eine der Rotation-Elektromagneteinrichtungen derart ansteuert, dass sich der Verfahrwagen in gleichförmiger Weise oder in ungleichförmiger Weise translatorisch bewegt und/oder das Drehgestell in gleichförmiger Weise oder in ungleichförmiger Weise rotiert und dadurch eine überlagerte Bewegung aus translatorischer Bewegung und Rotation des Bauteils erzeugt wird.

Beispielsweise kann in einer Ausgestaltung die Steuereinrichtung die translatorische Bewegung des Verfahrwagens und die Rotation des Drehgestells derart in überlagernder Weise steuern, dass eine konstante Rotationsgeschwindigkeit des Bauteils in eine Rotationsrichtung bei einer variierenden Translationsgeschwindigkeit des Bauteils erzeugt wird.

Beispielsweise kann in noch einer weiteren Ausgestaltung die Steuereinrichtung die translatorische Bewegung des Verfahrwagens und die Rotation des Drehgestells derart in überlagernder Weise steuern, dass eine konstante Translationsgeschwindigkeit des Bauteils bei einer variierenden Rotationsgeschwindigkeit des Bauteils in eine Rotationsrichtung erzeugt wird.

Ferner kann in noch einer weiteren Ausgestaltung die Steuereinrichtung Signale, welche Informationen hinsichtlich eines Translationswegs und einer Translationsrichtung des Verfahrwagens aufweisen, von wenigstens einer Translation-Messeinrichtung zum berührungslosen Messen der translatorischen Bewegung des Verfahrwagens erhalten und Signale, welche Informationen hinsichtlich eines Winkels (bzw. eines Rotationswegs) und/oder einer Rotationsgeschwindigkeit und/oder einer Rotationsrichtung des Drehgestells des Verfahrwagens aufweisen, von wenigstens einer Rotation-Messeinrichtung zum berührungslosen Messen der Rotation des Drehgestells erhalten und kann die Steuereinrichtung eine translatorische Bewegung des Verfahrwagens in Abhängigkeit von den Signalen von der wenigstens einen Translation-Messeinrichtung steuern und eine Rotation des Drehgestells in Abhängigkeit den Signalen von der wenigstens einen Rotation-Messeinrichtung steuern.

Außerdem kann einer noch weiteren Ausgestaltung die wenigstens eine Rotation-Messeinrichtung den Winkel (bzw. den Rotationsweg) und/oder die Rotationsgeschwindigkeit und/oder die Rotationsrichtung des Drehgestells in optischer Weise mittels einer stationären Sensoreinrichtung erfassen, wobei sich ein Messabstand der stationären Sensoreinrichtung zum Drehgestell in Abhängigkeit von der translatorischen Bewegung des Verfahrwagens verändert, und/oder kann die wenigstens eine Rotation-Messeinrichtung eine an dem Verfahrwagen angebrachte Verfahrwagen-Rotationserfassungseinrichtung und eine Empfangseinheit aufweisen, wobei die Verfahrwagen-Rotationserfassungseinrichtung den Winkel und/oder die erfasste Rotationsgeschwindigkeit und/oder die Rotationsrichtung des Drehgestells erfasst und den erfassten Winkel und/oder die erfasste Rotationsgeschwindigkeit und/oder die erfasste Rotationsrichtung des Drehgestells drahtlos an die Empfangseinheit übermittelt.

Darüber hinaus kann in einer noch weiteren Ausgestaltung die wenigstens eine Translation-Messeinrichtung den Translationsweg und die Translationsrichtung des Verfahrwagens in magnetischer Weise und/oder in optischer Weise erfassen.

Wird in dieser Anmeldung in Bezug auf die Erfindung von "einem Bauteil", "einem Verfahrwagen", "einem Drehgestell" gesprochen, so bedeutet dies nicht, dass die Erfindung auf "genau ein Bauteil", "genau einen Verfahrwagen" oder "genau ein Drehgestell" beschränkt ist, sondern bedeutet stattdessen vielmehr, dass auch weitere der vorgenannten Teile und Komponenten vorhanden sein können. Beispielsweise kann die Vorrichtung auch mehrere Verfahrwagen aufweisen. Ferner kann wenigstens einer oder jeder Verfahrwagen zur Halterung von mehreren Bauteilen eingerichtet sein, z.B. indem der jeweilige Verfahrwagen mehrere Drehgestelle aufweist. Bei Vorsehen mehrerer Drehgestelle können diese ferner dazu eingerichtet sein, voneinander unabhängig zu rotieren (z.B. durch entsprechende Ansteuerung der Rotation-Permanentmagneteinrichtungen), oder können ferner derart (z.B. über Getriebeeinrichtungen) miteinander gekuppelt sein, dass sie sich gleichzeitig in dieselbe Rotationsrichtung und/oder mit derselben Rotationsgeschwindigkeit drehen.

### Kurze Beschreibung der Zeichnungen

Ausgestaltungen der Erfindung sind in den Figuren dargestellt und werden im Folgenden näher erläutert, wobei der aus Gründen der Übersichtlichkeit nicht jede Figur stets alle Merkmale der Erfindung zeigt, sondern bestimmte Merkmale nicht dargestellt sein können.
Fig. 1 ist eine Draufsicht auf eine beispielhafte Vorrichtung zur Bearbeitung eines Bauteils gemäß der vorliegenden Erfindung.
Fig. 2 ist eine Draufsicht auf einen beispielhaften Verfahrwagen für eine Vorrichtung gemäß der vorliegenden Erfindung.
Fig. 3 ist eine Seitenansicht einer beispielhaften Vorrichtung zur Bearbeitung eines Bauteils gemäß der vorliegenden Erfindung mit mehreren Modulen.
Fig. 4 ist eine Querschnittansicht durch eine beispielhafte Vorrichtung zur Bearbeitung eines Bauteils gemäß der vorliegenden Erfindung.
Fig. 5, 7, 9, 11, 13, und 15 sind jeweils Querschnittansichten von Beispielen für wagenseitige und führungseinrichtungsseitige Längsführungsmittel einer beispielhaften Vorrichtung zur Bearbeitung eines Bauteils gemäß der vorliegenden Erfindung.
Fig. 6, 8, 10, 12, 14 und 16 sind jeweils zu den Querschnittansichten von Fig. 5, 7, 9, 11, 13, und 15 zugehörige Seitenansichten von Beispielen für wagenseitige und führungseinrichtungsseitige Längsführungsmittel einer beispielhaften Vorrichtung zur Bearbeitung eines Bauteils gemäß der vorliegenden Erfindung.
Fig. 17 bis 20 sind Beispiele einer Rotation-Messeinrichtung für eine beispielhafte Vorrichtung zur Bearbeitung eines Bauteils gemäß der vorliegenden Erfindung.
Fig. 21 und 22 sind eine Querschnittansicht und eine Seitenansicht, welche einen Bremsmechanismus einer beispielhaften Vorrichtung zur Bearbeitung eines Bauteils gemäß der vorliegenden Erfindung zeigen.
Fig. 23 ist eine weitere Querschnittansicht einer beispielhaften Vorrichtung zur Bearbeitung eines Bauteils gemäß der vorliegenden Erfindung.
Fig. 24 zeigt ein schematisches Blockdiagramm, welches das Zusammenwirken und die Funktionsweise der Vorrichtung gemäß der vorliegenden Erfindung veranschaulicht

### Detaillierte Beschreibung

In der folgenden ausführlichen Beschreibung wird auf die beigefügten Zeichnungen Bezug genommen, die Teil dieser bilden und in denen zur Veranschaulichung spezifische Beispiele und Ausführungsformen gezeigt sind, in denen die Erfindung ausgeübt werden kann. In dieser Hinsicht wird Richtungsterminologie wie etwa "oben", "unten", "vorne", "hinten", "vorderes", "hinteres", usw. mit Bezug auf die Orientierung der beschriebenen Figur(en) verwendet. Da Komponenten von Beispielen und Ausführungsformen in einer Anzahl verschiedener Orientierungen positioniert werden können, dient die Richtungsterminologie zur Veranschaulichung und ist auf keinerlei Weise einschränkend. Es versteht sich, dass andere Beispiele und Ausführungsformen benutzt und strukturelle oder logische Änderungen vorgenommen werden können, ohne von dem Schutzumfang der vorliegenden Erfindung abzuweichen. Es versteht sich, dass die Merkmale der hierin beschriebenen verschiedenen Beispiele und Ausführungsformen miteinander kombiniert werden können, sofern nicht spezifisch anders angegeben. Die folgende ausführliche Beschreibung ist deshalb nicht in einschränkendem Sinne aufzufassen, und der Schutzumfang der vorliegenden Erfindung wird durch die angefügten Ansprüche definiert.

Im Rahmen dieser Beschreibung werden die Begriffe "verbunden", "angeschlossen" sowie "gekoppelt" verwendet zum Beschreiben sowohl einer direkten als auch einer indirekten Verbindung, eines direkten oder indirekten Anschlusses sowie einer direkten oder indirekten Kopplung. In den Figuren werden identische oder ähnliche Elemente mit identischen Bezugszeichen versehen, soweit dies zweckmäßig ist.

Mit Bezug auf die Figuren weist eine Vorrichtung 1 zur Bearbeitung eines Bauteils 3 einen Verfahrwagen 10 auf.

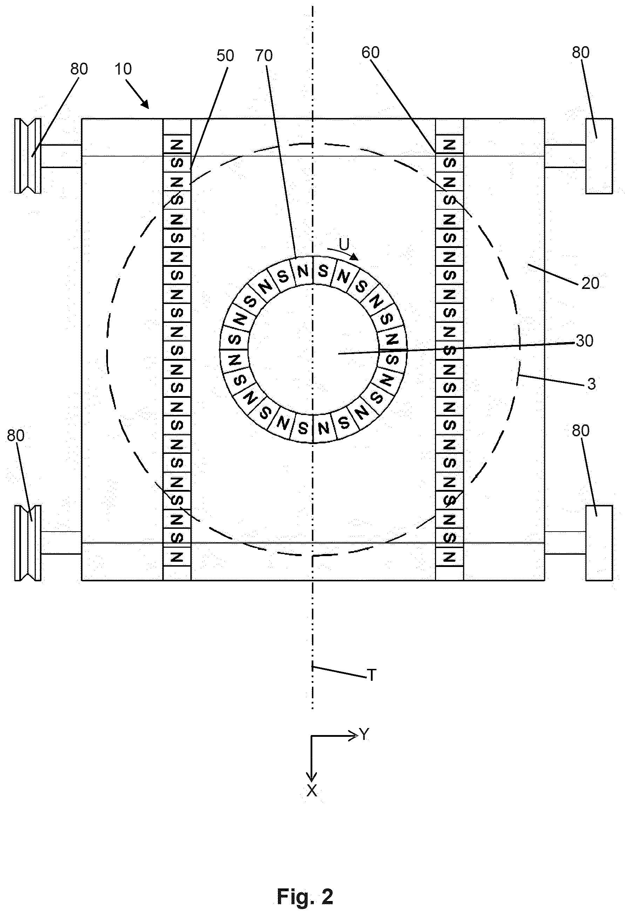

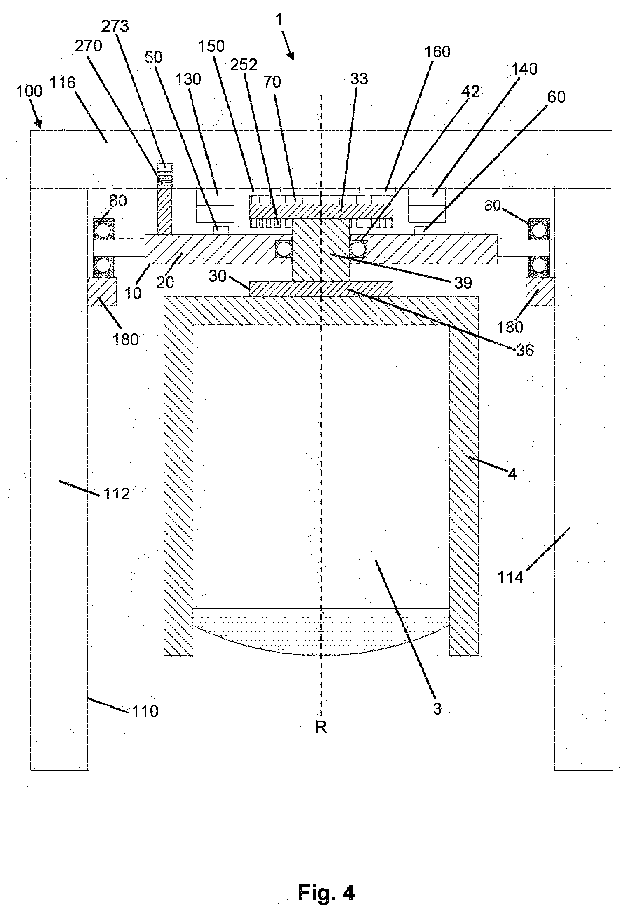

Der Verfahrwagen 10 weist, wie z.B. in Fig. 2 und 4 genauer gezeigt, einen Rahmen 20 auf, welcher entlang einer Längsrichtung X eine Translationsachse T, entlang welcher der Verfahrwagen 10 translatorisch vorwärts und rückwärts bewegbar ist, definiert. Der Verfahrwagen 100 weist ferner ein Drehgestell 30 auf, welches relativ zum Rahmen 20 um eine Rotationsachse R drehbar mit dem Rahmen 20 verbunden ist und an welchem das Bauteil 3 anbringbar ist. Das Drehgestell 30 weist z.B. ein erstes Rad (z.B. hier ein oberes Rad) 33, ein zweites Rad (z.B. hier ein unteres Rad) 36, welches dem ersten Rad 33 gegenüberliegend angeordnet ist und an welchem das Bauteil 3 anbringbar ist, und eine Welle 39, welche das erste Rad 33 und das zweite Rad 36 miteinander verbindet, auf. Beispielsweise kann der Rahmen 20 eine zentrale Durchgangsöffnung aufweisen, durch welche die Welle 39 hindurch verläuft, so dass das erste Rad 33 auf einer ersten Seite (z.B. oberhalb) des Rahmens 20 und das zweite Rad 36 auf einer zweiten Seite (z.B. unterhalb) des Rahmens 20 angeordnet ist. Das Bauteil 3 kann mittels einer Befestigungsvorrichtung 4, die z.B. in Form einer Käfigstruktur ausgebildet ist und mit dem Bauteil 3 (z.B. fest) verbunden ist, an dem zweiten Rad 33 des Drehgestells 30 angebracht sein. Der Verfahrwagen 10 weist ferner ein Drehlager 42, z.B. ein Axiallager (beispielsweise ein Axial-Schrägkugellager, ein Axial-Pendelrollenlager, etc.), auf, welches die Welle 39 drehbar mit dem Rahmen 20 des Verfahrwagens 10 verbindet.

Obwohl in den Figuren der Rahmen 20 als ein blockförmiger Körper dargestellt ist, ist dieser nicht auf eine derartige Ausgestaltung beschränkt und kann der Rahmen 20 auf zahlreiche Weisen ausgebildet sein. Beispielsweise kann der Rahmen 20 auch aus einer Mehrzahl von separaten Rahmenträgern ausgebildet sein, die sich z.B. jeweilig in Längsrichtung X und Querrichtung Y erstrecken und miteinander verbunden sind, um den Rahmen 20 auszubilden.

Der Verfahrwagen 10 weist ferner eine erste Translation-Permanentmagneteinrichtung 50 auf, die an dem Rahmen 20 (z.B. an einer Oberseite davon) angebracht ist und die entlang der Längsrichtung X angeordnete Permanentmagnete aufweist. Zudem kann der Verfahrwagen 10 eine zweite Translation-Permanentmagneteinrichtung 60 aufweisen, die an dem Rahmen 20 (z.B. an einer Oberseite davon) bezüglich der Längsrichtung X gegenüberliegend der (und z.B. im Abstand zur) ersten Translation-Permanentmagneteinrichtung 50 angebracht ist und die entlang der Längsrichtung X angeordnete Permanentmagnete aufweist.

Außerdem weist der Verfahrwagen 100 eine Rotation-Permanentmagneteinrichtung 70 auf, die an dem Drehgestell 30 angebracht ist, eine sich um die Rotationsachse R herum erstreckende Umfangsrichtung U definiert und entlang dieser Umfangsrichtung U angeordnete Permanentmagnete aufweist. Wie in Fig. 4 genauer gezeigt, trägt beispielsweise das erste Rad 33 (z.B. an einer Oberseite davon) die Permanentmagnete der Rotation-Permanentmagneteinrichtung 70.

Die erste und die zweite Translation-Permanentmagneteinrichtungen 50 und 60 sowie die Rotation-Permanentmagneteinrichtung 70 weisen z.B. eine Mehrzahl von unterschiedlich gepolten Permanentmagneten auf, die abwechselnd angeordnet sind. Beispielsweise weisen sowohl die erste als auch die zweite Translation-Permanentmagneteinrichtung 50 und 60 eine Mehrzahl von Nordpol-Permanentmagneten (d.h. mit dem Nordpol im Wesentlichen zur jeweiligen Translation-Elektromagneteinrichtung ausgerichtete Permanentmagneten) und eine Mehrzahl von Südpol-Permanentmagneten (d.h. mit dem Südpol im Wesentlichen zur jeweiligen Translation-Elektromagneteinrichtung ausgerichtete Permanentmagneten) (in Fig. 2 durch die Buchstaben "N" für die Nordpol-Permanentmagnete und "S" für die Südpol-Permanentmagnete veranschaulicht) auf, welche entlang der Längsrichtung X abwechselnd (z.B. in der in Fig. 2 gezeigten Reihenfolge Nordpol-Permanentmagnet N, Südpol-Permanentmagnet S, Nordpol-Permanentmagnet N, Südpol-Permanentmagnet S, usw.) angeordnet sind. Außerdem weist die Rotation-Permanentmagneteinrichtung 70 beispielsweise eine Mehrzahl von Nordpol-Permanentmagneten N (d.h. mit dem Nordpol im Wesentlichen zur jeweiligen Rotation-Elektromagneteinrichtung ausgerichtete Permanentmagneten) und eine Mehrzahl von Südpol-Permanentmagneten S (d.h. mit dem Südpol im Wesentlichen zur jeweiligen Rotation-Elektromagneteinrichtung ausgerichtete Permanentmagneten) auf, welche entlang der Umfangsrichtung U abwechselnd (z.B. ebenfalls in der zuvor genannten Reihenfolge) angeordnet sind, wie in Fig. 2 veranschaulicht ist. Die Permanentmagnete der ersten und der zweiten Translation-Permanentmagneteinrichtungen 50 und 60 sowie der Rotation-Permanentmagneteinrichtung 70 können aus einem Permanentmagnetmaterial, insbesondere einem vakuumgeeigneten Permanentmagnetmaterial, ausgebildet sein. Rein beispielhaft und nicht einschränkend seien hier Neodym-Eisen-Bor (NdFeB) und Samarium-Cobalt (SmCo) als mögliche Permanentmagnetmaterialen genannt.

Die Vorrichtung 1 weist ferner eine stationäre Verfahrwagenführungseinrichtung 100 auf. Die Verfahrwagenführungseinrichtung 100 ist gemäß der vorliegenden Erfindung z.B. aus einer Gestellstruktur gebildet, welche entlang der Längsrichtung X im Abstand voneinander angeordnete Querbügel 110 aufweist, welche jeweils seitliche Pfosten 112 und 114 (z.B. jeweils zwei seitliche Pfosten pro Querbügel), die bezüglich der Längsrichtung X gegenüberliegend voneinander (und zueinander im Abstand) angeordnet sind, und einen Querträger 116 aufweisen, welcher sich quer zur Längsrichtung X (bzw. im Wesentlichen entlang der Querrichtung Y) erstreckt und die Pfosten 112 und 114 miteinander verbindet.

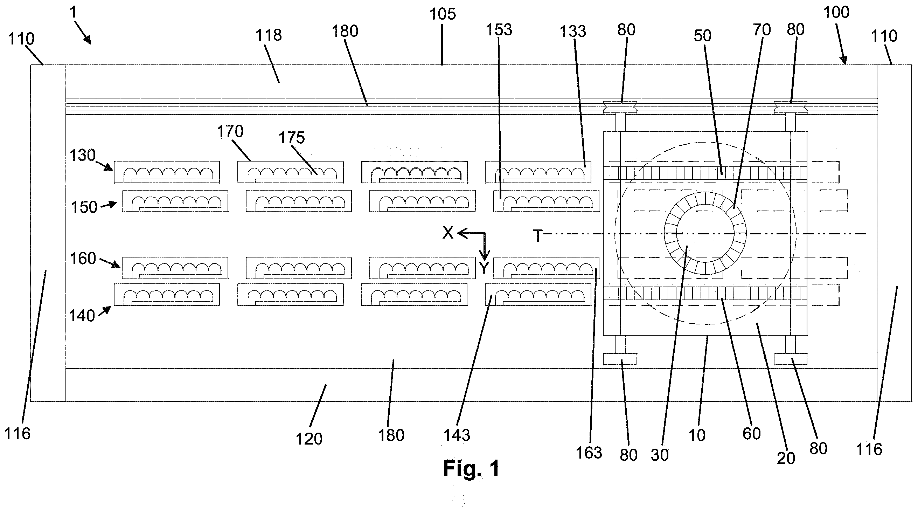

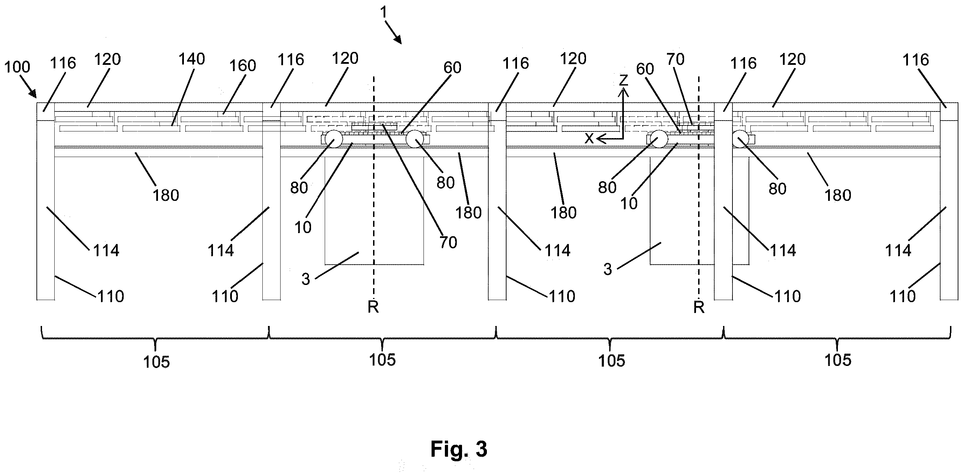

Die Gestellstruktur weist beispielsweise einzelne Module 105 auf (wie in Fig. 3 gezeigt), wobei jedes Modul 105 aus zwei Querbügel 110, die mittels sich entlang der Längsrichtung X erstreckenden Querbügellängsträgern 118 und 120 miteinander verbunden sind, aufweist. Wie besonders in Fig. 1 gezeigt, verbinden ein erster Querbügellängsträger 118 und ein zweiter Querbügellängsträger 120 zwei Querbügel 110 eines jeweiligen Moduls 105. Es können auch noch weitere Querbügellängsträger auf unterschiedlichen Höhen zur Verbindung der Querbügel jeweiliger Module vorgesehen sein, um die Stabilität der Gestellstruktur weiter zu erhöhen.

Die Vorrichtung 1 weist eine erste Translation-Elektromagneteinrichtung 130 auf, die an der Verfahrwagenführungseinrichtung 100 (z.B. an den Querträgern 116 der Querbügel 100) angebracht ist und die entlang der Längsrichtung X angeordnete Elektromagnete 133, welche mit den Permanentmagneten der ersten Translation-Permanentmagneteinrichtung 50 magnetisch zusammenwirken, aufweist. Die Vorrichtung 1 weist beispielsweise ferner eine zweite Translation-Elektromagneteinrichtung 140 auf, die bezüglich der Längsrichtung X gegenüberliegend der (und z.B. im Abstand zur) ersten Translation-Elektromagneteinrichtung 130 an der Verfahrwagenführungseinrichtung 100 (z.B. an den Querträgern 116 der Querbügel 100) angebracht ist und die entlang der Längsrichtung X angeordnete Elektromagnete 143, welche mit den Permanentmagneten der zweiten Translation-Permanentmagneteinrichtung 60 magnetisch zusammenwirken, aufweist. Außerdem weist die Vorrichtung 1 eine erste Rotation-Elektromagneteinrichtung 150 auf, die an der Verfahrwagenführungseinrichtung 100 (z.B. an den Querträgern 116 der Querbügel 100) angebracht ist und die entlang der Längsrichtung X angeordnete Elektromagnete 153, welche mit den Permanentmagneten der Rotation-Permanentmagneteinrichtung 70 magnetisch zusammenwirken, aufweist. Die Vorrichtung 1 gemäß der vorliegenden Erfindung weist ferner eine zweite Rotation-Elektromagneteinrichtung 160 auf, die bezüglich der Längsrichtung X gegenüberliegend der (und z.B. im Abstand zur) ersten Rotation-Elektromagneteinrichtung 150 an der Verfahrwagenführungseinrichtung 100 (z.B. an den Querträgern 116 der Querbügel 100) angebracht ist und die entlang der Längsrichtung X angeordnete Elektromagnete 163, welche mit den Permanentmagneten der Rotation-Permanentmagneteinrichtung 70 magnetisch zusammenwirken, aufweist.

Die Elektromagnete 133, 143 der ersten und/oder der zweiten Translation-Elektromagneteinrichtung 130, 140 und/oder die Elektromagnete 153, 163 der ersten und/oder der zweiten Rotation-Elektromagneteinrichtung 150, 160 können jeweilig ein Gehäuse 170 aufweisen (in Fig. 1 zur besseren Übersichtlichkeit beispielhaft nur durch ein Bezugszeichen an einer Elektromagneteinrichtung angedeutet). Das Gehäuse 170 kann derart eingerichtet sein, dass ein Gehäuseinnenraum gegenüber der Umgebung luftdicht ist. Das Gehäuse 170 weist beispielsweise eine Grundplatte, eine an der Grundplatte (z.B. fest) angebrachte Spulenabdeckung sowie eine zwischen Grundplatte und Spulenabdeckung vorgesehene Dichtung auf. In dem Gehäuse sind Elektromagnet-Spulen 175 (in Fig. 1 zur besseren Übersichtlichkeit beispielhaft nur durch ein Bezugszeichen an einer Elektromagneteinrichtung angedeutet) des jeweiligen Elektromagneten untergebracht. Ferner sind in dem Gehäuse 170 Kühlmittelkanäle ausgebildet, an welche eine Kühlmittelversorgung anschließbar ist bzw. angeschlossen ist, um dem Gehäuse 170 Kühlmittel zur Kühlung der Elektromagnet-Spulen 175 zuzuführen.

Die Elektromagnete 133 der ersten Translation-Elektromagneteinrichtung 130 können auf einem in der Vertikalrichtung Z (siehe Fig. 3) ersten Niveau angeordnet sein, so dass ein geeigneter, vorbestimmter Luftspalt zwischen den Elektromagneten 133 der ersten Translation-Elektromagneteinrichtung 130 und den Permanentmagneten der ersten Translation-Permanentmagneteinrichtung 50 vorliegt, um ein magnetisches Zusammenwirken der durch die Elektromagneten und die Permanentmagneten erzeugten Magnetfelder zu ermöglichen. Die Elektromagnete 143 der zweiten Translation-Elektromagneteinrichtung 140 können ebenfalls auf dem ersten Niveau angeordnet sein, so dass ein geeigneter, vorbestimmter Luftspalt zwischen den Elektromagneten 143 der zweiten Translation-Elektromagneteinrichtung 140 und den Permanentmagneten der zweiten Translation-Permanentmagneteinrichtung 60 vorliegt, um ein magnetisches Zusammenwirken der durch die Elektromagneten und die Permanentmagneten erzeugten Magnetfelder zu ermöglichen. Es ist jedoch auch möglich, dass die Elektromagnete 133, 143 der ersten und der zweiten Translation-Elektromagneteinrichtung 130, 140 (z.B. bedingt durch eine unterschiedliche Position der ihnen zugeordneten Translation-Pemanentmagneteinrichtung) auf unterschiedlichen Niveaus in der Vertikalrichtung angeordnet sind.

Die Elektromagnete 153 der ersten Rotation-Elektromagneteinrichtung 150 können auf einem in der Vertikalrichtung zweiten Niveau angeordnet sein, so dass ein geeigneter, vorbestimmter Luftspalt zwischen den Elektromagneten 153 der ersten Rotation-Elektromagneteinrichtung 150 und den Permanentmagneten der Rotation-Permanentmagneteinrichtung 70 vorliegt, um ein magnetisches Zusammenwirken der durch die Elektromagneten und die Permanentmagneten erzeugten Magnetfelder zu ermöglichen. Die Elektromagnete 163 der zweiten Rotation-Elektromagneteinrichtung 160 können ebenfalls auf dem zweiten Niveau angeordnet sein, so dass ein geeigneter, vorbestimmter Luftspalt zwischen den Elektromagneten 163 der zweiten Rotation-Elektromagneteinrichtung und den Permanentmagneten der Rotation-Permanentmagneteinrichtung 70 vorliegt, um ein magnetisches Zusammenwirken der durch die Elektromagneten und die Permanentmagneten erzeugten Magnetfelder zu ermöglichen. Das erste Niveau und das zweite Niveau können voneinander unterschiedlich sein, sind jedoch nicht hierauf beschränkt.

Die Vorrichtung 1 gemäß der vorliegenden Erfindung weist ferner eine Steuereinrichtung 200, welche mit der ersten und mit der zweiten Translation-Elektromagneteinrichtung 130, 140 sowie mit der ersten und mit der zweiten Rotation-Elektromagneteinrichtung 150,160 zur Ansteuerung der Elektromagnete davon verbunden ist, um die translatorische Bewegung des Verfahrwagens 10 entlang der Translationsachse T mittels des magnetischen Zusammenwirkens der Elektromagnete 133 der ersten Translation-Elektromagneteinrichtung 130 mit den Permanentmagneten der ersten Translation-Permanentmagneteinrichtung 50 und/oder des magnetischen Zusammenwirkens der Elektromagnete 143 der zweiten Translation-Elektromagneteinrichtung 140 mit den Permanentmagneten der zweiten Translation-Permanentmagneteinrichtung 60 zu steuern und um die Rotationsbewegung des Drehgestells 30 um die Rotationsachse R mittels des magnetischen Zusammenwirkens der Elektromagnete 153 der ersten Rotation-Elektromagneteinrichtung 150 mit den Permanentmagneten der Rotation-Permanentmagneteinrichtung 70 und/oder des magnetischen Zusammenwirkens der Elektromagnete 163 der zweiten Rotation-Elektromagneteinrichtung 160 mit den Permanentmagneten der Rotation-Permanentmagneteinrichtung 70 zu steuern. Die Steuereinrichtung 200 weist beispielsweise eine Translationssteuereinrichtung 203 auf, die dazu eingerichtet ist, die translatorische Bewegung des Verfahrwagens 10 zu steuern, und eine Rotationssteuereinrichtung 206 auf, die dazu eingerichtet ist, die Rotation des Drehgestells 30 zu steuern. Die Translationssteuereinrichtung 203 und die Rotationssteuereinrichtung 206 können auf eine in dieser Anmeldung genannten Weise realisiert sein, sind jedoch nicht darauf beschränkt und können auch auf jede andere geeignete Weise realisiert sein. Ferner kann die Steuereinrichtung 200 eine Überlagerungssteuereinrichtung 209 aufweisen, die mit der Translationssteuereinrichtung 203 und der Rotationsteuereinrichtung 206 verbunden ist und die dazu eingerichtet ist, entsprechende Steuersignale an die Translationssteuereinrichtung 203 und die Rotationsteuereinrichtung 206 zu übermitteln, um die translatorische Bewegung des Verfahrwagens 10 und die Rotation des Drehgestells 30 in überlagerter Weise zu steuern (und somit eine überlagerte Bewegung aus der translatorischen Bewegung und der Rotation des Bauteils 3 zu erzeugen).

In der vorliegenden Erfindung ist die Steuereinrichtung 200 dazu eingerichtet wenigstens eine von der ersten und der zweiten Translation-Elektromagneteinrichtungen 130, 140 derart anzusteuern, dass sich der Verfahrwagen 10 in gleichförmiger Weise oder in ungleichförmiger Weise translatorisch bewegt, und/oder wenigstens eine von der ersten und der zweiten Rotation-Elektromagneteinrichtungen 150, 160 derart anzusteuern, dass das Drehgestell 30 in gleichförmiger Weise oder in ungleichförmiger Weise rotiert. Hierdurch ist die Steuereinrichtung 200 dazu eingerichtet, eine überlagerte Bewegung aus translatorischer Bewegung und Rotation des Bauteils 3 zu erzeugen.

Die Steuereinrichtung 200 ist beispielsweise dazu eingerichtet, die translatorische Bewegung des Verfahrwagens 10 und die Rotation des Drehgestells 30 derart in überlagernder Weise zu steuern, dass eine konstante Rotationsgeschwindigkeit des Bauteils 3 in eine Rotationsrichtung bei einer variierenden Translationsgeschwindigkeit des Bauteils 3 erzeugt wird, oder die translatorische Bewegung des Verfahrwagens 10 und die Rotation des Drehgestells 30 derart in überlagernder Weise zu steuern, dass eine konstante Translationsgeschwindigkeit des Bauteils 3 bei einer variierenden Rotationsgeschwindigkeit des Bauteils 3 in eine Rotationsrichtung erzeugt wird.

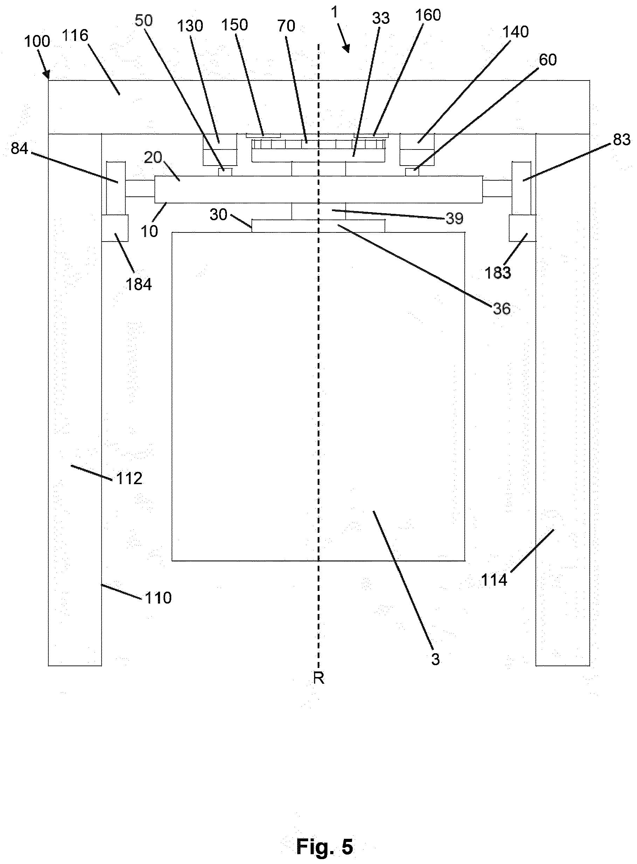

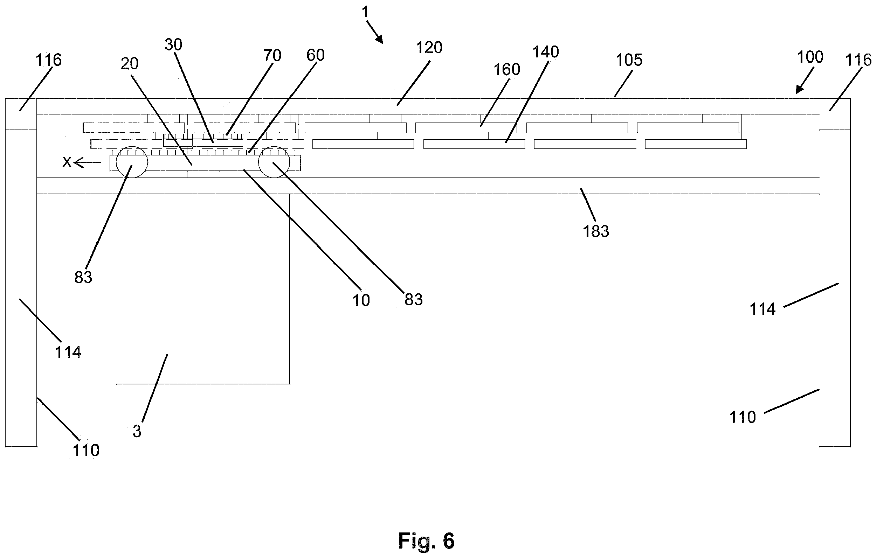

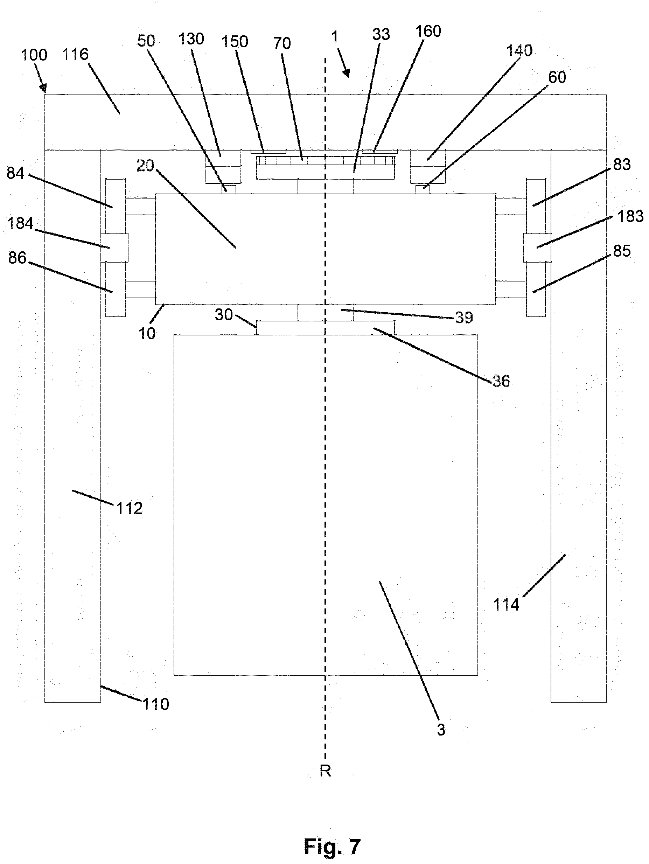

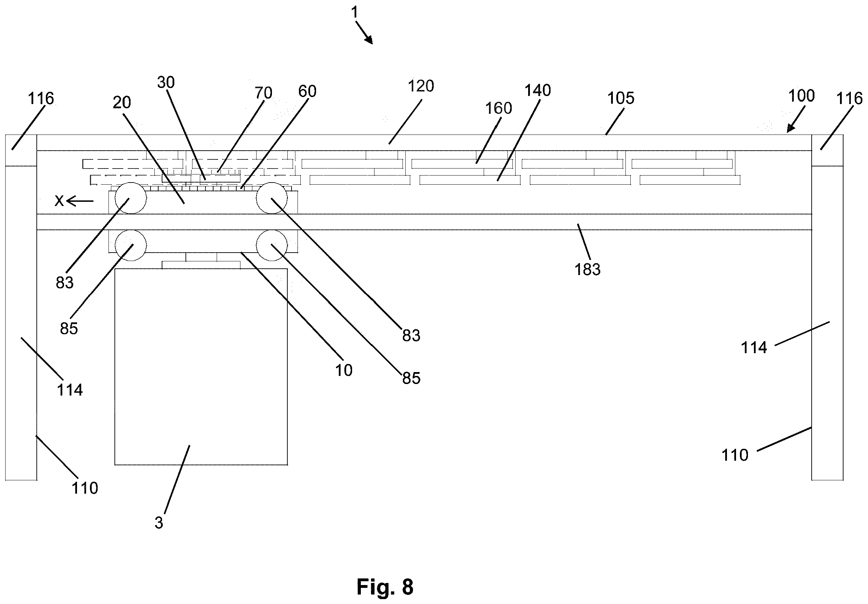

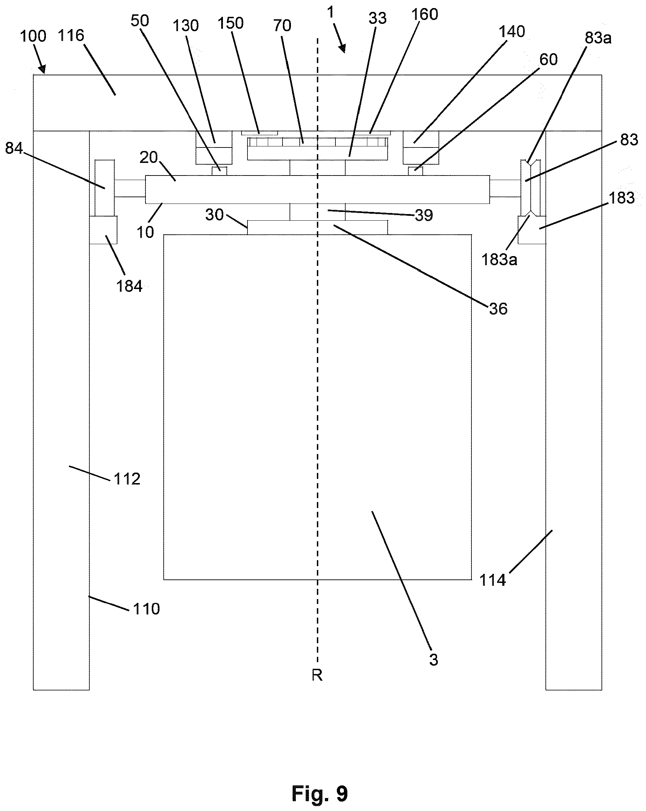

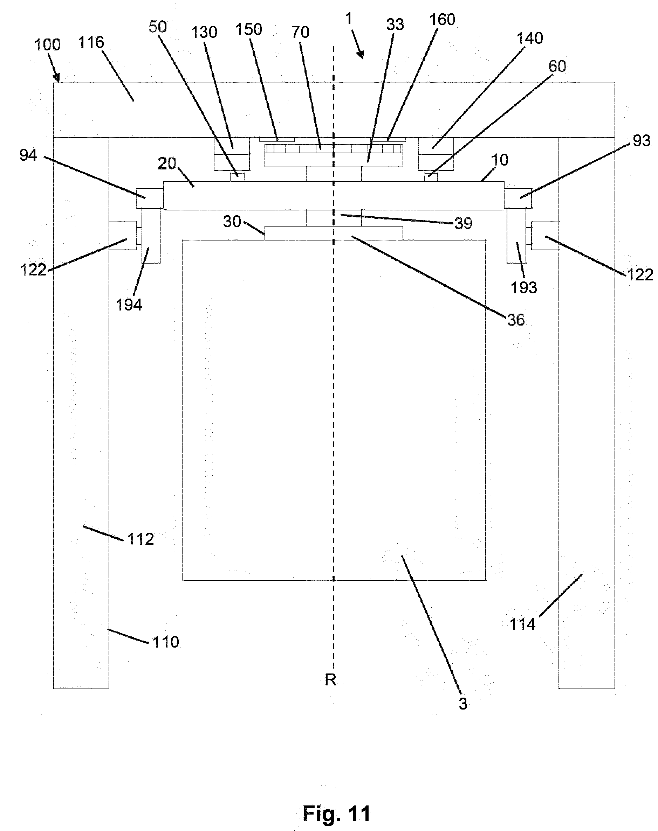

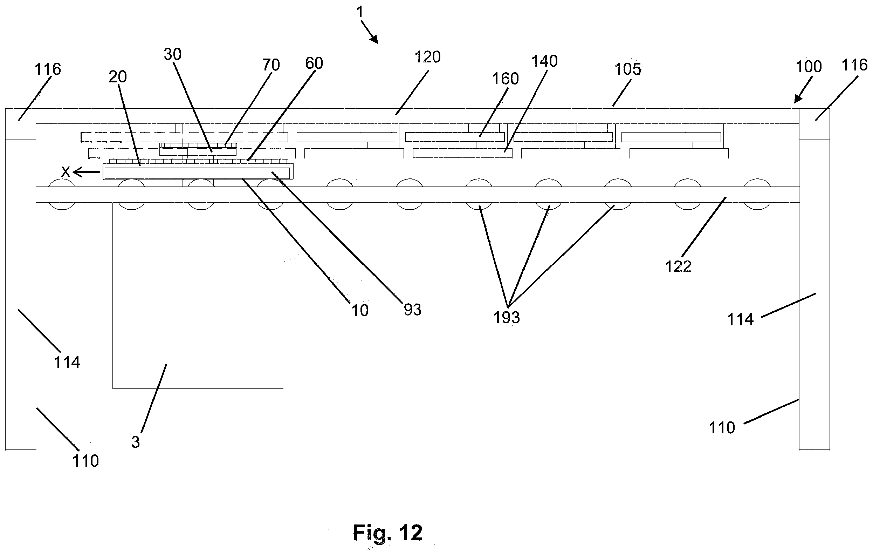

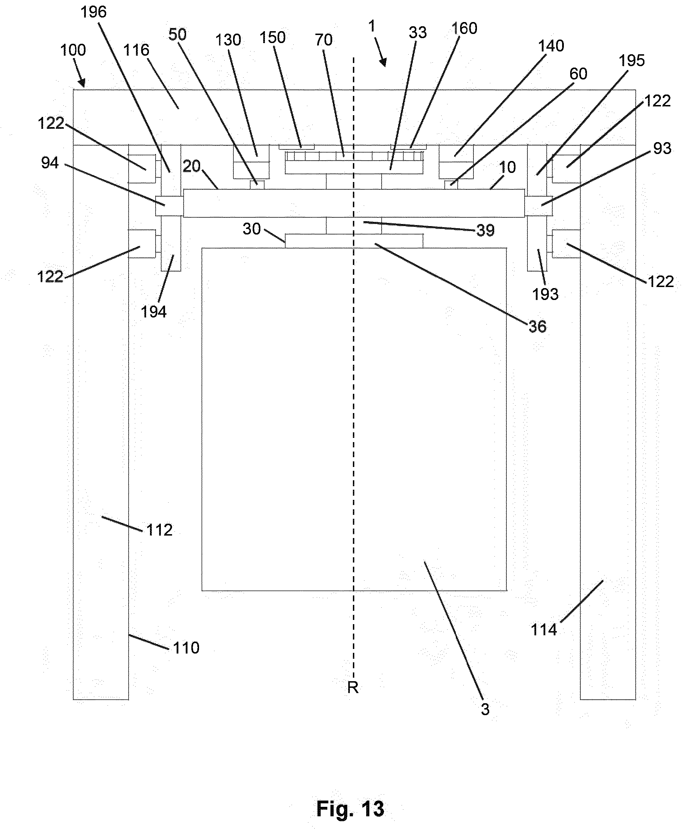

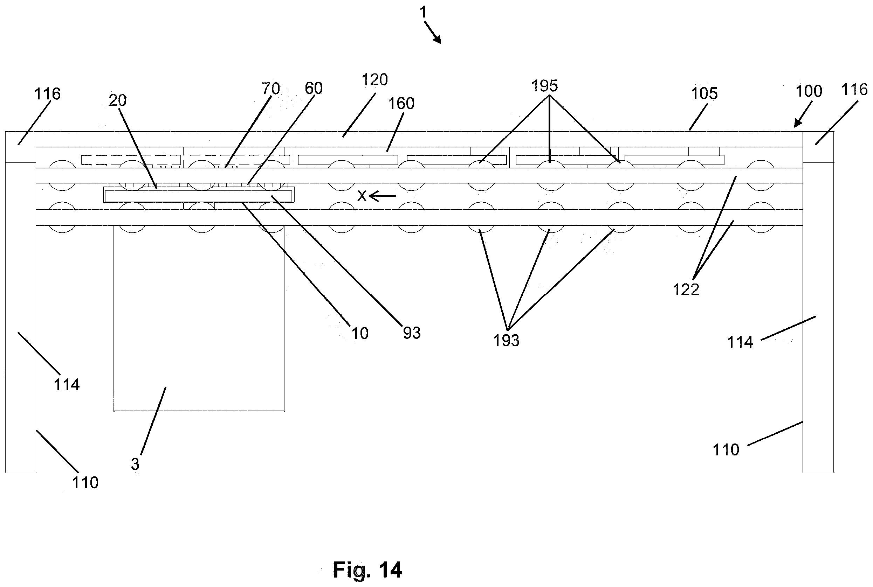

Der Verfahrwagen 10 gemäß der vorliegenden Erfindung weist zudem ein wagenseitiges Längsführungsmittel 80 auf, welches an dem Rahmen 20 angebracht ist, und weist die Verfahrwagenführungseinrichtung 100 ferner ein zu dem wagenseitigen Längsführungsmittel 80 komplementäres führungseinrichtungsseitiges Längsführungsmittel 180 auf, mittels dessen der Verfahrwagen 10 translatorisch geführt ist. Die wagenseitigen Längsführungsmittel 80 und die führungseinrichtungsseitigen Längsführungsmittel 180 können auf zahlreiche Weisen ausgebildet sein, wobei erfindungsgemäße Beispiele nachfolgend unter Bezugnahme auf die Figuren 5 bis 16 genauer beschrieben werden. Die vorliegende Erfindung ist jedoch nicht auf diese Beispiele beschränkt. Ferner sind in einer erfindungsgemäßen Vorrichtung 1 auch Kombinationen der nachstehend beschriebenen Beispiele möglich (z.B. kann eine Vorrichtung 1 eine Kombination aus dem Beispiel nach Fig. 5 und 6 mit dem Beispiel nach Fig. 7 und 8 (z.B. einen Verfahrwagen mit Rollen nach Fig. 5 und 6 auf nur einer Seite und Rollen nach Fig. 7 und 8 auf der anderen Seite) oder eine Kombination aus dem Beispiel nach Fig. 11 und 12 mit dem Beispiel nach Fig. 13 und 14 aufweisen, wobei diese Kombinationen entsprechend auch mit Quer-Festlagern und Quer-Loslagern nach Fig. 9 und 10 bzw. Fig. 15 und 16 möglich sind).

In einem erfindungsgemäßen Beispiel nach Fig. 5 und 6 weist das wagenseitige Längsführungsmittel 80 eine erste wagenseitige Längsführungsmittelkomponente in Form von ersten wagenseitigen Rollen 83 und eine zweite wagenseitige Längsführungsmittelkomponente in Form von zweiten wagenseitigen Rollen 84 auf und weist das führungseinrichtungsseitige Längsführungsmittel 180 eine erste führungseinrichtungsseitige Längsführungsmittelkomponente in Form einer ersten führungseinrichtungsseitigen Längsschiene 183 und eine zweite führungseinrichtungsseitige Längsführungsmittelkomponente in Form einer zweiten führungseinrichtungsseitigen Längsschiene 184 auf. Die erste führungseinrichtungsseitige Längsschiene 183 erstreckt sich entlang der Längsrichtung X, und die zweite führungseinrichtungsseitige Längsschiene 184 ist bezüglich der Längsrichtung X gegenüberliegend der (und z.B. im Abstand zur) ersten führungseinrichtungsseitigen Längsschiene 183 angeordnet und erstreckt sich ebenfalls entlang der Längsrichtung X. Die beiden Längsschienen 183, 184 sind ferner beispielsweise unterhalb der Querträger 116 angeordnet und können die Querbügel 110 miteinander verbinden. Die wagenseitigen Rollen 83, 84 sind drehbar mit dem Rahmen 20 des Verfahrwagens 10 verbunden, wobei beispielsweise die ersten wagenseitigen Rollen 83 an einer ersten Seite des Verfahrwagens 10 angeordnet sind und in der Längsrichtung X im Abstand zueinander angeordnet sind und wobei beispielsweise die zweiten wagenseitigen Rollen 84 an einer bezüglich der Längsrichtung X der ersten Seite gegenüberliegenden zweiten Seite des Verfahrwagens 10 angeordnet sind und in der Längsrichtung X im Abstand zueinander angeordnet sind. Ferner können die wagenseitigen Rollen 83, 84 in den Fig. 5 und 6 als Zylinderrollen bzw. Planrollen, beispielsweise Rollen mit balliger Lauffläche, ausgebildet sein. In den Fig. 5 und 6 sind die ersten wagenseitigen Rollen 83 oberhalb der ersten führungseinrichtungsseitigen Längsschiene 183 angeordnet und liegen auf dieser auf und sind die zweiten wagenseitigen Rollen 84 oberhalb der zweiten führungseinrichtungsseitigen Längsschiene 184 angeordnet und liegen auf dieser. Hierdurch wird die Gewichtskraft des Verfahrwagens 10 und des Bauteils 3 durch die wagenseitigen Rollen 83, 84 und die führungseinrichtungsseitigen Längsschienen 183, 184 abgestützt und wird die Translationsbewegung des Verfahrwagens 10 entlang der Translationsachse T durch die wagenseitigen Rollen 83, 84 und die führungseinrichtungsseitigen Längsschienen 183, 184 geführt.

In einem weiteren erfindungsgemäßen Beispiel nach Fig. 7 und 8 weist das wagenseitige Längsführungsmittel 80 zusätzlich zu den wagenseitigen Rollen 83, 84 die Rollen 85 und 86 auf, die drehbar mit dem Rahmen 20 des Verfahrwagens 10 verbunden sind und die als Zylinderrollen bzw. Planrollen, beispielsweise Rollen mit balliger Lauffläche, ausgebildet sein können. Folglich ist in diesem Beispiel die erste wagenseitige Längsführungsmittelkomponente 83 durch die bezüglich der ersten führungseinrichtungsseitigen Längsschiene 183 gegenüberliegenden ersten wagenseitigen Rollen 83, 85 gebildet und ist die zweite wagenseitige Längsführungsmittelkomponente 83 durch die bezüglich der zweiten führungseinrichtungsseitigen Längsschiene 184 gegenüberliegenden zweiten wagenseitigen Rollen 84, 86 gebildet. In den Fig. 7 und 8 sind die ersten wagenseitigen Rollen 83, 85 beidseitig (z.B. oberhalb und unterhalb) der ersten führungseinrichtungsseitigen Längsschiene 183 angeordnet und sind die zweiten wagenseitigen Rollen 84, 86 beidseitig (z.B. oberhalb und unterhalb) der zweiten führungseinrichtungsseitigen Längsschiene 184 angeordnet. Somit können die ersten wagenseitigen Rollen 83, 85 erste wagenseitige Rollenpaare bilden und können die zweiten wagenseitigen Rollen 84, 86 zweite wagenseitige Rollenpaare bilden. Hierdurch kann der Verfahrwagen 10, zusätzlich zur Abstützung der Gewichtskraft des Verfahrwagens 10 und des Bauteils 3 sowie der Führung der Translationsbewegung des Verfahrwagens 10 mittels der wagenseitigen Rollen 83, 84, gegen die magnetischen Anziehungskräfte, welche einerseits zwischen den jeweiligen Permanentmagneteinrichtungen und den jeweiligen Elektromagneteinrichtungen wirken, mittels der wagenseitigen Rollen 85, 86 an den führungseinrichtungsseitigen Längsschienen 183 und 184 abgestützt und geführt werden, wodurch beispielsweise ein im Wesentlichen konstanter Spalt zwischen den jeweiligen Elektromagneteinrichtungen und den jeweiligen Permanentmagneteinrichtungen aufrechterhalten werden kann.

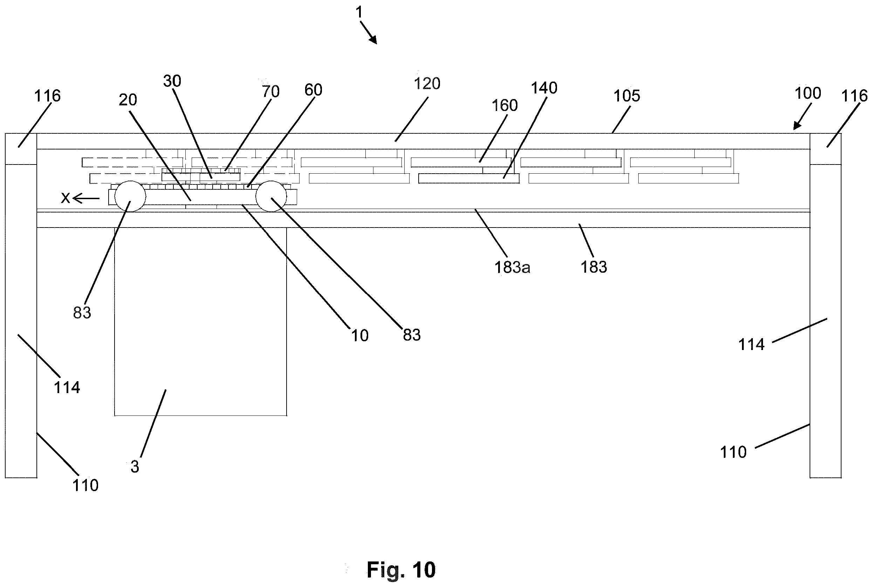

Bei dem erfindungsgemäßes Beispiel nach Fig. 9 und Fig. 10 ist im Vergleich mit dem Beispiel nach Fig. 5 und Fig. 6 zusätzlich vorgesehen, dass die ersten wagenseitigen Rollen 83 mit der ersten führungseinrichtungsseitigen Längsschiene 183 unter Ausbildung eines Quer-Festlagers in einem ein Querspiel unterbindenden Konkav-Konvex-Eingriff (z.B. durch Zusammenwirken eines konkaven Laufflächenprofils 83a der Rollen 83 mit einem konvexen äußeren Abschnitt 183a der Längsschiene 183) sind und die zweite wagenseitige Rollen 84 mit der zweiten führungseinrichtungsseitigen Längsschiene 184 unter Ausbildung eines Quer-Loslagers in einem ein Querspiel erlaubenden Eingriff (z.B. durch Zusammenwirken eines balligen Laufflächenprofils der Rollen 84 mit einer ebenen Fläche der Längsschiene 184) sind. Der Aufbau mit Quer-Festlager und Quer-Loslager, wie im Beispiel nach Fig. 9 und Fig. 10, kann in entsprechender Weise auch auf das Beispiel nach Fig. 7 und Fig. 8 angewendet werden, wobei dann die ersten wagenseitigen Rollen 83, 85 (bzw. die ersten wagenseitigen Rollenpaare) mit der ersten führungseinrichtungsseitigen Längsschiene 183 unter Ausbildung eines Quer-Festlagers in einem ein Querspiel unterbindenden Konkav-Konvex-Eingriff sind und die zweiten wagenseitigen Rollen 84, 86 (bzw. die zweiten wagenseitigen Rollenpaare) mit der zweiten führungseinrichtungsseitigen Längsschiene 184 unter Ausbildung eines Quer-Loslagers in einem ein Querspiel erlaubenden Eingriff sind. Hierdurch kann das Quer-Festlager zusätzlich eine noch sicherere und präzisere Führung des Verfahrwagens 10 bei der translatorischen Bewegung des Verfahrwagens 10 gewährleisten, wobei das Quer-Loslager zusätzlich Querbewegungen (z.B. temperaturbedingte Querverformungen) des Verfahrwagens 10 ausgleichen kann.

Obwohl in den Fig. 5, 6, 9 und 10 lediglich zwei erste wagenseitige Rollen 83 und in den Fig. 7 und Fig. 8 lediglich zwei erste wagenseitige Rollenpaare aus Rollen 83, 85 beispielhaft dargestellt sind, ist die vorliegende Erfindung nicht darauf beschränkt und kann eine beliebige Anzahl an wagenseitigen Rollen bzw. wagenseitigen Rollenpaaren an dem Verfahrwagen 10 vorgesehen sein. Jedes Modul 105 kann ferner die führungseinrichtungsseitigen Längsschienen 183 und 184 aufweisen, und die führungseinrichtungsseitigen Längsschienen 183 und 184 der einzelnen Module 105 können ferner unmittelbar aufeinanderfolgend (z.B. im Wesentlichen spaltfrei aufeinanderfolgend) angeordnet sein, wie in Fig. 3 gezeigt ist. Es kann aber auch sein, dass einzelne Module 105 keine führungseinrichtungsseitigen Längsschienen 183 und 184 aufweisen und/oder die führungseinrichtungsseitigen Längsschienen 183 und 184 unterbrochen sind (z.B. entlang der Längsrichtung X Räume bzw. Spalte zwischen führungseinrichtungsseitigen Längsschienen vorliegen). In solch einem Fall kann eine geeignete Anzahl von ersten wagenseitigen Rollen bzw. ersten wagenseitigen Rollenpaaren und zweiten wagenseitigen Rollen bzw. zweiten wagenseitigen Rollenpaaren an dem Verfahrwagen 10 über eine geeignete Distanz entlang der Längsrichtung X vorgesehen sein, damit der Verfahrwagen 10 die entsprechende Lücke zwischen den führungseinrichtungsseitigen Längsschienen 183 und 184 überbrücken kann.

Fig. 11 und Fig. 12 zeigen ein erfindungsgemäßes Beispiel, bei welchem das wagenseitige Längsführungsmittel 80 eine erste wagenseitige Längsführungsmittelkomponente in Form einer ersten wagenseitigen Längsschiene 93 und eine zweite wagenseitige Längsführungsmittelkomponente in Form einer zweiten wagenseitigen Längsschiene 94 aufweist und das führungseinrichtungsseitige Längsführungsmittel 180 eine erste führungseinrichtungsseitige Längsführungsmittelkomponente in Form von ersten führungseinrichtungsseitigen Rollen 193 und eine zweite führungseinrichtungsseitige Längsführungsmittelkomponente in Form von zweiten führungseinrichtungsseitigen Rollen 194 aufweist. Die erste wagenseitige Längsschiene 93 ist an einer Seite des Verfahrwagens 10 angebracht und erstreckt sich entlang der Längsrichtung X, und die zweite wagenseitige Längsschiene 94 ist an einer anderen Seite des Verfahrwagens 10 bezüglich der Längsrichtung X gegenüberliegend der (und z.B. im Abstand zur) ersten wagenseitigen Längsschiene 93 angebracht und erstreckt sich ebenfalls entlang der Längsrichtung X. Die führungseinrichtungsseitigen Rollen 193, 194 sind drehbar mit der Verfahrwagenführungseinrichtung 100 (z.B. mit einer ersten Querbügellängsschiene 122) verbunden, wobei beispielsweise die ersten führungseinrichtungsseitigen Rollen 193 an einer ersten Seite der Verfahrwagenführungseinrichtung 100 angeordnet sind und in der Längsrichtung X im Abstand zueinander angeordnet sind und wobei beispielsweise die zweiten führungseinrichtungsseitigen Rollen 194 an einer bezüglich der Längsrichtung X der ersten Seite gegenüberliegenden zweiten Seite der Verfahrwagenführungseinrichtung 100 angeordnet sind und in der Längsrichtung X im Abstand zueinander angeordnet sind. Ferner können die führungseinrichtungsseitigen Rollen 193, 194 in den Fig. 11 und 12 als Zylinderrollen bzw. Planrollen, beispielsweise Rollen mit balliger Lauffläche, ausgebildet sein. In den Fig. 11 und 12 liegt die erste wagenseitige Längsschiene 93 auf den ersten führungseinrichtungsseitigen Rollen 193 auf und liegt die zweite wagenseitigen Längsschiene 94 auf den zweiten führungseinrichtungsseitigen Rollen 194 auf. Hierdurch wird die Gewichtskraft des Verfahrwagens 10 und des Bauteils 3 durch die führungseinrichtungsseitigen Rollen 193, 194 und die wagenseitigen Längsschienen 93, 94 abgestützt und wird die Translationsbewegung des Verfahrwagens 10 entlang der Translationsachse T durch die führungseinrichtungsseitigen Rollen 193, 194 und die wagenseitigen Längsschienen 93, 94 geführt.

In dem erfindungsgemäßen Beispiel nach Fig. 13 und Fig. 14 weist das führungseinrichtungsseitige Längsführungsmittel 180 zusätzlich zu den führungseinrichtungsseitigen Rollen 193, 194 die führungseinrichtungsseitigen Rollen 195, 196 auf, die drehbar mit der Verfahrwagenführungseinrichtung 100 (z.B. mit einer zweiten Querbügellängsschiene 124) verbunden sind und die als Zylinderrollen bzw. Planrollen, beispielsweise Rollen mit balliger Lauffläche, ausgebildet sein können. Folglich ist in diesem Beispiel die erste führungseinrichtungsseitige Längsführungsmittelkomponente durch die bezüglich der ersten wagenseitigen Längsschiene 93 gegenüberliegenden ersten wagenseitigen Rollen 193, 195 gebildet und ist die zweite führungseinrichtungsseitige Längsführungsmittelkomponente durch die bezüglich der zweiten führungseinrichtungsseitigen Längsschiene 94 gegenüberliegenden zweiten führungseinrichtungsseitigen Rollen 194, 196 gebildet. In den Fig. 13 und Fig. 14 sind z.B. die ersten führungseinrichtungsseitigen Rollen 193, 195 beidseitig (z.B. oberhalb und unterhalb) der ersten wagenseitigen Längsschiene 93 angeordnet und sind die zweiten führungseinrichtungsseitigen Rollen 194, 196 beidseitig (z.B. oberhalb und unterhalb) der zweiten wagenseitigen Längsschiene 94 angeordnet. Insbesondere können die ersten führungseinrichtungsseitigen Rollen 193, 195 erste führungseinrichtungsseitige Rollenpaare bilden und können die zweiten führungseinrichtungsseitigen Rollen 194, 196 zweite führungseinrichtungsseitige Rollenpaare bilden. Hierdurch kann der Verfahrwagen 10, zusätzlich zur Abstützung der Gewichtskraft des Verfahrwagens 10 und des Bauteils 3 sowie der Führung der Translationsbewegung des Verfahrwagens 10 mittels der führungseinrichtungsseitigen Rollen 193 und 194, gegen die magnetischen Anziehungskräfte, welche einerseits zwischen den jeweiligen Permanentmagneteinrichtungen und den jeweiligen Elektromagneteinrichtungen wirken, die wagenseitigen Längsschienen 93 und 94 mittels der führungseinrichtungsseitigen Rollen 195 und 196 abgestützt und geführt werden, wodurch beispielsweise ein im Wesentlichen konstanter Spalt zwischen den jeweiligen Elektromagneteinrichtungen und den jeweiligen Permanentmagneteinrichtungen aufrechterhalten werden kann.

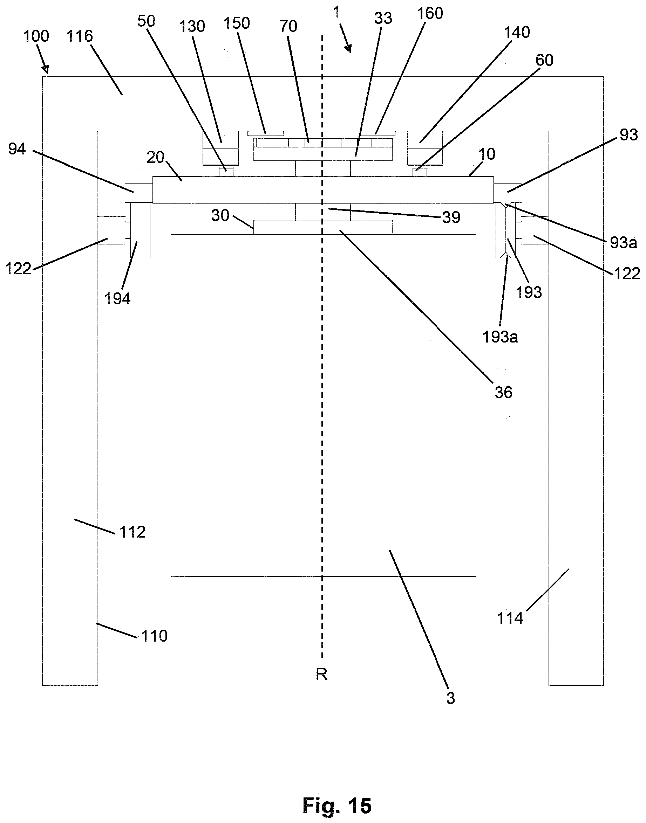

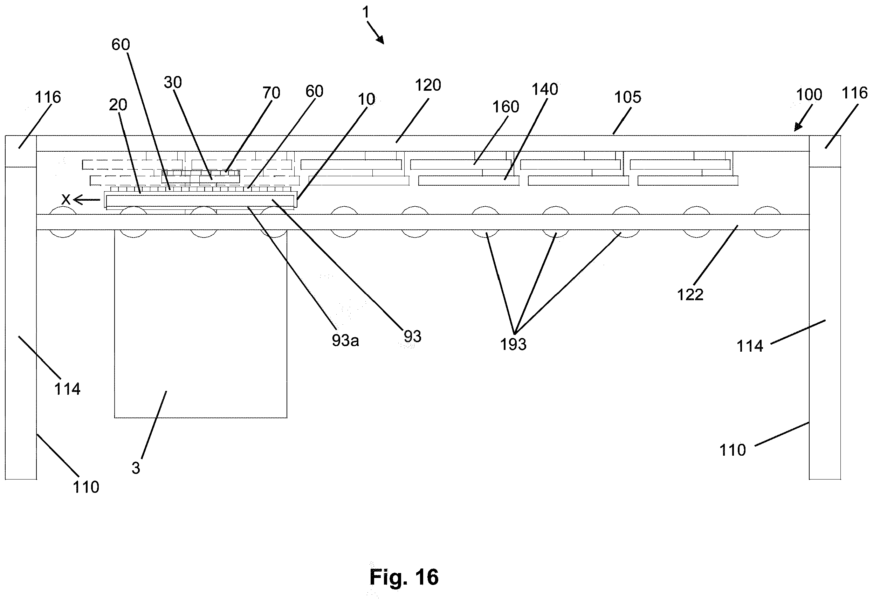

Bei einem erfindungsgemäßes Beispiel nach Fig. 15 und Fig. 16 ist im Vergleich zum Beispiel nach Fig. 11 und Fig. 12 zusätzlich vorgesehen, dass die ersten führungseinrichtungsseitigen Rollen 193 mit der ersten wagenseitigen Längsschiene 93 (z.B. durch Zusammenwirken eines konkaven Laufflächenprofils 193a der Rollen 193 mit einem konvexen äußeren Abschnitt 93a der Längsschiene 93) unter Ausbildung eines Quer-Festlagers in einem ein Querspiel unterbindenden Konkav-Konvex-Eingriff sind und die zweite führungseinrichtungsseitigen Rollen 194 mit der zweiten wagenseitigen Längsschiene 94 (z.B. durch Zusammenwirken eines balligen Laufflächenprofils der Rollen 194 mit einer ebenen Fläche der Längsschiene 94) unter Ausbildung eines Quer-Loslagers in einem ein Querspiel erlaubenden Eingriff sind. Der Aufbau mit Quer-Festlager und Quer-Loslager, wie im Beispiel nach Fig. 15 und Fig. 16, kann in entsprechender Weise auch auf das Beispiel nach Fig. 13 und Fig. 14 angewendet werden. Bei der entsprechenden Anwendung auf das Beispiel nach Fig. 13 und Fig. 14 sind dann die ersten führungseinrichtungsseitigen Rollen 193, 195 (bzw. die ersten führungseinrichtungsseitigen Rollenpaare) mit der ersten wagenseitigen Längsschiene 93 unter Ausbildung eines Quer-Festlagers in einem ein Querspiel unterbindenden Konkav-Konvex-Eingriff sind und die zweiten führungseinrichtungsseitigen Rollen 194, 196 (bzw. die zweiten führungseinrichtungsseitigen Rollenpaare) mit der zweiten wagenseitigen Längsschiene 94 unter Ausbildung eines Quer-Loslagers in einem ein Querspiel erlaubenden Eingriff. Hierdurch kann zusätzlich das Quer-Festlager eine noch sicherere und präzisere Führung des Verfahrwagens 10 bei der translatorischen Bewegung des Verfahrwagens 10 gewährleisten und kann das Quer-Loslager außerdem Querbewegungen (z.B. temperaturbedingte Querverformungen) des Verfahrwagens 10 ausgleichen.

Die Vorrichtung 1 kann ferner wenigstens eine Translation-Messeinrichtung zum berührungslosen Messen der translatorischen Bewegung des Verfahrwagens 10 und wenigstens eine Rotation-Messeinrichtung zum berührungslosen Messen der Rotation des Drehgestells 30 aufweisen.

In einem erfindungsgemäßen Beispiel kann die Vorrichtung 1 eine erste Translation-Messeinrichtung 220 zum berührungslosen Messen der translatorischen Bewegung des Verfahrwagens 10, eine zweite Translation-Messeinrichtung 230 zum berührungslosen Messen der translatorischen Bewegung des Verfahrwagens 10 und eine Rotation-Messeinrichtung 240 zum berührungslosen Messen der Rotation des Drehgestells 30 aufweisen, welche jeweilig mit der Steuereinrichtung 200 verbunden sind. Durch die Verwendung einer ersten und einer zweiten Translation-Messeinrichtung für die Messung der translatorischen Bewegung wird aufgrund der Redundanz die Ausfall- und Betriebssicherheit des Systems erhöht. Die vorliegende Erfindung ist jedoch hinsichtlich der Messeinrichtungen nicht beschränkt und es können auch weitere Translation-Messeinrichtung und auch weitere Rotation-Messeinrichtung vorgesehen sein.

Die erste Translation-Messeinrichtung 220 ist beispielsweise dazu eingerichtet, den Translationsweg und die Translationsrichtung des Verfahrwagens 10 in magnetischer Weise zu erfassen, und die Translation-Messeinrichtung 230 ist beispielsweise dazu eingerichtet, den Translationsweg und die Translationsrichtung des Verfahrwagens 10 in optischer Weise zu erfassen. Die erste Translation-Messeinrichtung 220 ist hierzu beispielsweise als eine magnetische (z.B. eine auf Magnetostriktion basierende) Translationsdetektionseinrichtung ausgebildet, die wenigstens einen seitlich an dem Verfahrwagen 10 (z.B. fest) angebrachten (permanent-)magnetischen Positionsgeber und wenigstens einen an der Verfahrwagenführungseinrichtung 100 (z.B. an den Pfosten 112 und/oder 114 der Querbügel 100) (z.B. fest) angebrachten magnetischen Sensor aufweist, der mit dem magnetischen Positionsgeber magnetisch zusammenwirkt, um den Translationsweg und die Translationsrichtung des Verfahrwagens 10 zu ermitteln. Ferner ist die zweite Translation-Messeinrichtung 230 beispielsweise als eine optische Translationsdetektionseinrichtung ausgebildet, die wenigstens einen seitlich an dem Verfahrwagen 10 (z.B. fest) angebrachten (z.B. länglichen) Maßstab (z.B. einen Glasmaßstab, einen Edelstahlmaßstab), der Striche und Lücken zwischen den Strichen aufweist, und wenigstens einen an der Verfahrwagenführungseinrichtung 100 (z.B. an den Pfosten 112 und/oder 114 der Querbügel 100) (z.B. fest) angebrachten optischen Abtastkopf, der dazu eingerichtet ist, den Maßstab (z.B. die Striche und Lücken des Maßstabs) abzutasten, um den Translationsweg und die Translationsrichtung des Verfahrwagens 10 zu ermitteln, aufweist. Die erste und die zweite Translation-Messeinrichtung 220 und 230 sind jedoch nicht auf diese beispielhaften Ausführungen beschränkt und können auch auf andere Weise realisiert sein, so lange sie zur Messung der Translation des Verfahrwagens 10 geeignet sind.

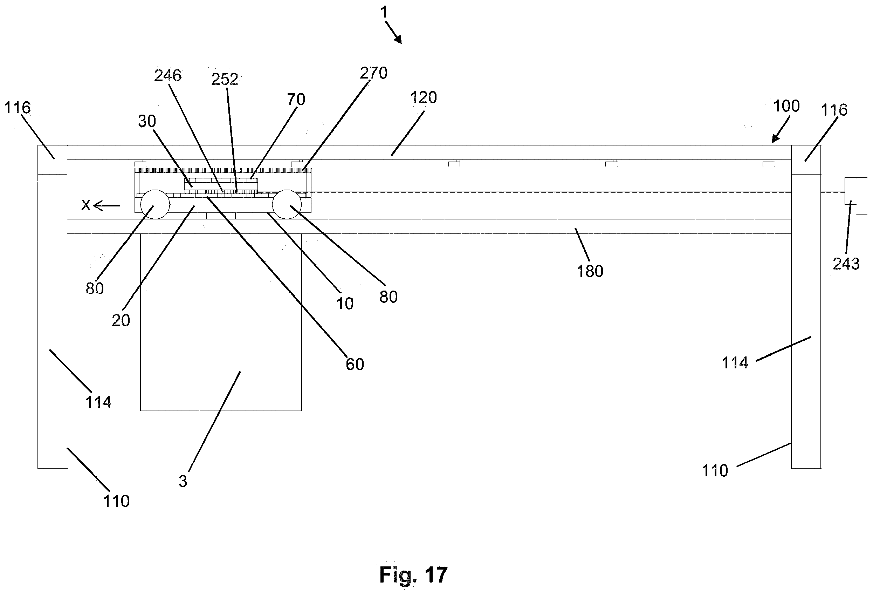

Die Rotation-Messeinrichtung 240 kann gemäß der vorliegenden Erfindung dazu eingerichtet sein, den Winkel (bzw. den Rotationsweg) und/oder die Rotationsgeschwindigkeit und/oder die Rotationsrichtung des Drehgestells 30 in optischer Weise mittels einer stationären Sensoreinrichtung zu erfassen, wie in Fig. 17 bis Fig. 20 gezeigt (wobei in diesen Figuren aus Gründen der Übersichtlichkeit die Translation- und die Rotation-Elektromagneteinrichtungen nicht gezeigt sind und auch teilweise die Translation- und die Rotation-Permanentmagneteinrichtungen nicht gezeigt sind).

Hierzu kann die Rotation-Messeinrichtung 240 zum Beispiel eine optische Inkrementalmesseinrichtung (bzw. Inkrementalgeber) oder eine optische Absolutwertmesseinrichtung aufweisen oder als solche ausgebildet sein. Unter Bezugnahme auf Fig. 17 bis Fig. 19 werden verschiedene Beispiele einer optisch arbeitenden Rotation-Messeinrichtung 240 beschrieben, wobei die vorliegende Erfindung nicht auf diese Beispiele beschränkt ist.

Die Rotation-Messeinrichtung 240 weist in dem erfindungsgemäßen Beispiel nach Fig. 17 eine (z.B. bezüglich des Verfahrwagens 10) stationäre Sensoreinrichtung 243 und eine Reflexionseinrichtung 246 auf. Die stationäre Sensoreinrichtung 243 ist dazu eingerichtet, wenigstens einen (z.B. wenigstens zwei oder genau zwei) Lichtstrahl(en) (z.B. wenigstens einen Laserstrahl, beispielsweise wenigstens oder genau zwei Laserstrahlen) in Richtung des Verfahrwagens 10 auszusenden (in Fig. 17 anhand der von Sensoreinrichtung 243 aus verlaufenden durchgezogenen Linie dargestellt), wenigstens einen von der Reflexionseinrichtung 246 impulsweise reflektierten Lichtstrahl (z.B. wenigstens oder genau zwei impulsweise reflektierten Lichtstrahlen) zu empfangen und anhand des wenigstens einen impulsweise reflektierten Lichtstrahls den Winkel (bzw. den Rotationsweg) und/oder die Rotationsgeschwindigkeit und/oder die Rotationsrichtung des Drehgestells 30 zu ermitteln. Zum Beispiel weist die stationäre Sensoreinrichtung 243 wenigstens eine Reflexlichtschranke, beispielsweise wenigstens oder genau zwei Reflexlichtschranken, auf, die dazu eingerichtet ist, einen jeweiligen Lichtstrahl auszusenden und den jeweiligen Lichtstrahl in Form eines reflektierten Lichtstrahls wieder zu empfangen. Die Reflexionseinrichtung 246 ist an dem Drehgestell 30 (z.B. an dem ersten Rad des Drehgestells 30) angebracht und dazu eingerichtet, wenigstens einen auftreffenden Lichtstrahl bei Rotation des Drehgestells 30 impulsweise (bzw. in Form von Impulsen) zu reflektieren (in Fig. 17 anhand der zur Sensoreinrichtung 243 verlaufenden gestrichelten Linie dargestellt). Hierzu weist die Reflexionseinrichtung 246 z.B. einen an dem Rahmen 20 des Verfahrwagens 10 (z.B. fest) angebrachten Spiegel (nicht gezeigt), auf welchen der wenigstens eine Lichtstrahl der stationären Sensoreinrichtung 243 gerichtet ist, und eine sich entlang der Umfangsrichtung U erstreckende und mit dem Drehgestell 30 drehfest verbundene Codiereinrichtung 252 (wie auch in Fig. 3 gezeigt) auf, welche zwischen dem Spiegel und der stationären Sensoreinrichtung 243 angeordnet ist und eine Mehrzahl von Schlitzen (z.B. in Form einer oder mehrerer (z.B. zueinander versetzter) Codierschlitzreihen, beispielsweise bevorzugt in Form von zwei zueinander versetzten Codierschlitzreihen) aufweist, wodurch die Reflexionseinrichtung 246 dazu eingerichtet ist, bei Rotation des Drehgestells 30 wenigstens einen auf die Reflexionseinrichtung 246 treffenden Lichtstrahl entsprechend der Rotationsrichtung und/oder dem Winkel (bzw. Rotationsweg) und/oder der Rotationsgeschwindigkeit impulsweise durch die Mehrzahl von Schlitzen hindurch zu reflektieren. Beispielsweise können zur Messung des rotationsrichtungsunabhängigen Winkels und/oder der rotationsrichtungsunabhängigen Rotationsgeschwindigkeit des Drehgestells 30 ein (z.B. ein einziger) von der stationären Sensoreinrichtung 243 ausgesendeter (und dann von der Reflexionseinrichtung 246 reflektierter) Lichtstrahl und eine (z.B. eine einzige) Codierschlitzreihe zum Erzeugen von Lichtimpulsen verwendet werden. Zur Messung des rotationsrichtungsbehafteten Winkels und/oder der rotationsrichtungsbehafteten Rotationsgeschwindigkeit (oder allein der Rotationsrichtung) können z.B. zwei von der stationären Sensoreinrichtung 243 ausgesendete (und dann von der Reflexionseinrichtung 246 reflektierte) Lichtstrahlen und zwei zueinander versetzte Codierschlitzreihe zum Erzeugen von Lichtimpulsen für einen jeweiligen Lichtstrahl verwendet werden.

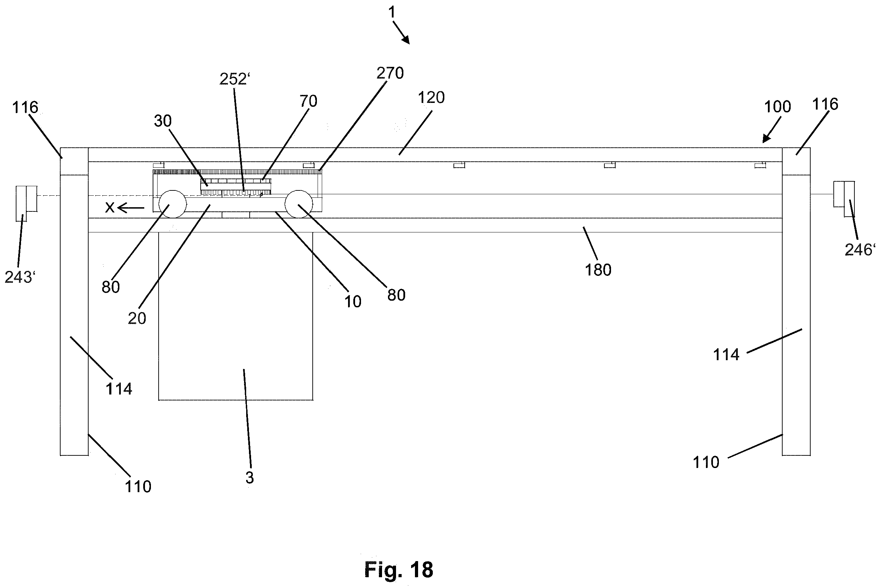

Die Rotation-Messeinrichtung 240 nach dem erfindungsgemäßen Beispiel nach Fig. 18 weist eine (z.B. bezüglich des Verfahrwagens 10) stationäre Sensoreinrichtung 243', eine der stationären Sensoreinrichtung 243' gegenüberliegende (z.B. bezüglich des Verfahrwagens 10) stationäre Lichtstrahlsendeeinrichtung 246' und eine mit dem Drehgestell 30 drehfest verbundene Codiereinrichtung 252' (ähnlich der in Fig. 3) auf. Die stationäre Lichtstrahlsendeeinrichtung 246' ist dazu eingerichtet, wenigstens einen Lichtstrahl (z.B. wenigstens zwei oder genau zwei Lichtstrahlen) in Richtung zur stationären Sensoreinrichtung 243' auszusenden (in Fig. 18 als von der Lichtstrahlsendeeinrichtung 246' ausgehende durchgezogene Linie dargestellt). Beispielsweise weist die Lichtstrahlsendeeinrichtung 246' wenigstens eine (z.B. wenigstens oder genau zwei) Lichtstrahlquelle auf, die dazu eingerichtet ist, einen jeweiligen Lichtstrahl auszusenden. Der Verfahrwagen 10 bewegt sich zwischen der stationären Sensoreinrichtung 243' und der stationären Lichtstrahlsendeeinrichtung 246', so dass die Codiereinrichtung 252' in einem Weg des wenigstens einen Lichtstrahls zwischen der stationären Lichtstrahlsendeeinrichtung 246' und der stationären Sensoreinrichtung 243' angeordnet ist. Die Codiereinrichtung 252' weist ferner eine Mehrzahl von Schlitzen (z.B. in Form einer oder mehrerer (z.B. zueinander versetzter) Codierschlitzreihen, beispielsweise bevorzugt in Form von zwei zueinander versetzten Codierschlitzreihen) auf. Die Codiereinrichtung 252' kann den von der stationären Lichtstrahlsendeeinrichtung 246' ausgesendeten wenigstens einen Lichtstrahl in Richtung zur stationären Sensoreinrichtung 243' durch die Mehrzahl von Schlitzen hindurch durchlassen, wobei bei einer Rotation des Drehgestells 30 Lichtimpulse entsprechend der Rotationsrichtung und/oder dem Winkel (bzw. Rotationsweg) und/oder der Rotationsgeschwindigkeit mittels der Mehrzahl von Schlitzen der Codiereinrichtung 252' erzeugt werden. Die stationäre Sensoreinrichtung 243'ist dazu eingerichtet, die erzeugten Lichtimpulse (in Fig. 18 als zu der Sensoreinrichtung 243' hin verlaufende gestrichelte Linie dargestellt) zu empfangen und anhand der empfangenen Lichtimpulse einen Winkel (bzw. einen Rotationsweg) und/oder der Rotationsgeschwindigkeit und/oder die Rotationsrichtung des Drehgestells 30 zu ermitteln. In dieser Hinsicht können beispielsweise zur Messung des rotationsrichtungsunabhängigen Winkels und/oder der rotationsrichtungsunabhängigen Rotationsgeschwindigkeit des Drehgestells 30 ein (z.B. ein einziger) von der Lichtstrahlsendeeinrichtung 246" ausgesendeter Lichtstrahl und eine (z.B. eine einzige) Codierschlitzreihe zum Erzeugen von Lichtimpulsen verwendet werden und können zur Messung des rotationsrichtungsbehafteten Winkels und/oder der rotationsrichtungsbehafteten Rotationsgeschwindigkeit (oder allein der Rotationsrichtung) beispielsweise zwei von der Lichtstrahlsendeeinrichtung 246' ausgesendete Lichtstrahlen und zwei zueinander versetzte Codierschlitzreihen zum Erzeugen von Lichtimpulsen für einen jeweiligen Lichtstrahl verwendet werden.

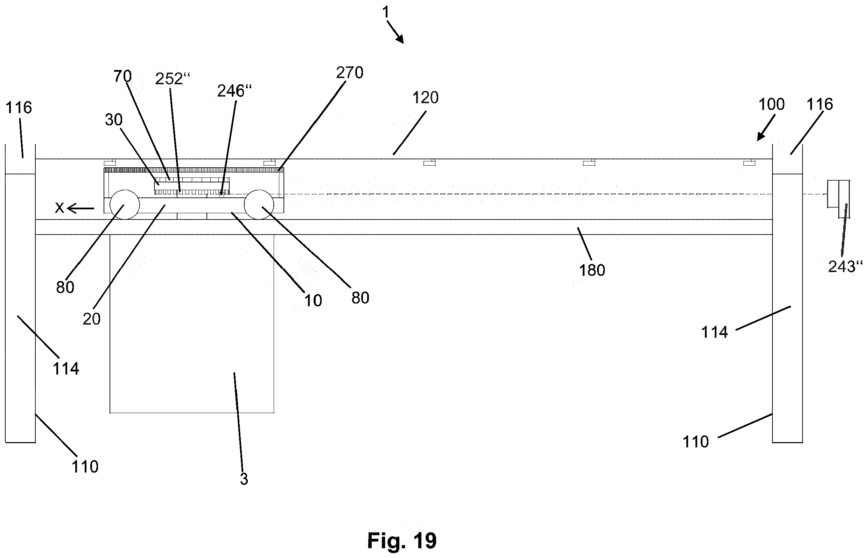

In dem erfindungsgemäßen Beispiel gemäß Fig. 19 weist die Rotation-Messeinrichtung 240 eine (z.B. bezüglich des Verfahrwagens) stationäre Sensoreinrichtung 243", eine an dem Verfahrwagen 10 angebrachte Verfahrwagen-Lichtstrahlsendeeinrichtung 246" und eine mit dem Drehgestell 30 des Verfahrwagens 10 drehfest verbundene Codiereinrichtung 252"auf. Die Verfahrwagen-Lichtstrahlsendeeinrichtung 246" ist dazu eingerichtet, wenigstens einen Lichtstrahl (z.B. wenigstens zwei oder genau zwei Lichtstrahlen) in Richtung zur Sensoreinrichtung 243" auszusenden. Beispielsweise weist die Verfahrwagen-Lichtstrahlsendeeinrichtung 246" wenigstens eine (z.B. wenigstens oder genau zwei) Lichtstrahlquelle auf, die dazu eingerichtet ist, einen jeweiligen Lichtstrahl auszusenden. Die mit dem Drehgestell 30 des Verfahrwagens 10 drehfest verbundene Codiereinrichtung 252" ist in einem Weg des wenigstens einen Lichtstrahls zwischen der Verfahrwagen-Lichtstrahlsendeeinrichtung 246" und der stationären Sensoreinrichtung 243" angeordnet und weist eine Mehrzahl von Schlitzen (z.B. in Form einer oder mehrerer (z.B. zueinander versetzter) Codierschlitzreihen, beispielsweise bevorzugt in Form von zwei zueinander versetzten Codierschlitzreihen) auf. Ferner kann die Codiereinrichtung 252"den von der Verfahrwagen-Lichtstrahlsendeeinrichtung 246" ausgesendeten wenigstens einen Lichtstrahl durch die Mehrzahl von Schlitzen in Richtung zur stationären Sensoreinrichtung 243' durchlassen, wobei bei einer Rotation des Drehgestells 30 Lichtimpulse (in Fig. 19 als zur Sensoreinrichtung 243" hin verlaufende gestrichelte Linie veranschaulicht) entsprechend der Rotationsrichtung und/oder dem Winkel (bzw. Rotationsweg) und/oder der Rotationsgeschwindigkeit des Drehgestells 30 mittels der Mehrzahl von Schlitzen der Codiereinrichtung 252" erzeugt werden. Die Sensoreinrichtung 243" ist außerdem dazu eingerichtet, die erzeugten Lichtimpulse zu empfangen und anhand der empfangenen Lichtimpulse einen Winkel (bzw. einen Rotationsweg) und/oder der Rotationsgeschwindigkeit und/oder die Rotationsrichtung des Drehgestells 30 zu ermitteln. Auch bei dem erfindungsgemäßen Beispiel gemäß Fig. 19 können zur Messung des rotationsrichtungsunabhängigen Winkels und/oder der rotationsrichtungsunabhängigen Rotationsgeschwindigkeit des Drehgestells 30 beispielsweise ein (z.B. ein einziger) von der Verfahrwagen-Lichtstrahlsendeeinrichtung 246" ausgesendeter Lichtstrahl und eine (z.B. eine einzige) Codierschlitzreihe zum Erzeugen von Lichtimpulsen verwendet werden und können zur Messung des rotationsrichtungsbehafteten Winkels und/oder der rotationsrichtungsbehafteten Rotationsgeschwindigkeit (oder allein der Rotationsrichtung) beispielsweise zwei von der Verfahrwagen-Lichtstrahlsendeeinrichtung 246" ausgesendete Lichtstrahlen und zwei zueinander versetzte Codierschlitzreihe zum Erzeugen von Lichtimpulsen für einen jeweiligen Lichtstrahl verwendet werden. Die Verfahrwagen-Lichtstrahlsendeeinrichtung 246" kann beispielsweise eine Batterie (z.B. einem austauschbaren Akkumulator) zur Versorgung mit elektrischer Energie aufweisen und/oder kann dazu eingerichtet sein, ihre zum Betrieb erforderliche elektrische Energie dem Magnetfeld der Translation-Elektromagneteinrichtungen 130, 140 und/oder der Rotation-Elektromagneteinrichtungen 150, 160 zu entziehen.

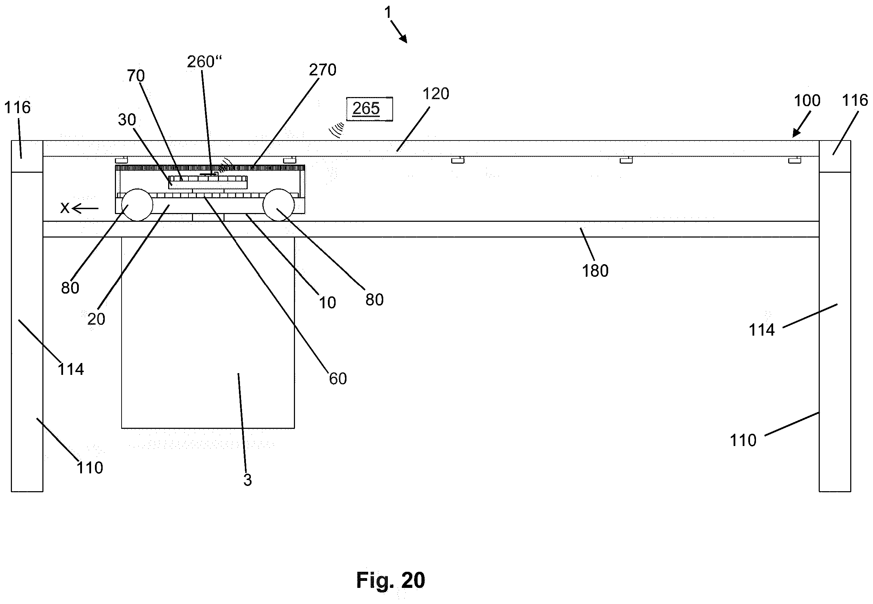

Zusätzlich oder alternativ zu den oben beschriebenen optischen Messsystemen kann die Rotation-Messeinrichtung 240 eine an dem Verfahrwagen 10 angebrachte Verfahrwagen-Rotationserfassungseinrichtung 260 und eine mit der Steuereinrichtung 200 verbundene Empfangseinheit 265 aufweisen, wie beispielhaft in Fig. 20 gezeigt. Die an dem Verfahrwagen 10 angebrachte Verfahrwagen-Rotationserfassungseinrichtung 265 kann hier dazu eingerichtet sein, den Winkel und/oder die Rotationsgeschwindigkeit und/oder die Rotationsrichtung des Drehgestells 30 auf beliebige, geeignete Weise (z.B. optisch, magnetisch, etc.) zu erfassen und dann den erfassten Winkel und/oder die erfasste Rotationsgeschwindigkeit und/oder die erfasste Rotationsrichtung des Drehgestells 30 drahtlos (z.B. in Form von Daten per Funkverbindung) an die Empfangseinheit 265 zu übermitteln. Die Empfangseinheit 265 übermittelt wiederum die empfangenen Informationen hinsichtlich des Winkels und/oder der Rotationsgeschwindigkeit und/oder der Rotationsrichtung des Drehgestells 30 an die Steuereinrichtung 200. Die Verfahrwagen-Rotationserfassungseinrichtung 260 kann beispielsweise eine Batterie (z.B. einen austauschbaren Akkumulator) zur Versorgung mit elektrischer Energie aufweisen, wobei die Batterie an dem Verfahrwagen 10 angebracht ist. Zusätzlich oder alternativ kann die Verfahrwagen-Rotationserfassungseinrichtung 260 die für ihren Betrieb erforderliche elektrische Energie dem Magnetfeld der Translation-Elektromagneteinrichtungen und/oder der Rotation-Elektromagneteinrichtungen entziehen. Beispielsweise weist die Verfahrwagen-Rotationserfassungseinrichtung 260 eine entsprechende Spulenanordnung auf, welche mit dem Magnetfeld der Translation-Elektromagneteinrichtungen und/oder der Rotation-Elektromagneteinrichtungen magnetisch zusammenwirkt und in welcher dadurch ein elektrischer Strom induziert wird, der zur Versorgung der Sensoreinrichtung 260 verwendet wird.

Darüber hinaus ist die Steuereinrichtung 200 der Vorrichtung 1 dazu eingerichtet, Signale, welche Informationen hinsichtlich eines Translationswegs (bzw. einer Translationsposition) und einer Translationsrichtung des Verfahrwagens 10 aufweisen, von der ersten Translation-Messeinrichtung 220 und der zweiten Translation-Messeinrichtung 230 zu erhalten und Signale, welche Informationen hinsichtlich eines Winkels und/oder einer Rotationsgeschwindigkeit und/oder einer Rotationsrichtung des Drehgestells des Verfahrwagens aufweisen, von der Rotation-Messeinrichtung 240 zu erhalten. Ferner ist die Steuereinrichtung 200 dazu eingerichtet, eine translatorische Bewegung des Verfahrwagens 10 in Abhängigkeit von den Signalen von der ersten und der zweiten Translation-Messeinrichtung 220, 230 zu steuern und eine Rotation des Drehgestells 30 in Abhängigkeit den Signalen von der Rotation-Messeinrichtung 240 zu steuern.

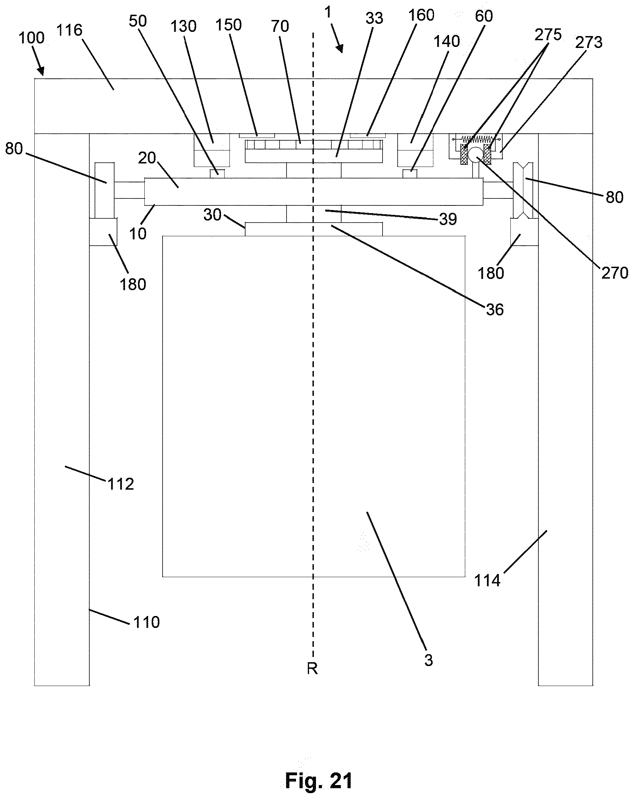

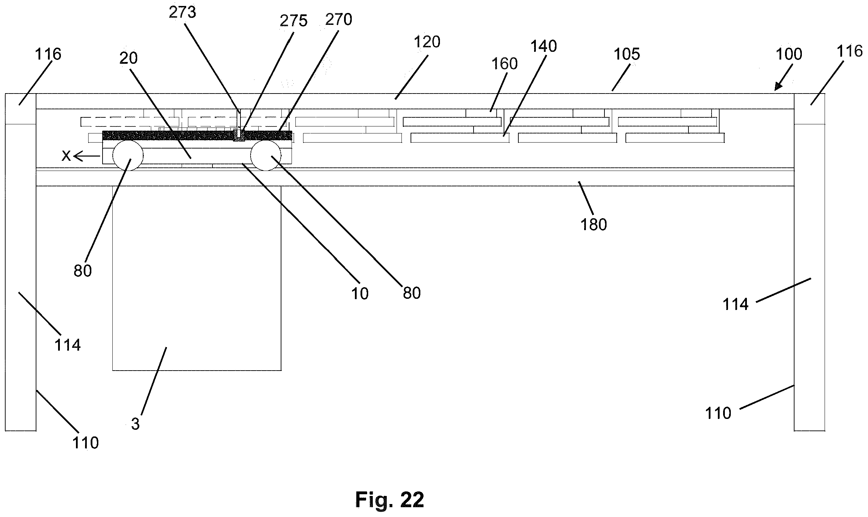

Außerdem ist gemäß Fig. 21 und 22 an dem Rahmen 20 des Verfahrwagens 10 beispielsweise eine Bremslängsschiene 270 angebracht, die sich entlang der Längsrichtung X erstreckt, und weist die Verfahrwagenführungseinrichtung 100 beispielsweise ferner wenigstens eine Bremsbackeneinrichtung 273 auf. Beispielsweise weist die Vorrichtung 1 mehrere Bremsbackeneinrichtungen 273. Die jeweilige Bremsbackeneinrichtung 273 kann an den Querbügellängsträgern 118, 120 angebracht sein (z.B. mittels eines zusätzlichen Querträgers zwischen den Querbügellängsträgern 118, 120) oder kann an einem jeweiligen Querträger 116 eines Querbügels 110 der Vorrichtung 1 vorgesehen und daran angebracht. Im Falle mehrerer Bremsbackeneinrichtungen 273 können diese jeweilig z.B. an vorbestimmten oder an allen Querträgern 116 der Querbügel 100 vorgesehen und daran angebracht. Die Bremsbackeneinrichtung 273 weist beidseitig der Bremslängsschiene 270 angeordnete Bremsbacken 275 auf, mittels deren die Bremslängsschiene 270 unter Erzeugung einer Bremskraft einklemmbar ist. Die Bremsbacken 275 der Bremsbackeneinrichtung 273 sind in Richtung zur Bremslängsschiene 270 beispielsweise mittels einer Feder (wie in Fig. 21 beispielhaft gezeigt) vorgespannt. Die Vorspannung der Bremsbacken 275 kann jedoch auch auf andere Weisen erzeugt werden. Die Bremsbackeneinrichtung(en) 273 ist (sind) beispielsweise dazu eingerichtet, eine Abbremsung des Verfahrwagens 10 in einer vorbestimmten Fehlersituation (z.B. bei Betätigung eines Not-Aus-Schalters und/oder bei Ausfall der Energieversorgung) durchzuführen. Beispielsweise ist (sind) die Bremsbackeneinrichtung(en) 273 dazu eingerichtet, bei einem Normalbetrieb der Vorrichtung 1 die Bremsbacken 275 von der Bremslängsschiene 270 gegen die Vorspannung im Abstand zu halten und es den Bremsbacken 275 von der Bremslängsschiene 270 bei einer vorbestimmten Fehlersituation zu erlauben, die Bremslängsschiene 270 aufgrund der Vorspannung zwischen sich unter Erzeugung einer Bremskraft einzuklemmen. Es sei angemerkt, dass die vorliegende Erfindung nicht auf nur eine Bremslängsschiene 270 beschränkt ist. Vielmehr können auch mehrere solcher Bremslängsschienen am Rahmen 20 des Verfahrwagens 10 angebracht sein und in zuvor beschriebener Weise mit zugehörigen Bremsbackeneinrichtungen an der Verfahrwagenführungseinrichtung 100 zusammenwirken.

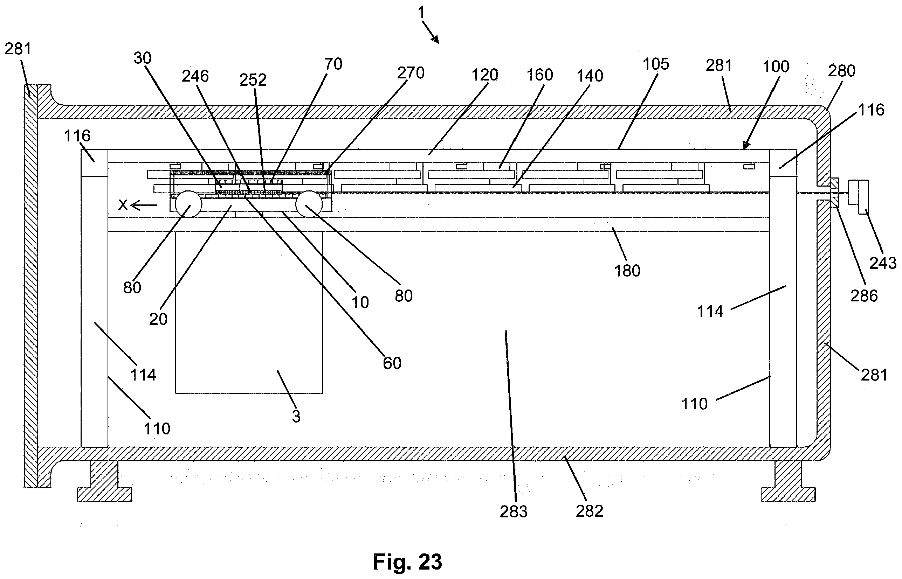

Die Vorrichtung 1 gemäß der vorliegenden Erfindung weist z.B. ferner eine oder mehrere Prozesskammern 280 auf (in Fig. 23 ist nur eine Prozesskammer 280 beispielhaft gezeigt), in denen das Bauteil 3 bearbeitet (z.B. beschichtet und/oder entschichtet) wird. Die Prozesskammern sind beispielsweise durch Prozesskammerwände 281 und einen Prozesskammerboden 282 gebildet und definieren einen jeweiligen Kammerinnenraum 283, in welchem ein Vakuum erzeugt wird. Hierzu weist die Vorrichtung 1 eine Vakuumvorrichtung auf, mittels deren der jeweilige Kammerinnenraum der einen oder der mehreren Prozesskammern 280 evakuierbar ist. Die Vakuumvorrichtung weist z.B. eine oder mehrere Vakuumpumpen beliebigen Typs auf. Eine oder mehrere Beschichtungseinrichtungen, mittels derer das Bauteil 3 beschichtet werden kann, sind innerhalb (z.B. im Kammerinnenraum) der einen oder mehreren Prozesskammern 280 angeordnet. Die eine oder die mehreren Beschichtungseinrichtungen sind z.B. Sputter-Beschichtungseinrichtungen, die z.B. jeweilig eine oder mehrere Magnetroneinrichtungen (z.B. Sputterplasmaeinrichtungen) aufweisen. Bei der vorliegenden Erfindung sind ferner eine oder mehrere Abtrageinrichtungen, mittels derer Material von dem Bauteil 3 abgetragen werden kann, innerhalb (z.B. im Kammerinnenraum) der einen oder mehreren Prozesskammern 280 angeordnet sind. Die eine oder die mehreren Abtrageinrichtungen sind z.B. Sputter-Abtrageinrichtungen, die z.B. jeweilig eine oder mehrere Sputterplasmaeinrichtungen aufweisen.

Darüber hinaus kann die Vorrichtung 1 gemäß der vorliegenden Erfindung noch weitere Kammern / Stationen, z.B. eine oder mehrere Schleusenkammern, eine oder mehrere Vakuumvorbereitungskammern (z.B. zum Vorbereiten (z.B. durch Ausheizen) des Verfahrwagens und des Bauteils für das Vakuum), eine oder mehrere Auswuchtstationen, eine oder mehrere Bauteilmontagestationen, sowie eine oder mehrere Ventileinrichtung, welche dazu eingerichtet sind, zwei Kammern selektiv miteinander verbinden, um ein Bewegen des Verfahrwagens zwischen den zwei Kammern zu ermöglichen, und selektiv die zwei Kammern voneinander luftdicht abzuschotten, aufweisen.

Beispielsweise erstreckt sich die Verfahrwagenführungseinrichtung 100 mit den daran angebrachten Translation-Elektromagneteinrichtungen 130, 140 und den daran angebrachten Rotation-Elektromagneteinrichtung 150, 160 (z.B. zumindest teilweise) innerhalb der einen oder der mehreren Prozesskammern 280, so dass der durch die Verfahrwagenführungseinrichtung 100 geführte Verfahrwagen 10 innerhalb der einen oder der mehreren Prozesskammern 280 entlang der Translationsachse T mittels der ersten und der zweiten Translation-Elektromagneteinrichtung 130, 140 translatorisch bewegbar ist und das Drehgestell 30 des Verfahrwagens 10 mittels der ersten und der zweiten Rotation-Elektromagneteinrichtung 150, 160 innerhalb der einen oder mehreren Prozesskammern 280 um die Rotationsachse R drehbar ist. In Fig. 23 ist beispielhaft gezeigt, dass sich ein Modul 105 der Verfahrwagenführungseinrichtung 100 innerhalb einer Prozesskammer 280 erstreckt. Ferner kann sich die Verfahrwagenführungseinrichtung 100 mit den daran angebrachten Translation-Elektromagneteinrichtungen 130, 140 und den daran angebrachten Rotation-Elektromagneteinrichtung 150, 160 auch in bzw. durch der einen oder den mehreren Prozesskammern 280 vor- oder nachgeschalteten weiteren Kammern / Stationen erstrecken, so dass auf dieselbe Weise wie in der einen oder den mehreren Prozesskammern 280 der Verfahrwagen 10 in diesen bzw. durch diese weiteren Kammern / Stationen translatorisch bewegt werden kann und das Drehgestell 30 in Rotation versetzt werden kann. Beispielsweise sind ein oder mehr Module 105 der Verfahrwagenführungseinrichtung 100 in der einen oder den mehreren Prozesskammern 280 vor- oder nachgeschalteten Kammern / Stationen angeordnet und untereinander verbunden, so dass der Verfahrwagen 10 in diesen bzw. durch diese weiteren Kammern / Stationen translatorisch bewegt werden kann und das Drehgestell 30 in Rotation versetzt werden kann. Somit ist es mit der vorliegenden Erfindung möglich, ein einheitliches Antriebssystem in allen Kammern der Vorrichtung 1 zu realisieren, wobei keine Schleppketten über mehrere Kammern verlaufen müssen oder eine Übergabe des Verfahrwagens von einem Energieversorgungssystem einer Kammer / Station an das Energieversorgungssystem der nächsten Kammer / Station erforderlich ist.

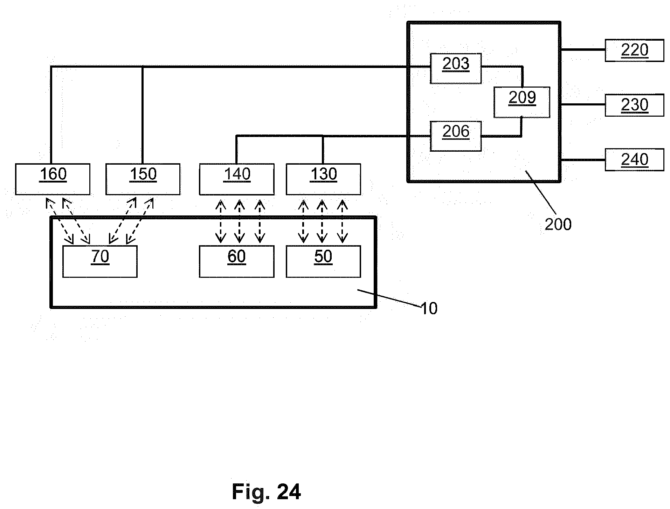

In Fig. 24 ist außerdem die Messung der Rotation des Drehgestells mittels des in Fig. 17 gezeigten Beispiels veranschaulicht, wobei die stationäre Sensoreinrichtung 243" außerhalb der Prozesskammer 280 angeordnet ist. Wie in Fig. 24 beispielhaft gezeigt, weist die Prozesskammer ein Prozesskammerfenster 286 auf, welches aus einem für den von der stationären Sensoreinrichtung 243" ausgesendeten und empfangenen Lichtstrahl durchlässig ist. Beispielsweise ist das Prozesskammerfenster 286 ein für den Lichtstrahl durchlässiges Glasfenster. Hierdurch kann mittels der außerhalb der Prozesskammer 280 angeordneten stationären Sensoreinrichtung 243" die Rotation des Drehgestells berührungslos von außerhalb der Prozesskammer 280 gemessen werden.

Bestandteile und Komponenten der Vorrichtung 1 können beispielsweise aus vakuumgeeigneten Materialen oder in vakuumgeeigneter Bauweise ausgebildet sein. Zum Beispiel können Bestandteile und Komponenten der Vorrichtung 1 aus vakuumgeeigneten Metallmaterial, beispielsweise aus vakuumgeeignetem Stahlmaterial oder Aluminiummaterial (z.B. Aluminium oder einer Legierung davon) gefertigt sein. Insbesondere können die Teile des Verfahrwagens (z.B. Rahmen, Schienen, etc.) und Teile der Verfahrwagenführungseinrichtung (z.B. Träger, Schienen, etc.) aus vakuumgeeignetem Stahlmaterial oder Aluminiummaterial (z.B. Aluminium oder einer Legierung davon) gefertigt sein.

Fig. 24 zeigt ein schematisches Blockdiagramm, welches das Zusammenwirken und die Funktionsweise der Vorrichtung 1 gemäß der vorliegenden Erfindung veranschaulicht.

Die Steuereinrichtung 200 erhält von der ersten Translation-Messeinrichtung 220 und der Translation-Messeinrichtung 230 Signale, welche Informationen hinsichtlich eines Translationswegs (bzw. einer Translationsposition) und einer Translationsrichtung des Verfahrwagens 10 aufweisen. Beispielsweise kann die Steuereinrichtung 200 den Translationsweg (bzw. die Translationsposition) und die Translationsrichtung des Verfahrwagens 10 direkt als Information von der ersten Translation-Messeinrichtung 220 und der zweiten Translation-Messeinrichtung 230 erhalten oder kann die Steuereinrichtung 200 den Translationsweg (bzw. die Translationsposition) und die Translationsrichtung des Verfahrwagens 10 anhand der von der ersten Translation-Messeinrichtung 220 und der zweiten Translation-Messeinrichtung 230 erhaltenen Informationen ermitteln (z.B. berechnen).

Die Steuereinrichtung 200 erhält ferner von der Rotation-Messeinrichtung 240 Signale, welche Informationen hinsichtlich eines Winkels (bzw. eines Rotationswegs) und/oder eine Rotationsgeschwindigkeit und/oder einer Rotationsrichtung des Drehgestells 30 aufweisen. Beispielsweise kann die Steuereinrichtung 200 den Winkel (bzw. den Rotationsweg) und/oder die Rotationsgeschwindigkeit und/oder die Rotationsrichtung des Drehgestells 30 direkt als Information von der Rotation-Messeinrichtung 240 erhalten oder kann die Steuereinrichtung 200 den Winkel (bzw. den Rotationsweg) und/oder die Rotationsgeschwindigkeit und/oder die Rotationsrichtung des Drehgestells 30 anhand der von der Rotation-Messeinrichtung 240 erhaltenen Informationen ermitteln (z.B. berechnen).

Die Steuereinrichtung 200 kann ferner mit einer übergeordneten Steuerung (nicht gezeigt) verbunden sein und von dieser Sollvorgaben hinsichtlich der translatorischen Bewegung (z.B. hinsichtlich des gewünschten Translationswegs (bzw. der gewünschten Translationsposition) und einer gewünschten Translationsrichtung) des Verfahrwagens 10 und hinsichtlich der Rotation (z.B. hinsichtlich des gewünschten Winkels (bzw. des gewünschten Rotationswegs), der gewünschten Rotationsgeschwindigkeit und/oder der gewünschten Drehrichtung) des Drehgestells 30 erhalten oder solche Sollvorgaben aus von der übergeordneten Steuerung übermittelten Daten (z.B. aus Informationen hinsichtlich der gewünschten Verteilung des Materials (z.B. eines Schichtdickenprofils) auf der Oberfläche des Bauteils, mit dem das Bauteil beschichtet werden soll, und/oder aus Informationen hinsichtlich der gewünschten Tiefe der Materialabtragung (z.B. eines Restdickenprofils) von dem Bauteil) berechnen.

Die Überlagerungssteuereinrichtung 209 der Steuereinrichtung 200 kann die Sollvorgaben und die von den Messeinrichtungen erhaltenen Informationen dazu verwenden, um entsprechende Steuersignale für die Translationssteuereinrichtung 203 und die Rotationsteuereinrichtung 206 zu erzeugen und diese Steuersignale an die Translationssteuereinrichtung 203 und die Rotationsteuereinrichtung 206 zu übermitteln.

Die Translationssteuereinrichtung 203 setzt die Steuersignale der Überlagerungssteuereinrichtung 209 in Ansteuersignale für die anzusteuernden Elektromagnete der ersten und zweiten Translation-Elektromagneteinrichtung 130 und 140, und die Rotationsteuereinrichtung 206 setzt die Steuersignale der Überlagerungssteuereinrichtung 209 in Ansteuersignale für die anzusteuernden Elektromagnete der ersten und zweiten Rotation-Elektromagneteinrichtung 150 und 160 um. Die anzusteuernden Elektromagnete (bzw. deren Elektromagnet-Spulen) der ersten und zweiten Translation-Elektromagneteinrichtung 130 und 140 sowie der ersten und zweiten Rotation-Elektromagneteinrichtung 150 und 160 werden dadurch von der Translationssteuereinrichtung 203 und der Rotationsteuereinrichtung 206 derart mit elektrischer Energie versorgt, dass eine gewünschte translatorische Bewegung des Verfahrwagens 10 und eine gewünschte Rotation des Drehgestells 30 erzeugt wird.

Die jeweilig angesteuerten Elektromagnete der ersten Translation-Elektromagneteinrichtung 130 wirken magnetisch (in Fig. 24 mit gestrichelten Linien dargestellt) mit den Permanentmagneten der ersten Translation-Permanentmagneteinrichtung 50 ähnlich einem Linearantrieb zusammen und die jeweilig angesteuerten Elektromagnete der zweiten Translation-Elektromagneteinrichtung 140 wirken magnetisch mit den Permanentmagneten der zweiten Translation-Permanentmagneteinrichtung 60 ähnlich einem Linearantrieb zusammen, wodurch eine Antriebskraft zur translatorischen Bewegung des Verfahrwagens 10 auf den Rahmen 20 aufgebracht wird. Ferner wirken die jeweilig angesteuerten Elektromagnete der ersten Rotation-Elektromagneteinrichtung 150 und der zweiten Rotation-Elektromagneteinrichtung 160 mit den Permanentmagneten der Rotation-Permanentmagneteinrichtung 60 ähnlich einem Linearantrieb zusammen, wodurch eine Antriebskraft zur Rotation des Drehgestells relativ zum Rahmen 20 auf das Drehgestell 30 aufgebracht wird.

Folglich wird der Verfahrwagen 10 entlang der Translationsachse T auf die gewünschte Weise (z.B. hinsichtlich der gewünschten Translationsrichtung, des gewünschten Translationswegs (bzw. der gewünschten Translationsposition), der gewünschten Translationsgeschwindigkeit und der gewünschten Translationsbeschleunigung, etc.) translatorisch bewegt und wird zusätzlich oder alternativ das Drehgestell 30 um die Rotationsachse R auf die gewünschte Weise (z.B. hinsichtlich der gewünschten Rotationsrichtung, des gewünschten Winkels (bzw. gewünschten Rotationswegs), der gewünschten Winkelgeschwindigkeit und der gewünschten Winkelbeschleunigung, etc.) rotiert. Hierdurch wird die gewünschte translatorische Bewegung und die gewünschte Rotation des Bauteils 3 in überlagerbarer Weise erzeugt.

Beispielsweise kann eine Rotation des Bauteils 3 mit konstanter Rotationsgeschwindigkeit des Bauteils 3 in eine Rotationsrichtung bei einer variierenden Translationsgeschwindigkeit des Bauteils 3 erzeugt werden. Ferner kann eine translatorische Bewegung des Bauteils 3 mit konstanter Translationsgeschwindigkeit des Bauteils bei einer variierenden Rotationsgeschwindigkeit des Bauteils 3 in eine Rotationsrichtung erzeugt werden.

Durch entsprechende Ansteuerung der Elektromagnete können somit sowohl eine rein translatorische Bewegung des Verfahrwagens 10, eine reine Rotation des Drehgestells 30 relativ zum Rahmen 20 des Verfahrwagens 10 als auch eine überlagerte Bewegung aus translatorischer Bewegung des Verfahrwagens 10 und Rotation des Drehgestells 30 relativ zum Rahmen 20 erzeugt werden.

## Patentansprüche

1. Vorrichtung (1) zur Bearbeitung eines Bauteils (3), aufweisend:
einen Verfahrwagen (10) mit
einem Rahmen (20), welcher entlang einer Längsrichtung (X) eine Translationsachse (T), entlang welcher der Verfahrwagen (10) translatorisch vorwärts und rückwärts bewegbar ist, definiert,
einem Drehgestell (30), das relativ zum Rahmen um eine Rotationsachse (R) drehbar mit dem Rahmen (20) verbunden ist und an welchem das Bauteil (3) anbringbar ist,
einer ersten Translation-Permanentmagneteinrichtung (50), die an dem Rahmen (20) angebracht ist und die entlang der Längsrichtung (X) angeordnete Permanentmagnete aufweist,
einer Rotation-Permanentmagneteinrichtung (70), die an dem Drehgestell (30) angebracht ist, eine sich um die Rotationsachse (R) herum erstreckende Umfangsrichtung (U) definiert und entlang dieser Umfangsrichtung (U) angeordnete Permanentmagnete aufweist, und
einem wagenseitigen Längsführungsmittel (80), welches an dem Rahmen (20) angebracht ist,
eine stationäre Verfahrwagenführungseinrichtung (100), die ein zu dem wagenseitigen Längsführungsmittel (80) komplementäres führungseinrichtungsseitiges Längsführungsmittel (180) aufweist, mittels dessen der Verfahrwagen (10) translatorisch geführt ist,
eine erste Translation-Elektromagneteinrichtung (130), die an der Verfahrwagenführungseinrichtung (100) angebracht ist und die entlang der Längsrichtung (X) angeordnete Elektromagnete (133), welche mit den Permanentmagneten der ersten Translation-Permanentmagneteinrichtung (50) magnetisch zusammenwirken, aufweist,
eine erste Rotation-Elektromagneteinrichtung (150), die an der Verfahrwagenführungseinrichtung (100) angebracht ist und die entlang der Längsrichtung (X) angeordnete Elektromagnete (153), welche mit den Permanentmagneten der Rotation-Permanentmagneteinrichtung (70) magnetisch zusammenwirken, aufweist, und
eine Steuereinrichtung (200), welche mit der ersten Translation-Elektromagneteinrichtung (130) und mit der ersten Rotation-Elektromagneteinrichtung (150) zur Ansteuerung der Elektromagnete (133, 153) davon verbunden ist, um die translatorische Bewegung des Verfahrwagens (10) entlang der Translationsachse (T) mittels des magnetischen Zusammenwirkens der Elektromagnete (133) der ersten Translation-Elektromagneteinrichtung (130) mit den Permanentmagneten der ersten Translation-Permanentmagneteinrichtung (50) zu steuern und um die Rotationsbewegung des Drehgestells(30) um die Rotationsachse (R) mittels des magnetischen Zusammenwirkens der Elektromagnete (153) der ersten Rotation-Elektromagneteinrichtung (150) mit den Permanentmagneten der Rotation-Permanentmagneteinrichtung (70) zu steuern.

2. Vorrichtung (1) gemäß Anspruch 1, wobei
der Verfahrwagen (10) ferner eine zweite Translation-Permanentmagneteinrichtung (60) aufweist, die an dem Rahmen (20) bezüglich der Längsrichtung (X) gegenüberliegend der ersten Translation-Permanentmagneteinrichtung (50) angebracht ist und die entlang der Längsrichtung (X) angeordnete Permanentmagnete aufweist, und wobei
die Vorrichtung (1) ferner eine zweite Translation-Elektromagneteinrichtung (140) aufweist, die bezüglich der Längsrichtung (X) gegenüberliegend der ersten Translation-Elektromagneteinrichtung (130) an der Verfahrwagenführungseinrichtung (100) angebracht ist und die entlang der Längsrichtung (X) angeordnete Elektromagnete (143), welche mit den Permanentmagneten der zweiten Translation-Permanentmagneteinrichtung (60) magnetisch zusammenwirken, aufweist,
wobei die Steuereinrichtung (200) ferner mit der zweiten Translation-Elektromagneteinrichtung (140) zur Ansteuerung der Elektromagnete (143) der zweiten Translation-Elektromagneteinrichtung (140) verbunden ist, um die translatorische Bewegung des Verfahrwagens (10) entlang der Translationsachse (T) zusätzlich mittels des magnetischen Zusammenwirkens der Elektromagnete (143) der zweiten Translation-Elektromagneteinrichtung (140) mit den Permanentmagneten der zweiten Translation-Permanentmagneteinrichtung (60) zu steuern.

3. Vorrichtung (1) gemäß Anspruch 1 oder 2, ferner aufweisend:
eine zweite Rotation-Elektromagneteinrichtung (160), die bezüglich der Längsrichtung (X) gegenüberliegend der ersten Rotation-Elektromagneteinrichtung (150) an der Verfahrwagenführungseinrichtung (100) angebracht ist und die entlang der Längsrichtung (X) angeordnete Elektromagnete (163), welche mit den Permanentmagneten der Rotation-Permanentmagneteinrichtung (70) magnetisch zusammenwirken, aufweist,
wobei die Steuereinrichtung (200) ferner mit der zweiten Rotation-Elektromagneteinrichtung (160) zur Ansteuerung der Elektromagnete (163) der zweiten Rotation-Elektromagneteinrichtung (160) verbunden ist, um die Rotationsbewegung des Drehgestells (30) um die Rotationsachse (R) zusätzlich mittels des magnetischen Zusammenwirkens der Elektromagnete (163) der zweiten Rotation-Elektromagneteinrichtung (160) mit den Permanentmagneten der Rotation-Permanentmagneteinrichtung (70) zu steuern.

4. Vorrichtung (1) gemäß irgendeinem der vorhergehenden Ansprüche, wobei das Drehgestell (30) aufweist:
ein erstes Rad (33), das die Permanentmagnete der Rotation-Permanentmagneteinrichtung (70) trägt,
ein zweites Rad (36), welches dem ersten Rad (33) gegenüberliegend angeordnet ist und an welchem das Bauteil (3) anbringbar ist, und
eine Welle (39), welche das erste Rad (33) und das zweite Rad (36) miteinander verbindet,
und wobei der Verfahrwagen (10) ein Drehlager (42) aufweist, welches die Welle (39) drehbar mit dem Rahmen (20) des Verfahrwagens (10) verbindet.

5. Vorrichtung (1) gemäß irgendeinem der vorhergehenden Ansprüche, wobei die Verfahrwagenführungseinrichtung (100) aus einer Gestellstruktur gebildet ist, welche entlang der Längsrichtung (X) im Abstand voneinander angeordnete Querbügel (110) aufweist, welche jeweils seitliche Pfosten (112, 114), die bezüglich der Längsrichtung (X) gegenüberliegend angeordnet sind, und einen Querträger (116) aufweisen, welcher sich quer zur Längsrichtung (X) erstreckt und die Pfosten (112, 114) miteinander verbindet,
wobei das führungseinrichtungsseitige Längsführungsmittel (180) von Längsschienen, welche unterhalb der Querträger (116) angeordnet sind, sich entlang der Längsrichtung (X) erstrecken und die Querbügel (110) miteinander verbinden, oder von Rollen, welche unterhalb der Querträger (116) entlang der Längsrichtung (X) im Abstand zueinander angeordnet sind, gebildet ist.

6. Vorrichtung (1) gemäß irgendeinem der vorhergehenden Ansprüche, wobei das wagenseitige Längsführungsmittel (80) eine erste wagenseitige Längsführungsmittelkomponente und eine zweite wagenseitige Längsführungsmittelkomponente aufweist und das führungseinrichtungsseitige Längsführungsmittel (180) eine erste führungseinrichtungsseitige Längsführungsmittelkomponente und eine zweite führungseinrichtungsseitige Längsführungsmittelkomponente aufweist, und
wobei die erste wagenseitige Längsführungsmittelkomponente und die erste führungseinrichtungsseitige Längsführungsmittelkomponente unter Ausbildung eines Quer-Festlagers miteinander im Eingriff stehen und wobei die zweite wagenseitige Längsführungsmittelkomponente und die zweite führungseinrichtungsseitige Längsführungsmittelkomponente unter Ausbildung eines Quer-Loslagers miteinander im Eingriff stehen.

7. Vorrichtung (1) gemäß Anspruch 6,
wobei die erste führungseinrichtungsseitige Längsführungsmittelkomponente durch eine erste führungseinrichtungsseitige Längsschiene (183), welche sich entlang der Längsrichtung (X) erstreckt, gebildet ist und die zweite führungseinrichtungsseitige Längsführungsmittelkomponente durch eine zweite führungseinrichtungsseitige Längsschiene (184), welche bezüglich der Längsrichtung (X) gegenüberliegend der ersten führungseinrichtungsseitigen Längsschiene (183) angeordnet ist und sich entlang der Längsrichtung (X) erstreckt, gebildet ist,
wobei die erste wagenseitige Längsführungsmittelkomponente durch wenigstens eine Rolle (83), die mit der ersten führungseinrichtungsseitigen Längsschiene (183) unter Ausbildung des Quer-Festlagers in einem ein Querspiel unterbindenden Konkav-Konvex-Eingriff ist, optional durch bezüglich der ersten führungseinrichtungsseitigen Längsschiene (183) gegenüberliegende erste wagenseitige Rollen (83, 85), die mit der ersten führungseinrichtungsseitigen Längsschiene (183) unter Ausbildung des Quer-Festlagers in einem ein Querspiel unterbindenden Konkav-Konvex-Eingriff sind, gebildet ist und die zweite wagenseitige Längsführungsmittelkomponente durch wenigstens eine Rolle (84), die mit der zweiten führungseinrichtungsseitigen Längsschiene (184) unter Ausbildung des Quer-Loslagers in einem ein Querspiel erlaubenden Eingriff ist, optional durch bezüglich der zweiten führungseinrichtungsseitigen Längsschiene (184) gegenüberliegende zweite wagenseitige Rollen (84, 86), die mit der zweiten führungseinrichtungsseitigen Längsschiene (184) unter Ausbildung des Quer-Loslagers in einem ein Querspiel erlaubenden Eingriff sind, gebildet ist.

8. Vorrichtung (1) gemäß Anspruch 6,
wobei die erste wagenseitige Längsführungsmittelkomponente durch eine erste wagenseitige Längsschiene (93), welche sich entlang der Längsrichtung (X) erstreckt, gebildet ist und die zweite wagenseitige Längsführungsmittelkomponente durch eine zweite wagenseitige Längsschiene (94), welche bezüglich der Längsrichtung (X) gegenüberliegend der ersten wagenseitigen Längsschiene (93) angeordnet ist und sich entlang der Längsrichtung (X) erstreckt, gebildet ist,
wobei die erste führungseinrichtungsseitige Längsführungsmittelkomponente durch wenigstens eine Rolle (193), die mit der ersten wagenseitigen Längsschiene (93) unter Ausbildung des Quer-Festlagers in einem ein Querspiel unterbindenden Konkav-Konvex-Eingriff ist, optional durch bezüglich der ersten wagenseitigen Längsschiene (93) gegenüberliegende erste führungseinrichtungsseitige Rollen (193, 195), die mit der ersten wagenseitigen Längsschiene (93) unter Ausbildung des Quer-Festlagers in einem ein Querspiel unterbindenden Konkav-Konvex-Eingriff sind, gebildet ist und die zweite führungseinrichtungsseitige Längsführungsmittelkomponente durch wenigstens eine Rolle (194), die mit der zweiten wagenseitigen Längsschiene (94) unter Ausbildung des Quer-Loslagers in einem ein Querspiel erlaubenden Eingriff ist, optional durch bezüglich der zweiten wagenseitigen Längsschiene (94) gegenüberliegende zweite führungseinrichtungsseitige Rollen (194, 196), die mit der zweiten wagenseitigen Längsschiene (94) unter Ausbildung des Quer-Loslagers in einem ein Querspiel erlaubenden Eingriff sind, gebildet ist.

9. Vorrichtung (1) gemäß irgendeinem der vorhergehenden Ansprüche, wobei die Elektromagnete (133, 143) der ersten und/oder der zweiten Translation-Elektromagneteinrichtung (130, 140)und/oder die Elektromagnete (153, 163) der ersten und/oder der zweiten Rotation-Elektromagneteinrichtung (150, 160) jeweilig ein Gehäuse (170) aufweisen, in welchem Elektromagnet-Spulen (175) der Elektromagnete (133, 143, 153, 163) untergebracht sind, wobei in dem Gehäuse (170) Kühlmittelkanäle ausgebildet sind, an welche eine Kühlmittelversorgung anschließbar ist, um dem Gehäuse (170) Kühlmittel zur Kühlung der Elektromagnet-Spulen (175) zuzuführen.

10. Vorrichtung (1) gemäß irgendeinem der vorhergehenden Ansprüche, ferner aufweisend:
eine oder mehrere Prozesskammern (280),
eine Vakuumvorrichtung, mittels deren die eine oder die mehreren Prozesskammern (280) evakuierbar sind,
wobei eine oder mehrere Beschichtungseinrichtungen, mittels derer das Bauteil (3) beschichtet werden kann, innerhalb der einen oder mehreren Prozesskammern (280) angeordnet sind und/oder eine oder mehrere Abtrageinrichtungen, mittels derer Material von dem Bauteil (3) abgetragen werden kann, innerhalb der einen oder mehreren Prozesskammern (280) angeordnet sind,
wobei die Verfahrwagenführungseinrichtung (100) mit der daran angebrachten jeweiligen Translation-Elektromagneteinrichtung (130, 140) und der daran angebrachten jeweiligen Rotation-Elektromagneteinrichtung (150, 160) sich zumindest teilweise innerhalb der einen oder mehreren Prozesskammern (280) erstreckt, so dass der durch die Verfahrwagenführungseinrichtung (100) geführte Verfahrwagen (10) innerhalb der einen oder mehreren Prozesskammern (280) entlang der Translationsachse (T) mittels der jeweiligen Translation-Elektromagneteinrichtung (130, 140) translatorisch bewegbar ist und das Drehgestell (30) des Verfahrwagens (10) mittels der jeweiligen Rotation-Elektromagneteinrichtung (150, 160) innerhalb der einen oder mehreren Prozesskammern (820) um die Rotationsachse (R) drehbar ist.

11. Vorrichtung (1) gemäß irgendeinem der vorhergehenden Ansprüche,
wobei an dem Rahmen (20) des Verfahrwagens (10) ferner mindestens eine Bremslängsschiene (270) angebracht ist, die sich entlang der Längsrichtung (X) erstreckt,
und wobei die Verfahrwagenführungseinrichtung (100) ferner aufweist wenigstens eine Bremsbackeneinrichtung (273), welche beidseitig der Bremslängsschiene (270) angeordnete Bremsbacken (275) aufweist, mittels deren die Bremslängsschiene (270) unter Erzeugung einer Bremskraft einklemmbar ist.

12. Verfahren zum Betreiben einer Vorrichtung (1) gemäß irgendeinem der Ansprüche 1 bis 11, wobei
die Steuereinrichtung (200) wenigstens eine der Translation-Elektromagneteinrichtungen (130, 140) und/oder wenigstens eine der Rotation-Elektromagneteinrichtungen (150, 160) derart ansteuert, dass sich der Verfahrwagen (10) in gleichförmiger Weise oder in ungleichförmiger Weise translatorisch bewegt und/oder das Drehgestell (30) in gleichförmiger Weise oder in ungleichförmiger Weise rotiert und dadurch eine überlagerte Bewegung aus translatorischer Bewegung und Rotation des Bauteils (3) erzeugt wird.

13. Verfahren gemäß Anspruch 12, wobei die Steuereinrichtung (200) die translatorische Bewegung des Verfahrwagens (10) und die Rotation des Drehgestells (30) derart in überlagernder Weise steuert, dass eine konstante Rotationsgeschwindigkeit des Bauteils (3) in eine Rotationsrichtung (R) bei einer variierenden Translationsgeschwindigkeit des Bauteils (3) erzeugt wird.

14. Verfahren gemäß Anspruch 12, wobei die Steuereinrichtung (200) die translatorische Bewegung des Verfahrwagens (10) und die Rotation des Drehgestells (30) derart in überlagernder Weise steuert, dass eine konstante Translationsgeschwindigkeit des Bauteils (3) bei einer variierenden Rotationsgeschwindigkeit des Bauteils (3) in eine Rotationsrichtung (R) erzeugt wird.

15. Verfahren gemäß irgendeinem der Ansprüche 12 bis 14, wobei die Vorrichtung (1) ferner wenigstens eine Translation-Messeinrichtung (220, 230) zum berührungslosen Messen der translatorischen Bewegung des Verfahrwagens (30) und wenigstens eine Rotation-Messeinrichtung (240) zum berührungslosen Messen der Rotation des Drehgestells (30) aufweist, welche jeweilig mit der Steuereinrichtung (200) verbunden sind,
wobei die Steuereinrichtung (200) Signale, welche Informationen hinsichtlich eines Translationswegs und einer Translationsrichtung des Verfahrwagens (10) aufweisen, von der wenigstens einen Translation-Messeinrichtung (220, 230) erhält und Signale, welche Informationen hinsichtlich eines Winkels und/oder einer Rotationsgeschwindigkeit und/oder einer Rotationsrichtung des Drehgestells des Verfahrwagens aufweisen, von der wenigstens einen Rotation-Messeinrichtung (240) erhält, und
wobei die Steuereinrichtung (200) eine translatorische Bewegung des Verfahrwagens (10) in Abhängigkeit von den Signalen von der wenigstens einen Translation-Messeinrichtung (220, 230) steuert und eine Rotation des Drehgestells (30) in Abhängigkeit von den Signalen von der wenigstens einen Rotation-Messeinrichtung (240) steuert,
wobei optional die wenigstens eine Rotation-Messeinrichtung (240) den Winkel und/oder die Rotationsgeschwindigkeit und/oder die Rotationsrichtung des Drehgestells (30) in optischer Weise mittels einer stationären Sensoreinrichtung (243; 243'; 243") erfasst, sich ein Messabstand der stationären Sensoreinrichtung (243; 243'; 243") zum Drehgestell (30) in Abhängigkeit von der translatorischen Bewegung des Verfahrwagens (10) verändert, und/oder die wenigstens eine Rotation-Messeinrichtung (240) eine an dem Verfahrwagen angebrachte Verfahrwagen-Rotationserfassungseinrichtung (260) und eine mit der Steuereinrichtung (200) verbundene Empfangseinheit (265) aufweist, die Verfahrwagen-Rotationserfassungseinrichtung (260) den Winkel und/oder die Rotationsgeschwindigkeit und/oder die Rotationsrichtung des Drehgestells (30) erfasst und den erfassten Winkel und/oder die erfasste Rotationsgeschwindigkeit und/oder die erfasste Rotationsrichtung des Drehgestells (30) drahtlos an die Empfangseinheit (265) übermittelt und die Empfangseinheit (265) die empfangenen Informationen über den Winkel und/oder die Rotationsgeschwindigkeit und/oder die Rotationsrichtung des Drehgestells (30) an die Steuereinheit (200) übermittelt,
wobei ferner optional die wenigstens eine Translation-Messeinrichtung (220, 230) des Verfahrwagens den Translationsweg und die Translationsrichtung des Verfahrwagens in magnetischer Weise und/oder in optischer Weise erfasst.

## Claims

1. Apparatus (1) for treating a component (3), comprising:
a moving carriage (10) comprising
a frame (20), which, along a longitudinal direction (X), defines a translational axis (T), along which the moving carriage (10) is translationally movable forwards and backwards,
a bogie (30), which is connected to the frame (20) so as to be rotatable relative to the frame about an axis of rotation (R), and to which the component (3) is attachable,
a first translatory permanent magnet device (50), which is attached to the frame (20) and which comprises permanent magnets disposed along the longitudinal direction (X),
a rotatory permanent magnet device (70), which is attached to the bogie (30), defines a circumferential direction (U) extending around the axis of rotation (R) and comprises permanent magnets disposed along said circumferential direction (U), and
a carriage-side longitudinal guide means (80), which is attached to the frame (20),
a stationary carriage guide device (100), which comprises a guide device-side longitudinal guide means (180), which is complementary to the carriage-side longitudinal guide means (80) and by means of which the carriage (10) is guided in a translational manner,
a first translatory electromagnet device (130), which is attached to the moving carriage guide device (100) and which comprises electromagnets (133), which are disposed along the longitudinal direction (X) and which interact magnetically with the permanent magnets of the first translatory permanent magnet device (50),
a first rotatory electromagnet device (150), which is attached to the moving carriage guide device (100) and which comprises electromagnets (153), which are disposed along the longitudinal direction (X) and which interact magnetically with the permanent magnets of the rotatory permanent magnet device (70), and
a controller (200), which is connected to the first translatory electromagnet device (130) and to the first rotatory electromagnet device (150) for controlling the electromagnets (133, 153) thereof in order to control the translational movement of the moving carriage (10) along the translational axis (T) by means of the magnetic interaction of the electromagnets (133) of the first translatory electromagnet device (130) with the permanent magnets of the first translatory permanent magnet device (50) and to control the rotational movement of the moving carriage (30) about the axis of rotation (R) by means of the magnetic interaction of the electromagnets (153) of the first rotatory electromagnet device (150) with the permanent magnets of the rotatory permanent magnet device (70).

2. Apparatus (1) according to claim 1, wherein
the moving carriage (10) further comprises a second translatory permanent magnet device (60), which is attached to the frame (20) on the opposite of the first translatory permanent magnet device (50) with respect to the longitudinal direction (X) and which comprises permanent magnets disposed along the longitudinal direction (X), and wherein
the apparatus (1) further comprises a second translatory electromagnet device (140), which is attached to the moving carriage guide device (100) on the opposite of the first moving electromagnet device (130) with respect to the longitudinal direction (X) and which comprises electromagnets (143), which are disposed along the longitudinal direction (X) and which interact magnetically with the permanent magnets of the second translatory permanent magnet device (60),
wherein the controller (200) is further connected to the second translatory electromagnet device (140) for controlling the electromagnets (143) of the second translatory electromagnet device (140) in order to additionally control the translational movement of the moving carriage (10) along the translation axis (T) by means of the magnetic interaction of the electromagnets (143) of the second translatory electromagnet device (140) with the permanent magnets of the second translatory permanent magnet device (60).

3. Apparatus (1) according to claim 1 or 2, further comprising:
a second rotatory electromagnet device (160), which is attached to the moving carriage guide device (100) on the opposite of the first rotatory electromagnet device (150) with respect to the longitudinal direction (X) and which comprises electromagnets (163), which are disposed along the longitudinal direction (X) and which magnetically interact with the permanent magnets of the rotatory permanent magnet device (70),
wherein the controller (200) is further connected to the second rotatory electromagnet device (160) for controlling the electromagnets (163) of the second rotatory electromagnet device (160) in order to additionally control the rotational movement of the bogie (30) about the axis of rotation (R) by means of the magnetic interaction of the electromagnets (163) of the second rotatory electromagnet device (160) with the permanent magnets of the rotatory permanent magnet device (70).

4. Apparatus (1) according to any one of the preceding claims, wherein the bogie (30) comprises:
a first wheel (33), which carries the permanent magnets of the rotary permanent magnet device (70),
a second wheel (36), which is disposed oppositely to the first wheel (33) and to which the component (3) is attachable, and
a shaft (39), which connects the first wheel (33) and the second wheel (36) to one another,
and wherein the moving carriage (10) comprises a rotational bearing (42), which rotatably connects the shaft (39) to the frame (20) of the moving carriage (10).

5. Apparatus (1) according to any one of the preceding claims, wherein the moving carriage guide device (100) is formed by a frame structure, comprising transverse brackets (110), which are disposed spaced apart from each other along the longitudinal direction (X) and which respectively comprise lateral posts (112, 114), which are disposed, with respect to the longitudinal direction (X), oppositely to each other, and a cross member (116) extending transversely to the longitudinal direction (X) and connecting the posts (112, 114) with each other,
wherein the guide device-side longitudinal guide means (180) is formed by longitudinal rails, which are disposed below the cross members (116), extend along the longitudinal direction (X) and connect the transverse brackets (110) with each other, or by rollers, which are disposed spaced apart from each other along the longitudinal direction (X) below the cross members (116).

6. Apparatus (1) according to any one of the preceding claims, wherein the carriage-side longitudinal guide means (80) comprises a first carriage-side longitudinal guide means component and a second carriage-side longitudinal guide means component and the guide device-side longitudinal guide means (180) comprises a first guide device-side longitudinal guide means component and a second guide device-side longitudinal guide means component, and
wherein the first carriage-side longitudinal guide means component and the first guide device-side longitudinal guide means component are in engagement with each other while forming a transverse fixed bearing, and the second carriage-side longitudinal guide means component and the second guide device-side longitudinal guide means component are in engagement with each other while forming a transverse floating bearing.

7. Apparatus (1) according to claim 6,
wherein the first guide device-side longitudinal guide means component is formed by a first guide device-side longitudinal rail (183) extending along the longitudinal direction (X) and the second guide device-side longitudinal guide means component is formed by a second guide device-side longitudinal rail (184), which is disposed, with respect to the longitudinal direction (X), oppositely to the first guide device-side longitudinal rail (183) and extends along the longitudinal direction (X),
wherein the first carriage-side longitudinal guide means component is formed by at least one roller (83), which is in a concave-convex engagement, which prevents transverse play, with the first guide device-side longitudinal rail (183) while forming the transverse fixed bearing, optionally by first carriage-side rollers (83, 85), which are disposed oppositely with respect to the first guide device-side longitudinal rail (183) and are in a concave-convex engagement, which prevents transverse play, with the first guide device-side longitudinal rail (183) while forming the transverse fixed bearing, and the second carriage-side longitudinal guide means component is formed by at least one roller (84), which is in an engagement, which allows transverse play, with the second guide device-side longitudinal rail (184) while forming the transverse floating bearing, optionally by second carriage-side rollers (84, 86), which are disposed oppositely with respect to the second guide device-side longitudinal rail (184) and which are in an engagement, which allows transverse play, with the second guide device-side longitudinal rail (184) while forming the transverse floating bearing.

8. Apparatus (1) according to claim 6,
wherein the first carriage-side longitudinal guide means component is formed by a first carriage-side longitudinal rail (93) extending along the longitudinal direction (X) and the second carriage-side longitudinal guide means component is formed by a second carriage-side longitudinal rail (94), which is disposed, with respect to the longitudinal direction (X), oppositely to the first carriage-side longitudinal rail (93) and extends along the longitudinal direction (X),
wherein the first guide device-side longitudinal guide means component is formed by at least one roller (193), which is in a concave-convex engagement, which prevents transverse play, with the first carriage-side longitudinal rail (93) while forming the transverse fixed bearing, optionally by first guide device-side rollers (193, 195), which are disposed oppositely with respect to the first carriage-side longitudinal rail (93) and are in a concave-convex engagement, which prevents transverse play, with the first carriage-side longitudinal rail (93) while forming the transverse fixed bearing, and the second guide device-side longitudinal guide means component is formed by at least one roller (194), which is in an engagement, which allows transverse play, with the second carriage-side longitudinal rail (94) while forming the transverse floating bearing, optionally by second guide device-side rollers (194, 496), which are disposed oppositely with respect to the second carriage-side longitudinal rail (94) and which are in an engagement, which allows transverse play, with the second carriage-side longitudinal rail (94) while forming the transverse floating bearing.

9. Apparatus (1) according to any one of the preceding claims, wherein the electromagnets (133, 143) of the first and/or the second translatory electromagnet device (130, 140) and/or the electromagnets (153, 163) of the first and/or the second rotatory electromagnet device (150, 160) each have a housing (170), in which electromagnet coils (175) of the electromagnets (133, 143, 153, 163) are accommodated, wherein coolant channels are formed in the housing (170), said coolant channels being connectable to a coolant supply in order to supply coolant to the housing (170) for cooling the electromagnet coils (175).

10. Apparatus (1) according to any one of the preceding claims, further comprising:
one or more process chambers (280),
a vacuum device, which allows to evacuate the one or more process chambers (280),
wherein one or more coating devices, while allow the component (3) to be coated, are disposed within the one or more process chambers (280) and/or one or more ablating devices, which allow to ablate material from the component (3), are disposed within the one or more process chambers (280),
wherein the moving carriage guide device (100) with the respective translatory electromagnetic device (130, 140) attached thereto and the respective rotatory electromagnetic device (150, 160) attached thereto extends at least partially within the one or more process chambers (280) so that the moving carriage (10) guided by the moving carriage guide device (100) is translationally movable within the one or more process chambers (280) along the translation axis (T) by means of the respective tranlsatory electromagnet device (130, 140), and the bogie (30) of the moving carriage (10) is rotatable about the axis of rotation (R) within the one or more process chambers (820) by means of the respective rotatory electromagnet device (150, 160).

11. Apparatus (1) according to any one of the preceding claims,
wherein at least one longitudinal brake rail (270) extending along the longitudinal direction (X) is also attached to the frame (20) of the moving carriage (10),
and wherein the moving carriage guide device (100) further comprises at least one brake shoe device (273) comprising brake shoes (275), which disposed on both sides of the longitudinal brake rail (270) and by means of which the longitudinal brake rail (270) is clampable while generating a braking force.

12. Method of operating an apparatus (1) according to any one of claims 1 to 11, wherein
the controller (200) controls at least one of the translatory electromagnetic devices (130, 140) and/or at least one of the rotatory electromagnetic devices (150, 160) in such a way that the moving carriage (10) moves translationally in a uniform manner or in a non-uniform manner and/or the bogie (30) rotates in a uniform manner or in a non-uniform manner and thereby a superimposed movement of translational movement and rotation of the component (3) is generated.

13. method according to claim 12, wherein the controller (200) controls the translational movement of the moving carriage (10) and the rotation of the bogie (30) in a superimposed manner in such a way that, with a varying translational speed of the component (3), a constant rotational speed of the component (3) in a rotational direction (R) is generated.

14. Method according to claim 12, wherein the controller (200) controls the translational movement of the moving carriage (10) and the rotation of the bogie (30) in a superimposed manner in such a way that, with a varying rotational speed of the component (3) in a rotational direction (R), a constant translational speed of the component (3) is generated.

15. Method according to any one of claims 12 to 14, wherein the apparatus (1) further comprises at least one translation measurement device (220, 230) for contactless measurement of the translational movement of the moving carriage (30) and at least one rotation measurement device (240) for contactless measurement of the rotation of the bogie (30), which are respectively connected to the controller (200),
wherein the controller (200) receives signals, which include information regarding a translation path and a translation direction of the moving carriage (10), from the at least one translation measurement device (220, 230) and signals, which include information regarding an angle and/or a rotational speed and/or a rotational direction of the bogie of the moving carriage, from the at least one rotation measurement device (240), and
wherein the controller (200) controls a translational movement of the moving carriage (10) in accordance with the signals from the at least one translation measurement device (220, 230) and controls a rotation of the bogie (30) in accordance with the signals from the at least one rotation measurement device (240),
wherein, optionally, the at least one rotation measurement device (240) detects the angle and/or the rotational speed and/or the rotational direction of the bogie (30) in an optical manner by means of a stationary sensor device (243; 243'; 243"), a measuring distance of the stationary sensor device (243; 243'; 243") to the bogie (30) varies depending on the translational movement of the moving carriage (10), and/or the at least one rotation measurement device (240) comprises a carriage rotation detection device (260) attached to the carriage and a receiving unit (265) connected to the controller (200), the carriage rotation detection device (260) detects the angle and/or the rotational speed and/or the rotational direction of the bogie (30) and transmits the detected angle and/or the detected rotational speed and/or the detected rotational direction of the bogie (30) wirelessly to the receiving unit (265) and the receiving unit (265) transmits the received information about the angle and/or the rotational speed and/or the rotational direction of the bogie (30) to the controller (200),
wherein, further optionally, the at least one translation measurement device (220, 230) of the carriage detects the translation path and the translational direction of the carriage in a magnetic manner and/or in an optical manner.

## Revendications

1. Dispositif (1) pour usiner une pièce (3), comprenant :
un chariot de déplacement (10) avec
un châssis (20), lequel définit le long d'une direction longitudinale (X) un axe de translation (T), le long duquel le chariot de déplacement (10) peut se déplacer en avant et en arrière en translation,
un bogie (30), qui est relié au châssis (20) de manière à pouvoir tourner autour d'un axe de rotation (R) par rapport au châssis et sur lequel la pièce (3) peut être fixée,
un premier dispositif de translation à aimants permanents (50), qui est fixé sur le châssis (20) et qui comprend des aimants permanents disposés le long de la direction longitudinale (X),
un dispositif de rotation à aimants permanents (70), qui est fixé sur le bogie (30), définit une direction périphérique (U) s'étendant autour de l'axe de rotation (R) et comprend des aimants permanents disposés le long de cette direction périphérique (U), et
un moyen de guidage longitudinal côté chariot (80), lequel est fixé sur le châssis (20),
un dispositif de guidage de chariot de déplacement (100) fixe, qui présente un moyen de guidage longitudinal côté dispositif de guidage (180) complémentaire du moyen de guidage longitudinal côté chariot (80), au moyen duquel le chariot de déplacement (10) est guidé en translation,
un premier dispositif de translation à électroaimants (130), qui est fixé sur le dispositif de guidage de chariot de déplacement (100) et qui comprend des électroaimants (133) disposés le long de la direction longitudinale (X), lesquels coopèrent de façon magnétique avec les aimants permanents du premier dispositif de translation à aimants permanents (50),
un premier dispositif de rotation à électroaimants (150), qui est fixé sur le dispositif de guidage de chariot de déplacement (100) et qui comprend des électroaimants (153) disposés le long de la direction longitudinale (X), lesquels coopèrent de façon magnétique avec les aimants permanents du dispositif de rotation à aimants permanents (70), et
un dispositif de commande (200), lequel est relié au premier dispositif de translation à électroaimants (130) et au premier dispositif de rotation à (150) pour commander les électroaimants (133, 153) de ceux-ci, afin de commander le mouvement en translation du chariot de déplacement (10) le long de l'axe de translation (T) au moyen de la coopération magnétique des électroaimants (133) du premier dispositif de translation à électroaimants (130) avec les aimants permanents du premier dispositif de translation à aimants permanents (50) et afin de commander le mouvement en rotation du bogie (30) autour de l'axe de rotation (R) au moyen de la coopération magnétique des électroaimants (153) du premier dispositif de rotation à électroaimants (150) avec les aimants permanents du dispositif de rotation à aimants permanents (70).

2. Dispositif (1) selon la revendication 1, dans lequel
le chariot de déplacement (10) comprend en outre un deuxième dispositif de translation à aimants permanents (60), qui est fixé sur le châssis (20) à l'opposé du premier dispositif de translation à aimants permanents (50) par rapport à la direction longitudinale (X) et qui comprend des aimants permanents disposés le long de la direction longitudinale (X), et dans lequel
le dispositif (1) comprend en outre un deuxième dispositif de translation à électroaimants (140), qui est fixé sur le dispositif de guidage de chariot de déplacement (100) à l'opposé du premier dispositif de translation à électroaimants (130) par rapport à la direction longitudinale (X) et qui comprend des électroaimants (143) disposés le long de la direction longitudinale (X), lesquels coopèrent de façon magnétique avec les aimants permanents du deuxième dispositif de translation à aimants permanents (60),
dans lequel le dispositif de commande (200) est relié en outre au deuxième dispositif de translation à électroaimants (140) pour commander les électroaimants (143) du deuxième dispositif de translation à électroaimants (140), afin de commander de manière supplémentaire le mouvement en translation du chariot de déplacement (10) le long de l'axe de translation (T) au moyen de la coopération magnétique des électroaimants (143) du deuxième dispositif de translation à électroaimants (140) avec les aimants permanents du deuxième dispositif de translation à aimants permanents (60).

3. Dispositif (1) selon la revendication 1 ou 2, présentant en outre :
un deuxième dispositif de rotation à électroaimants (160), qui est fixé sur le dispositif de guidage de chariot de déplacement (100) à l'opposé du premier dispositif de rotation à électroaimants (150) par rapport à la direction longitudinale (X) et qui présente des électroaimants (163) disposés le long de la direction longitudinale (X), lesquels coopèrent de façon magnétique avec les aimants permanents du dispositif de rotation à aimants permanents (70),
dans lequel le dispositif de commande (200) est relié en outre au deuxième dispositif de rotation à électroaimants (160) pour commander les électroaimants (163) du deuxième dispositif de rotation à électroaimants (160), afin de commander de manière supplémentaire le mouvement en rotation du bogie (30) autour de l'axe de rotation (R) au moyen de la coopération magnétique des électroaimants (163) du deuxième dispositif de rotation à électroaimants (160) avec les aimants permanents du dispositif de rotation à aimants permanents (70).

4. Dispositif (1) selon l'une quelconque des revendications précédentes, dans lequel le bogie (30) comprend :
une première roue (33), qui porte les aimants permanents du dispositif de rotation à aimants permanents (70),
une deuxième roue (36), laquelle est disposée à l'opposé de la première roue (33) et sur laquelle la pièce (3) peut être fixée, et
un arbre (39), reliant la première roue (33) et la deuxième roue (36) l'une à l'autre,
et dans lequel le chariot de déplacement (10) comprend un palier rotatif (42), lequel relie l'arbre (39) de manière rotative au châssis (20) du chariot de déplacement (10).

5. Dispositif (1) selon l'une quelconque des revendications précédentes, dans lequel le dispositif de guidage de chariot de déplacement (100) est formé d'une structure de bâti, laquelle comprend des étriers transversaux (110) disposés à distance les uns des autres le long de la direction longitudinale (X), lesquels présentent respectivement des montants latéraux (112, 114), qui sont disposés de manière opposée par rapport à la direction longitudinale (X), et une traverse (116), laquelle s'étend transversalement par rapport à la direction longitudinale (X) et relie les montants (112, 114) les uns aux autres,
dans lequel le moyen de guidage longitudinal côté dispositif de guidage (180) est formé de rails longitudinaux, lesquels sont disposés au-dessous de la traverse (116), s'étendant le long de la direction longitudinale (X) et reliant les étriers transversaux (110) les uns aux autres, ou de rouleaux, lesquels sont disposés à distance les uns des autres au-dessous de la traverse (116) le long de la direction longitudinale (X).

6. Dispositif (1) selon l'une quelconque des revendications précédentes, dans lequel le moyen de guidage longitudinal côté chariot (80) comprend un premier composant de moyen de guidage longitudinal côté chariot et un deuxième composant de moyen de guidage longitudinal côté chariot et le moyen de guidage longitudinal côté dispositif de guidage (180) comprend un premier composant de moyen de guidage longitudinal côté dispositif de guidage et un deuxième composant de moyen de guidage longitudinal côté dispositif de guidage, et
dans lequel le premier composant de moyen de guidage longitudinal côté chariot et le premier composant de moyen de guidage longitudinal côté dispositif de guidage sont en prise l'un avec l'autre avec formation d'un palier fixe transversal et dans lequel le deuxième composant de moyen de guidage longitudinal côté chariot et le deuxième composant de moyen de guidage longitudinal côté dispositif de guidage sont en prise l'un avec l'autre avec formation d'un palier libre transversal.

7. Dispositif (1) selon la revendication 6,
dans lequel le premier composant de moyen de guidage longitudinal côté dispositif de guidage est formé par un premier rail longitudinal côté dispositif de guidage (183), lequel s'étend le long de la direction longitudinale (X), et le deuxième composant de moyen de guidage longitudinal côté dispositif de guidage est formé par un deuxième rail longitudinal côté dispositif de guidage (184), lequel est disposé à l'opposé du premier rail longitudinal côté dispositif de guidage (183) par rapport à la direction longitudinale (X) et s'étend le long de la direction longitudinale (X),
dans lequel le premier composant de moyen de guidage longitudinal côté chariot est formé par au moins un rouleau (83), qui est en prise concavo-convexe empêchant un jeu transversal avec le premier rail longitudinal côté dispositif de guidage (183) avec formation du palier fixe transversal, éventuellement par des premiers rouleaux côté chariot (83, 85) opposés par rapport au premier rail longitudinal côté dispositif de guidage (183), qui sont en prise concavo-convexe empêchant un jeu transversal avec le premier rail longitudinal côté dispositif de guidage (183) avec formation du palier fixe transversal et le deuxième composant de moyen de guidage longitudinal côté chariot est formé par au moins un rouleau (84), qui est en prise permettant un jeu transversal avec le deuxième rail longitudinal côté dispositif de guidage (184) avec formation du palier libre transversal, éventuellement par des deuxièmes rouleaux côté chariot (84, 86) opposés par rapport au deuxième rail longitudinal côté dispositif de guidage (184), qui sont en prise permettant un jeu transversal avec le deuxième rail longitudinal côté dispositif de guidage (184) avec formation du palier libre transversal.

8. Dispositif (1) selon la revendication 6,
dans lequel le premier composant de moyen de guidage longitudinal côté chariot est formé par un premier rail longitudinal côté chariot (93), lequel s'étend le long de la direction longitudinale (X), et le deuxième composant de moyen de guidage longitudinal côté chariot est formé par un deuxième rail longitudinal côté chariot (94), lequel est disposé à l'opposé du premier rail longitudinal côté chariot (93) par rapport à la direction longitudinale (X) et s'étend le long de la direction longitudinale (X),
dans lequel le premier composant de moyen de guidage longitudinal côté dispositif de guidage est formé par au moins un rouleau (193), qui est en prise concavo-convexe empêchant un jeu transversal avec le premier rail longitudinal côté chariot (93) avec formation du palier fixe transversal, éventuellement par des premiers rouleaux côté dispositif de guidage (193, 195) opposés par rapport au premier rail longitudinal côté chariot (93), qui sont en prise concavo-convexe empêchant un jeu transversal avec le premier rail longitudinal côté chariot (93) avec formation du palier fixe transversal et le deuxième composant de moyen de guidage longitudinal côté dispositif de guidage est formé par au moins un rouleau (194), qui est en prise permettant un jeu transversal avec le deuxième rail longitudinal côté chariot (94) avec formation du palier libre transversal, éventuellement par des deuxièmes rouleaux côté dispositif de guidage (194, 196) opposés par rapport au deuxième rail longitudinal côté chariot (94), qui sont en prise permettant un jeu transversal avec le deuxième rail longitudinal côté chariot (94) avec formation du palier libre transversal.

9. Dispositif (1) selon l'une quelconque des revendications précédentes, dans lequel les électroaimants (133, 143) du premier et/ou du deuxième dispositif de translation à électroaimants (130, 140) et/ou les électroaimants (153, 163) du premier et/ou du deuxième dispositif de rotation à électroaimants (150, 160) comprennent chacun un boîtier (170), dans lequel sont logées des bobines d'électroaimants (175) des électroaimants (133, 143, 153, 163), des canaux de réfrigérant étant réalisés dans le boîtier (170), auxquels peut être raccordée une alimentation en réfrigérant, afin d'amener un réfrigérant au boîtier (170) pour refroidir les bobines d'électroaimants (175).

10. Dispositif (1) selon l'une quelconque des revendications précédentes, présentant en outre :
une ou plusieurs chambres de traitement (280),
un dispositif de mise sous vide, au moyen duquel un vide peut être créé dans la ou les chambres de traitement (280),
dans lequel un ou plusieurs dispositifs de revêtement, au moyen desquels la pièce (3) peut être revêtue, sont disposés à l'intérieur de la ou des chambres de traitement (280) et/ou un ou plusieurs dispositifs d'enlèvement, au moyen desquels de la matière peut être enlevée de la pièce (3), sont disposés à l'intérieur de la ou des chambres de traitement (280),
dans lequel le dispositif de guidage de chariot de déplacement (100) avec le dispositif de translation à électroaimants (130, 140) respectif fixé sur celui-ci et le dispositif de rotation à électroaimants (150, 160) respectif fixé sur celui-ci, s'étend au moins en partie à l'intérieur de la ou des chambres de traitement (280), de sorte que le chariot de déplacement (10) guidé par le dispositif de guidage de chariot de déplacement (100) peut être déplacé en translation à l'intérieur de la ou des chambres de traitement (280) le long de l'axe de translation (T) au moyen du dispositif de translation à électroaimants (130, 140) respectif et le bogie (30) du chariot de déplacement (10) peut être amené en rotation autour de l'axe de rotation (R) à l'intérieur de la ou des chambres de traitement (280) au moyen du dispositif de rotation à électroaimants (150, 160) respectif.

11. Dispositif (1) selon l'une quelconque des revendications précédentes,
dans lequel en outre au moins un rail longitudinal de frein (270), qui s'étend le long de la direction longitudinale (X), est fixé sur le châssis (20) du chariot de déplacement (10),
et dans lequel le dispositif de guidage de chariot de déplacement (100) présente en outre au moins un dispositif de mâchoires de frein (273), lequel comprend des mâchoires de frein (275) disposées des deux côtés du rail longitudinal de frein (270), au moyen desquelles le rail longitudinal de frein (270) peut être coincé avec production d'une force de freinage.

12. Procédé pour faire fonctionner un dispositif (1) selon l'une quelconque des revendications 1 à 11, dans lequel
le dispositif de commande (200) commande au moins un des dispositifs de translation à électroaimants (130, 140) et/ou au moins un des dispositifs de rotation à électroaimants (150, 160), de telle sorte que le chariot de déplacement (10) se déplace en translation de manière régulière ou de manière irrégulière et/ou le bogie (30) tourne de manière régulière ou de manière irrégulière et de cette façon un mouvement superposé composé du mouvement en translation et de la rotation de la pièce (3) est produit.

13. Procédé selon la revendication 12, dans lequel le dispositif de commande (200) commande le mouvement en translation du chariot de déplacement (10) et la rotation du bogie (30) de manière superposée, de telle sorte qu'une vitesse de rotation constante de la pièce (3) dans une direction de rotation (R) pour une vitesse de translation variable de la pièce (3) est produite.

14. Procédé selon la revendication 12, dans lequel le dispositif de commande (200) commande le mouvement en translation du chariot de déplacement (10) et la rotation du bogie (30) de manière superposée, de telle sorte qu'une vitesse de translation constante de la pièce (3) pour une vitesse de rotation variable de la pièce (3) dans une direction de rotation (R) est produite.

15. Procédé selon l'une quelconque des revendications 12 à 14, dans lequel le dispositif (1) comprend en outre au moins un dispositif de mesure de translation (220, 230) pour la mesure sans contact du mouvement en translation du chariot de déplacement (10) et au moins un dispositif de mesure de rotation (240) pour la mesure sans contact de la rotation du bogie (30), lesquels sont reliés respectivement au dispositif de commande (200),
dans lequel le dispositif de commande (200) reçoit des signaux, lesquels comprenent des informations concernant un chemin de translation et une direction de translation du chariot de déplacement (10), de l'au moins un dispositif de mesure de translation (220, 230) et des signaux, lesquels comprennent des informations concernant un angle et/ou une vitesse de rotation et/ou une direction de rotation du bogie du chariot de déplacement, de l'au moins un dispositif de mesure de rotation (240), et
dans lequel le dispositif de commande (200) commande un mouvement en translation du chariot de déplacement (10) en fonction des signaux de l'au moins un dispositif de mesure de translation (220, 230) et commande une rotation du bogie (30) en fonction des signaux de l'au moins un dispositif de mesure de rotation (240),
dans lequel éventuellement l'au moins un dispositif de mesure de rotation (240) détecte l'angle et/ou la vitesse de rotation et/ou la direction de rotation du bogie (30) de manière optique au moyen d'un dispositif de capteur fixe (243 ; 243' ; 243"), une distance de mesure du dispositif de capteur fixe (243 ; 243' ; 243") par rapport au bogie (30) changeant en fonction du mouvement en translation du chariot de déplacement (10), et/ou l'au moins un dispositif de mesure de rotation (240) comprend un dispositif de détection de rotation de chariot de déplacement (260) fixé sur le chariot de déplacement et une unité de réception (265) reliée au dispositif de commande (200), le dispositif de détection de rotation de chariot de déplacement (260) détectant l'angle et/ou la vitesse de rotation et/ou la direction de rotation du bogie (30) et transmettant sans fil l'angle détecté et/ou la vitesse de rotation détectée et/ou la direction de rotation détectée du bogie (30) à l'unité de réception (265) et l'unité de réception (265) transmettant les informations reçues sur l'angle et/ou la vitesse de rotation et/ou la direction de rotation du bogie (30) à l'unité de commande (200),
dans lequel en outre éventuellement l'au moins un dispositif de mesure de translation (220, 230) du chariot de déplacement détecte le chemin de translation et la direction de translation du chariot de déplacement de façon magnétique et/ou de façon optique.
